# EUROPEAN PATENT SPECIFICATION

(11) **EP 4 286 392 B1**
(45) Date of publication and mention of the grant of the patent: **10.09.2025**
(21) Application number: 23175981.2
(22) Date of filing: 30.05.2023
(51) Int. Cl.: C07F 15/00, C09K 11/00, H10K 85/30, H10K 85/40

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 03.06.2022 KR 20220068503
(43) Date of publication of application: 06.12.2023
(73) Proprietor: Samsung Electronics Co., Ltd., Suwon-si, Gyeonggi-do 16677 (KR)
(72) Inventor: KANG, Byungjoon, 16678 Suwon-si (KR); LEE, Kum Hee, 16678 Suwon-si (KR); LEE, Banglin, 16678 Suwon-si (KR); LEE, Yong Joo, 16678 Suwon-si (KR); CHOI, Byoungki, 16678 Suwon-si (KR); HONG, Sunghun, 16678 Suwon-si (KR); HONG, Youngki, 16678 Suwon-si (KR); HWANG, Kyuyoung, 16678 Suwon-si (KR)
(74) Representative: Elkington and Fife LLP

(56) References cited:
- US-A1- 2012 292 601
- US-A1- 2017 346 025

## Description

### FIELD OF THE INVENTION

The subject matter relates to organometallic compounds, organic light-emitting devices including the same, and electronic apparatuses including the organic light-emitting devices.

### BACKGROUND OF THE INVENTION

Organic light-emitting devices (OLEDs) are self-emissive devices, which have improved characteristics in terms of viewing angles, response time, luminance, driving voltage, and response speed. In addition, OLEDs can produce full-color images.

In an example, an organic light-emitting device typically includes an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. These excitons may transition from an excited state to the ground state to thereby generate light.

US 2017/346025 discloses an organic light-emitting device. US 2012/292601 discloses iridium complexes and their use in organic light-emitting devices.

### SUMMARY OF THE INVENTION

Provided are organometallic compounds, organic light-emitting devices including the same, and electronic apparatuses including the organic light-emitting devices.

Additional aspects will be set forth in part in the detailed description, which follows and, in part, will be apparent from the detailed description, or may be learned by practice of the presented exemplary embodiments.

According to the invention, provided is an organometallic compound in accordance with claim 1.

According to an embodiment, provided is an organic light-emitting device including a first electrode, a second electrode, and an organic layer arranged between the first electrode and the second electrode, wherein the organic layer includes an emission layer, and wherein the organic layer includes at least one organometallic compound represented by Formula 1.

The emission layer may include the at least one organometallic compound, and the at least one organometallic compound included in the emission layer may act as a dopant.

According to still another embodiment, provided is an electronic apparatus including the organic light-emitting device as described herein.

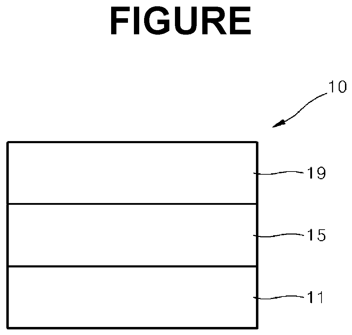

### BRIEF DESCRIPTION OF THE DRAWING

The above and other aspects, features, and advantages of certain exemplary embodiments of the disclosure will be more apparent from the following detailed description taken in conjunction with the FIGURE, which is a schematic cross-sectional view of an organic light-emitting device according to one or more embodiments.

### DETAILED DESCRIPTION OF THE EMBODIMENTS

Reference will now be made in detail to exemplary embodiments, examples of which are illustrated in the accompanying drawing, wherein like reference numerals refer to like elements throughout the specification. In this regard, the present exemplary embodiments may have different forms and should not be construed as being limited to the detailed descriptions set forth herein. Accordingly, the exemplary embodiments are merely described in further detail below by referring to the figure, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volts (eV)" of the vacuum level, while when the work function or the HOMO energy level is referred to be "shallow," "low," or "small," the work function or HOMO energy level has a small absolute value based on "0 eV" of the vacuum level.

An organometallic compound according to the invention is represented by Formula 1:

Formula 1 M(L₁)ₙ₁(L₂)ₙ₂

wherein M in Formula 1 is iridium, platinum, osmium, or rhodium.

In Formula 1, L₁ is a ligand represented by Formula 2-1, and L₂ is a ligand represented by Formula 2-2: 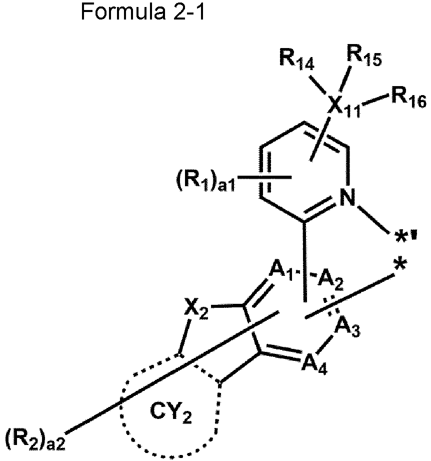 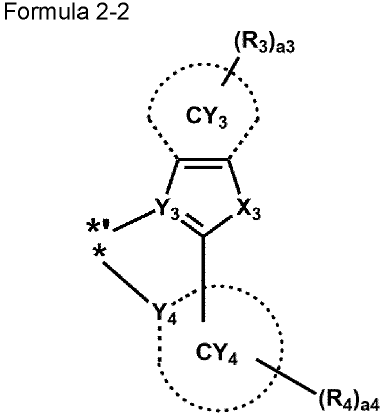 wherein Formulae 2-1 and 2-2 are each independently as described herein.

n1 and n2 in Formula 1 indicate numbers of L₁ groups and L₂ groups, respectively, and are each independently 1 or 2. When n1 is 2, two L₁ are identical to or different from each other, and when n2 is 2, two L₂ are identical to or different from each other.

In one or more embodiments, in Formula 1, i) n1 may be 2, and n2 may be 1; or ii) n1 may be 1, and n2 may be 2.

In one or more embodiments, in Formula 1, i) M may be iridium or osmium, and a sum of n1 and n2 may be 3; or ii) M may be platinum, and a sum of n1 and n2 may be 2.

L₁ and L₂ in Formula 1 are different from each other. In other words, the organometallic compound represented by Formula 1 is a heteroleptic complex.

X₁₁ in Formula 2-1 is Si or Ge.

In one or more embodiments, X₁₁ may be Si.

In one or more embodiments, X₁₁ may be Ge.

In Formula 2-1, X₂ is O, S, Se, N(R₂₉), C(R₂₉ₐ)(R_{29b}), or Si(R₂₉ₐ)(R_{29b}). R₂₉, R₂₉ₐ, and R_{29b} are each independently as described herein.

In one or more embodiments, X₂ may be O or S.

In Formula 2-1, A₁ to A₄ are each independently C or N, wherein one of A₁ to A₄ is C bonded to a neighboring pyridine group, and another one among A₁ to A₄ is C bonded to M in Formula 1.

In one or more embodiments, in Formula 2-1,
i) A₁ may be C bonded to a neighboring pyridine group, A₂ may be C bonded to M in Formula 1, and A₃ and A₄ may each independently be C or N,
ii) A₂ may be C bonded to a neighboring pyridine group, A₃ may be C bonded to M in Formula 1, and A₁ and A₄ may each independently be C or N,
iii) A₃ may be C bonded to a neighboring pyridine group, A₄ may be C bonded to M in Formula 1, and A₁ and A₂ may each independently be C or N,
iv) A₂ may be C bonded to a neighboring pyridine group, A₁ may be C bonded to M in Formula 1, and A₃ and A₄ may each independently be C or N,
v) A₃ may be C bonded to a neighboring pyridine group, A₂ may be C bonded to M in Formula 1, and A₁ and A₄ may each independently be C or N, or
vi) A₄ may be C bonded to a neighboring pyridine group, A₃ may be C bonded to M in Formula 1, and A₁ and A₂ may each independently be C or N.

In one or more embodiments, a group represented by 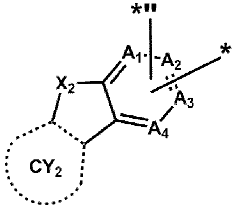 in Formula 2-1 may be a group represented by one of Formulae CY2-A to CY2-F: 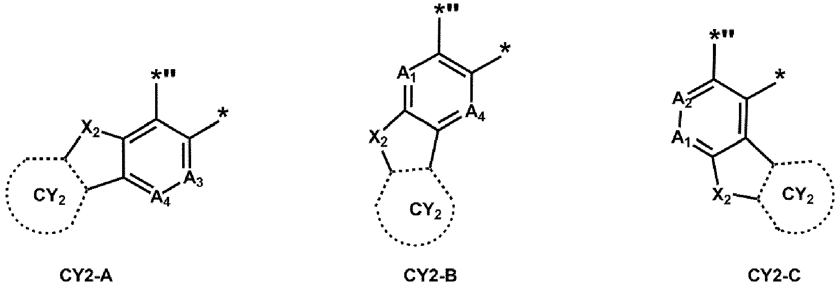 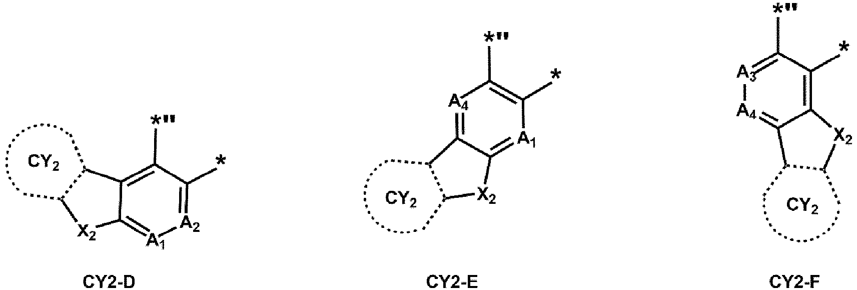
wherein, in Formulae CY2-A to CY2-F,
   X₂ and ring CY₂ may each independently as described herein,
   A₁ to A₄ may each independently be C or N,
   *" may indicate a binding site to a neighboring pyridine group in Formula 2-1, and
   * may indicate a binding site to M in Formula 1.
Y₃ in Formulae 2-2 is N.
X₃ in Formulae 2-2 is O, S, or N-(T₃-Z₃), wherein T₃ and Z₃ are each as defined herein.

In one or more embodiments, X₃ may be N-(T₃-Z₃), wherein T₃ and Z₃ are each as defined herein.

T₃ is a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In one or more embodiments, T₃ may be:
a single bond; or
a C₁-C₂₀ alkylene group, a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or benzothiadiazole group, each unsubstituted or substituted with at least one R₁₀ₐ.

In one or more embodiments, T₃ may be:
a single bond; or
a benzene group that is unsubstituted or substituted with at least one R₁₀ₐ.

In one or more embodiments, T₃ may be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

Y₄ in Formulae 2-2 is C or N.

In one or more embodiments, Y₄ may be C.

In Formulae 2-1 and 2-2, ring CY₂ to ring CY₄ are each independently a C₅-C₃₀ carbocyclic group or a C₁-C₃₀ heterocyclic group, wherein ring CY₂ is a C₃-C₃₀ heterocyclic group comprising at least one N as a ring-forming atom (for example, including a group represented by one *=N-*', two *=N-*', or three *=N-*' as a ring-forming atom); at least one of A₁ to A₄ is N; or ring CY₂ is a C₃-C₃₀ heterocyclic group including at least one N as a ring-forming atom (for example, including a group represented by one *=N-*', two *=N-*', or three *=N-*' as a ring-forming atom), and at least one of A₁ to A₄ is N.

For example, ring CY₂ to ring CY₄ may each independently be i) a first ring, ii) a second ring, iii) a condensed ring system in which at least two first rings are condensed to each other, iv) a condensed ring system in which at least two second rings are condensed with each other, or v) a condensed ring system in which at least one first ring and at least one second ring are condensed with each other,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (i.e., a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, rings CY₂ to CY₄ may each independently be a cyclopentane group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, an azaphenanthrobenzoselenophene group, a pyridine group, a pyrimidine group, a pyrazine group, a pyridazine group, a triazine group, a quinoline group, an isoquinoline group, a quinoxaline group, a quinazoline group, a phenanthridine group, a phenanthroline group, a benzoquinoline group, a benzoisoquinoline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, a norbornene group, a benzene group condensed with an adamantane group, a benzene group condensed with a norbornane group, a benzene group condensed with a norbornene group, a pyridine group condensed with an adamantane group, a pyridine group condensed with a norbornane group, or a pyridine group condensed with a norbornene group.

In one or more embodiments, ring CY₂ may be a benzene group, a naphthalene group, a phenanthrene group, an anthracene group, a carbazole group, a fluorene group, a dibenzosilole group, a dibenzothiophene group, a dibenzofuran group, a dibenzoselenophene group, a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group.

In one or more embodiments, ring CY₂ may be a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group.

In one or more embodiments, ring CY₂ may be a benzene group, a naphthalene group, a phenanthrene group, an anthracene group, a carbazole group, a fluorene group, a dibenzosilole group, a dibenzothiophene group, a dibenzofuran group, or a dibenzoselenophene group, and at least one of A₁ to A₄ in Formula 2-1 may be N.

In one or more embodiments, ring CY₂ may be a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group, and at least one of A₁ to A₄ in Formula 2-1 may be N.

In one or more embodiments, ring CY₃ may be a benzene group, a naphthalene group, an anthracene group, a phenanthrene group, a pyridine group, a pyrimidine group, a pyridazine group, a pyrazine group, a quinoline group, or an isoquinoline group.

In one or more embodiments, ring CY₄ may be a benzene group, a naphthalene group, an anthracene group, a phenanthrene group, a 1,2,3,4-tetrahydronaphthalene group, a benzene group condensed with a norbornane group, a carbazole group, a fluorene group, a dibenzosilole group, a dibenzothiophene group, a dibenzofuran group, a dibenzoselenophene group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group.

R₁ to R₄, R₁₄ to R₁₆, R₂₉, R₂₉ₐ, R_{29b}, and Z₃ in Formulae 2-1 and 2-2 are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), or -P(Q₈)(Q₉). Q₁ to Q₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, R₁ to R₄, R₁₄ to R₁₆, R₂₉, R₂₉ₐ, R_{29b}, and Z₃ may each not be -Ge(Q₃)(Q₄)(Q₅).

In one or more embodiments, R₁ to R₄, R₁₄ to R₁₆, R₂₉, R₂₉ₐ, R_{29b}, and Z₃ may each not include germanium.

In one or more embodiments, R₁ to R₄, R₁₄ to R₁₆, R₂₉, R₂₉ₐ, R_{29b}, and Z₃ may each not be -Si(Q₃)(Q₄)(Q₅).

In one or more embodiments, R₁ to R₄, R₁₄ to R₁₆, R₂₉, R₂₉ₐ, R_{29b}, and Z₃ may each not include silicon.

In one or more embodiments, R₁ to R₄, R₁₄ to R₁₆, R₂₉, R₂₉ₐ, R_{29b}, and Z₃ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a cyclopentyl group, a cyclohexyl group, a cycloheptyl group, a cyclooctyl group, an adamantanyl group, a norbornanyl group(bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or azadibenzothiophenyl group, each unsubstituted or substituted with at least one of deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, - Si(Q₃₃)(Q₃₄)(Q₃₅), -Ge(Q₃₃)(Q₃₄)(Q₃₅), or a combination thereof; or
-N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉), and
Q₁ to Q₉ and Q₃₃ to Q₃₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₂₀ alkyl group, a phenyl group, or a combination thereof.

In one or more embodiments, R₁ to R₄, R₂₉, R₂₉ₐ, R_{29b}, and Z₃ may each independently be:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, - Si(Q₃₃)(Q₃₄)(Q₃₅), -Ge(Q₃₃)(Q₃₄)(Q₃₅), or a combination thereof.

In one or more embodiments, R₁₄ to R₁₆ may each independently be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In one or more embodiments, R₁₄ to R₁₆ in Formula 2-1 may each independently be -CH₃, -CH₂CH₃, -CD₃, -CD₂H, -CDH₂, -CH₂CD₃, -CD₂CH₃, or a phenyl group.

In one or more embodiments, R₁₄ to R₁₆ in Formula 2-1 may be identical to or different from each other.

In one or more embodiments, R₁ to R₄, R₁₄ to R₁₆, R₂₉, R₂₉ₐ, R_{29b}, and Z₃ in Formulae 2-1 and 2-2 may each independently be hydrogen, deuterium, -F, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, -CH₃, -CD₃, -CD₂H, -CDH₂, -CF₃, -CF₂H, -CFH₂, -OCH₃, -OCDH₂, -OCD₂H, -OCD₃, -SCH₃, -SCDH₂, -SCD₂H, - SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, -Si(Q₃)(Q₄)(Q₅), or - Ge(Q₃)(Q₄)(Q₅), wherein Q₃ to Q₅ may each independently be as described herein.

In one or more embodiments, at least one of R₁(s) in the number of a1 in Formula 2-1 (for example, R₁₁ in Formula CY1-1) may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F: 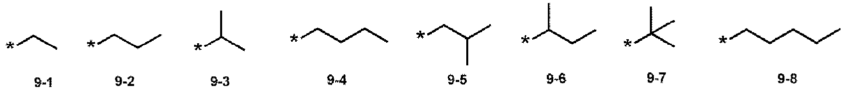 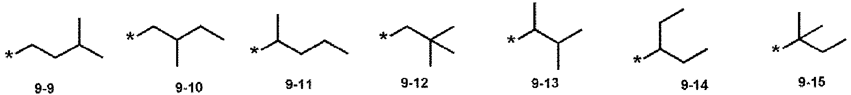 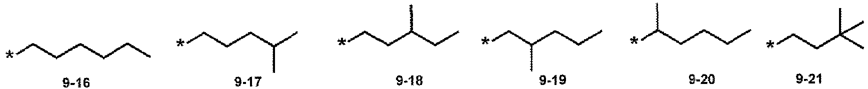 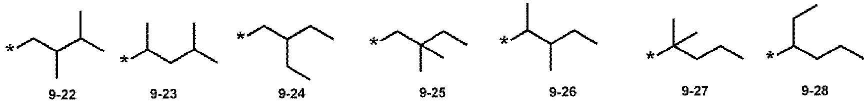 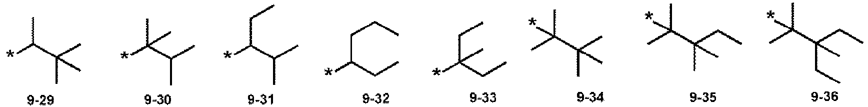 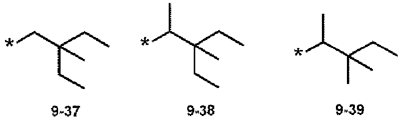 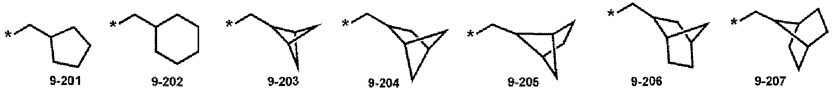 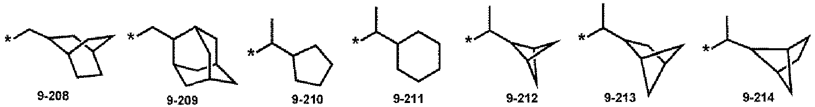 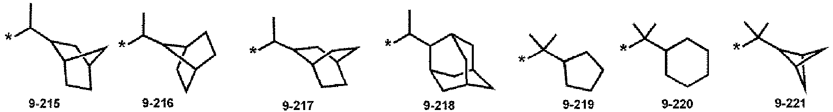 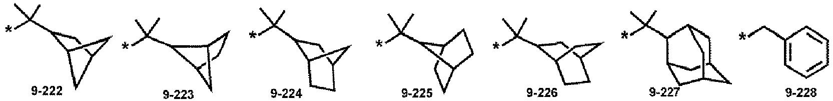 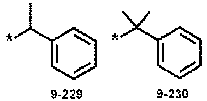 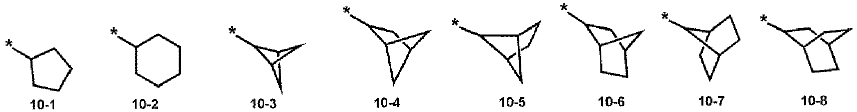 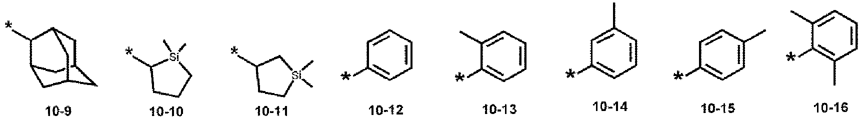 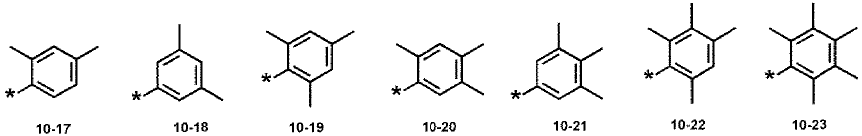 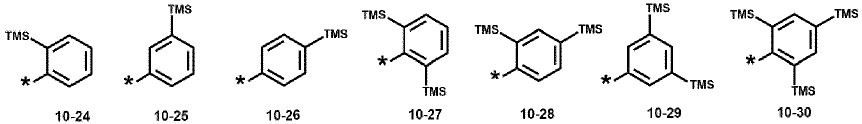 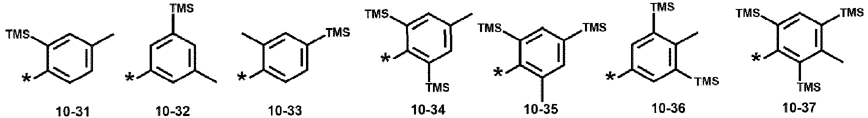 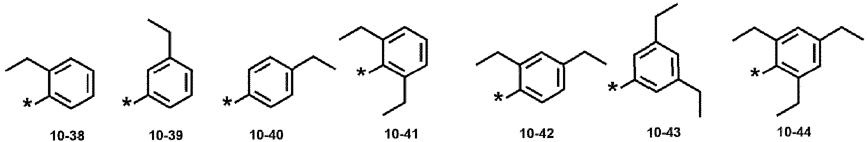 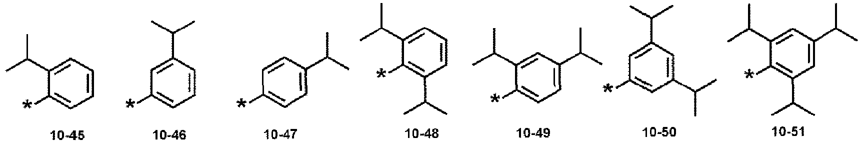 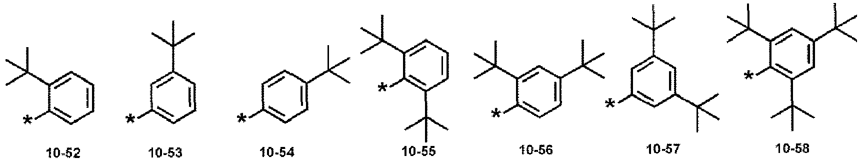 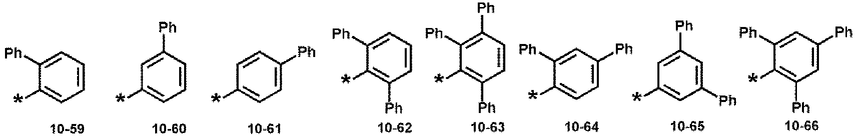 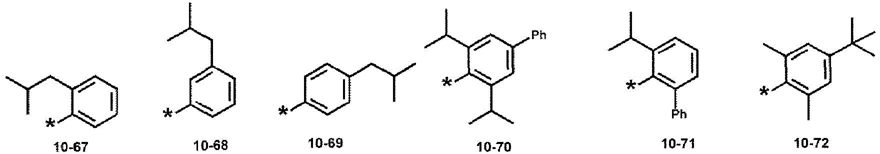 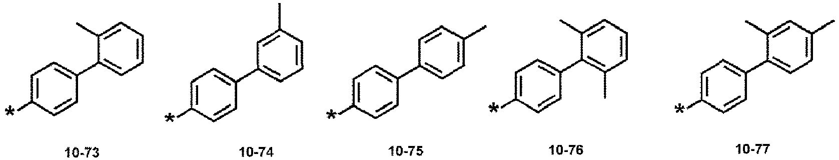 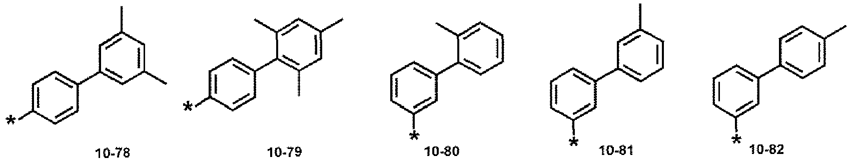 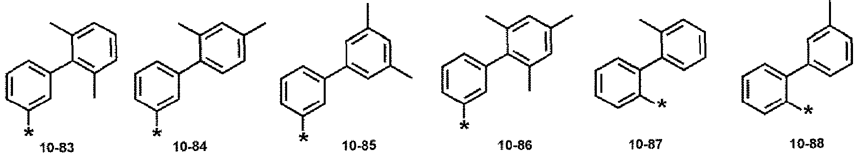 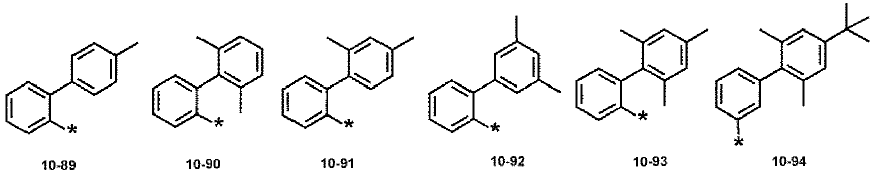 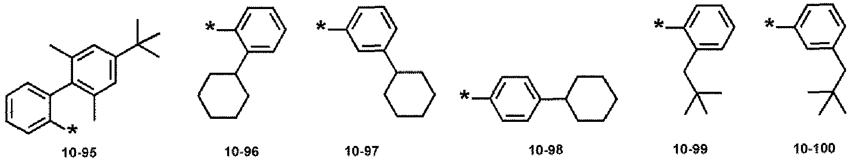 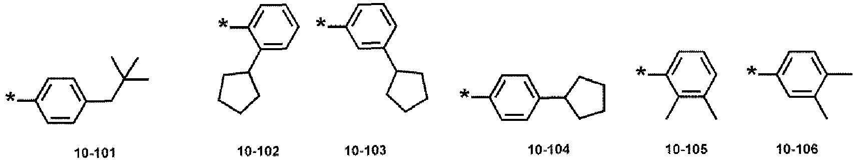 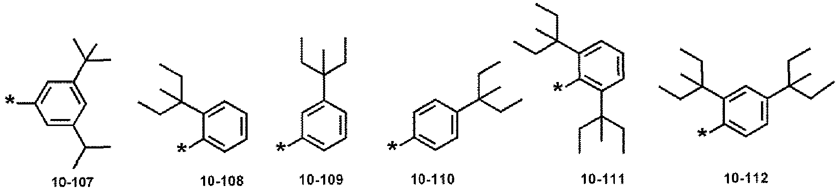 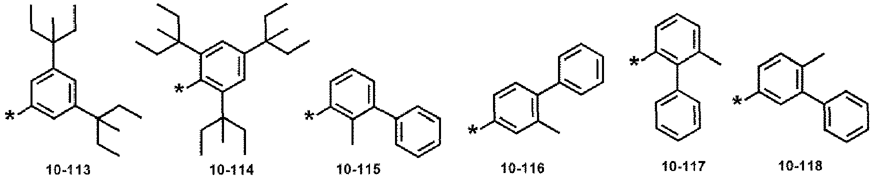 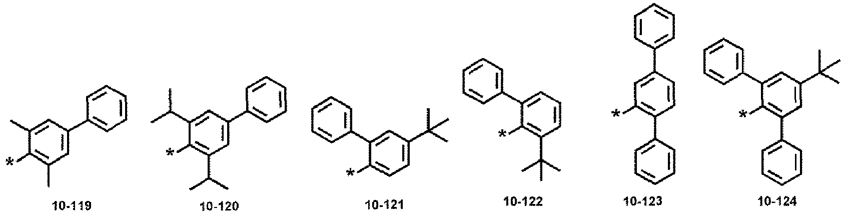 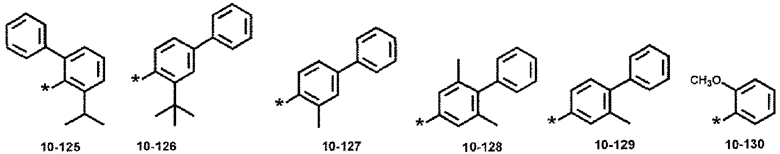 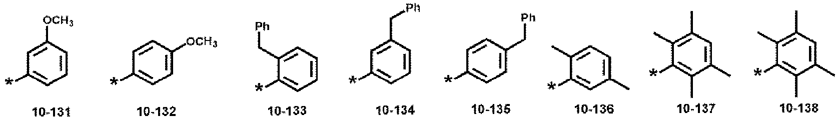 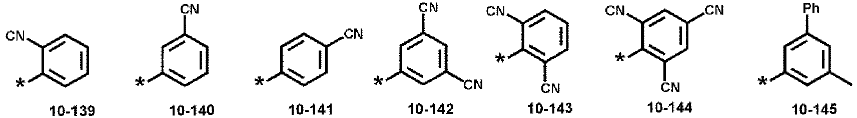 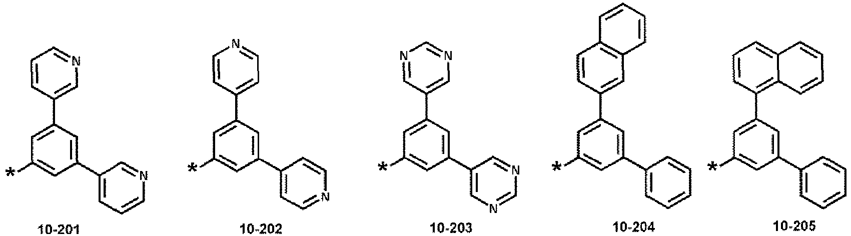 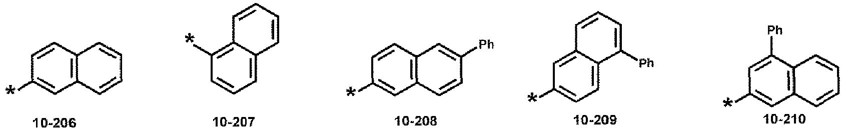 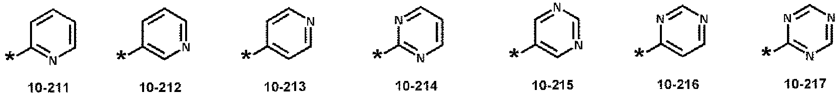 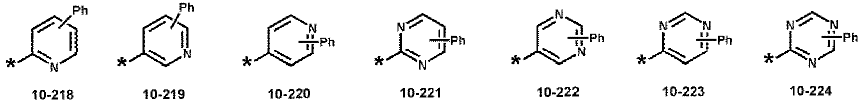 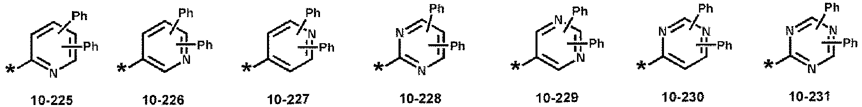 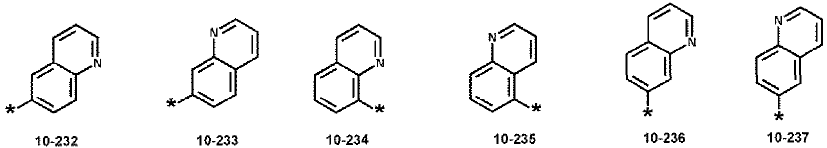 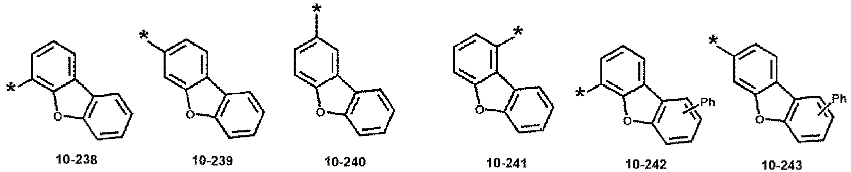 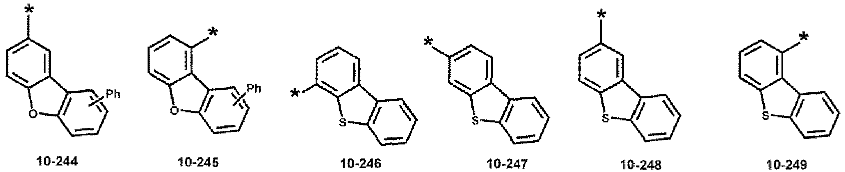 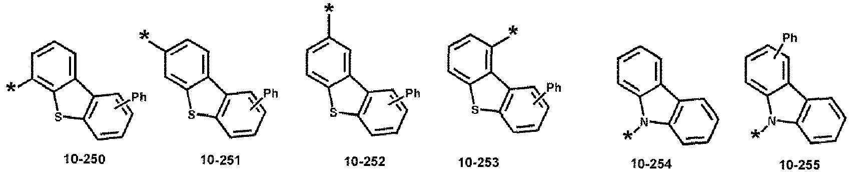 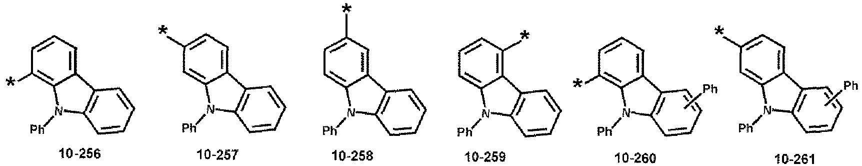 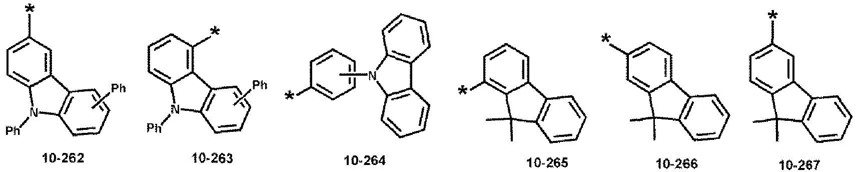 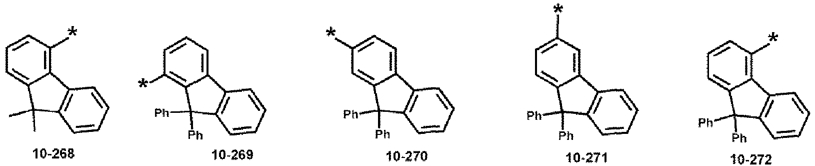 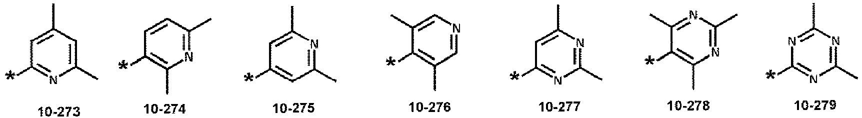 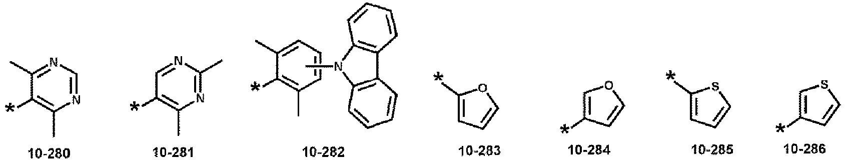 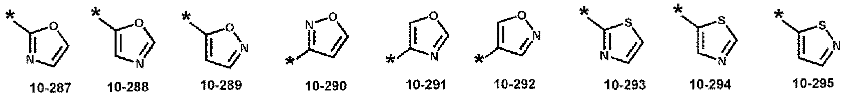 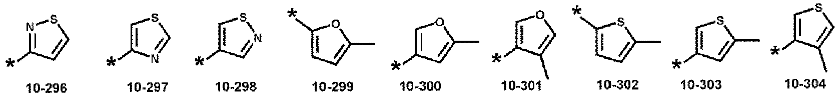 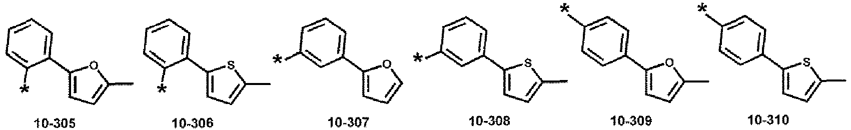 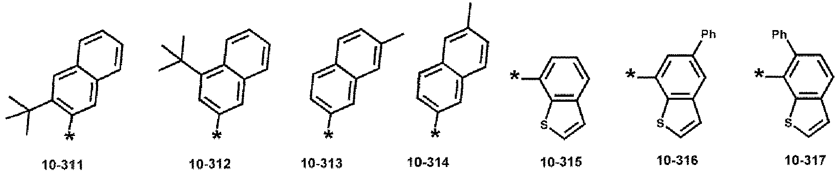 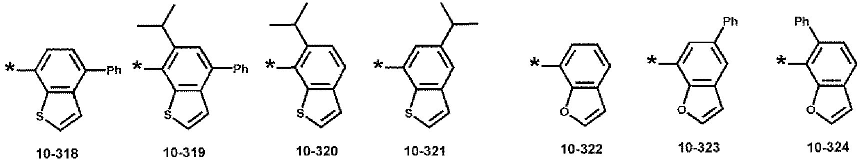 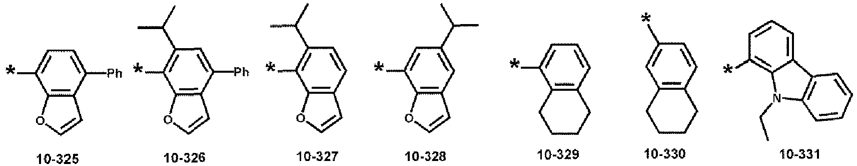 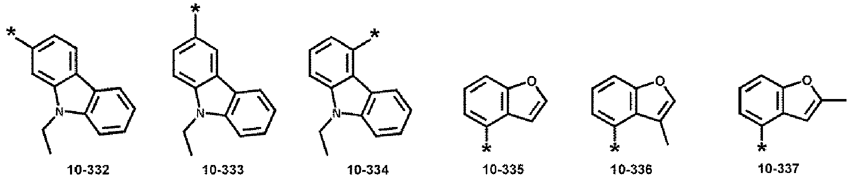 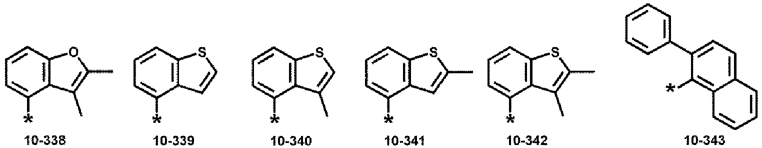 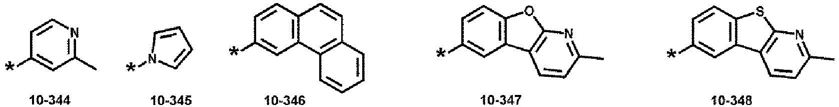 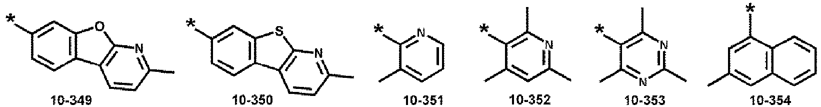 wherein, in Formulae 9-1 to 9-39, 9-201 to 9-230, 10-1 to 10-145, and 10-201 to 10-354, * indicates a binding site to a neighboring atom, "Ph" indicates a phenyl group, "TMS" indicates a trimethylsilyl group, and "TMG" indicates a trimethylgermyl group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may be, for example, a group represented by one of Formulae 9-501 to 9-514 or 9-601 to 9-637:

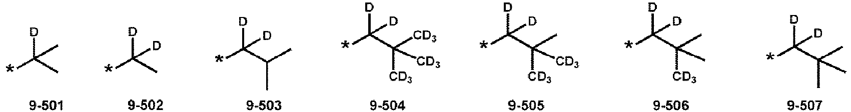

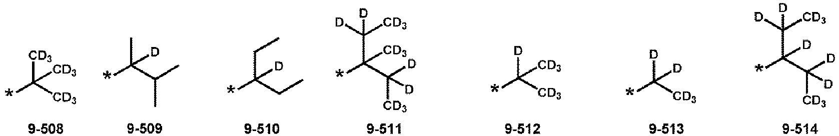

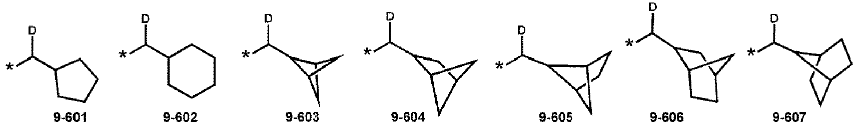

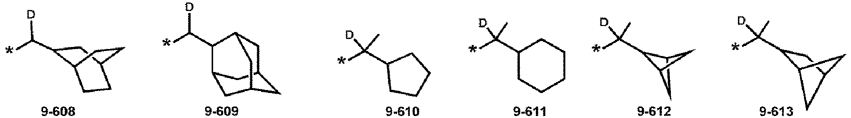

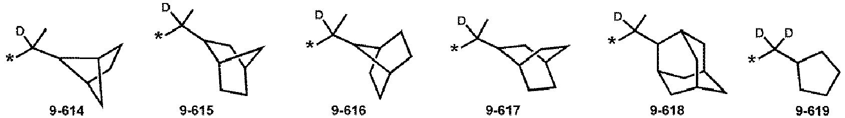

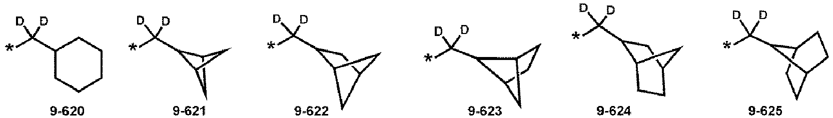

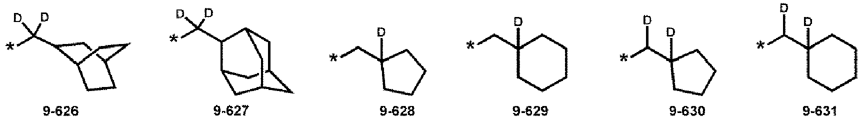

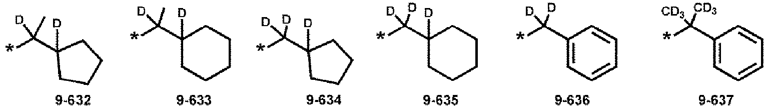

The "group represented by one of Formulae 9-1 to 9-39 in which at least one hydrogen is substituted with -F" and the "group represented by one of Formulae 9-201 to 9-230 in which at least one hydrogen is substituted with -F" may be, for example, a group represented by one of Formulae 9-701 to 9-710:

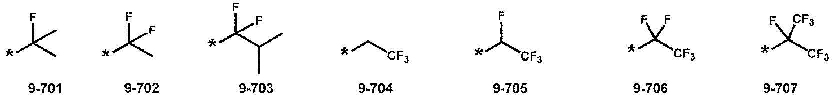

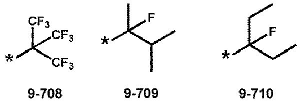

The "group represented by one of Formulae 10-1 to 10-145 in which at least one hydrogen is substituted with deuterium" and the "group represented by one of Formulae 10-201 to 10-354 in which at least one hydrogen is substituted with deuterium" may be, for example, a group represented by one of Formulae 10-501 to 10-553:

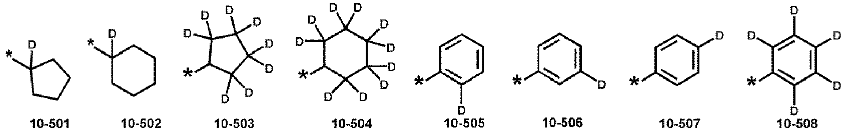

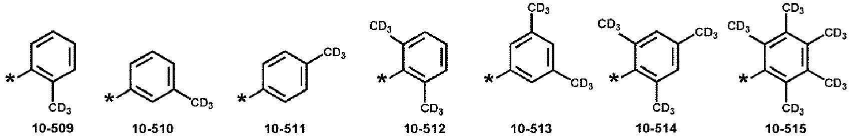

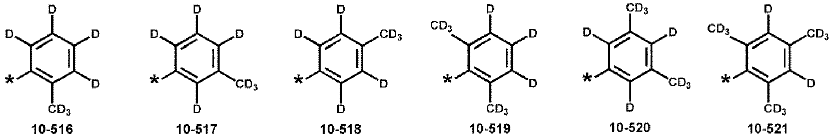

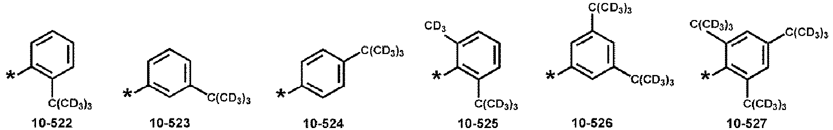

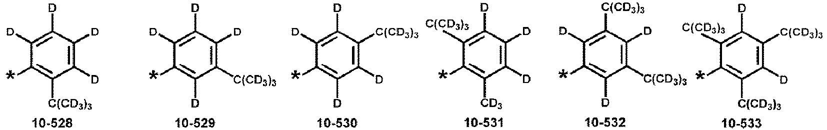

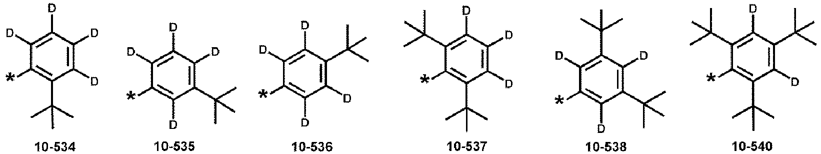

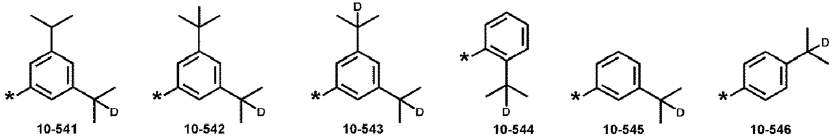

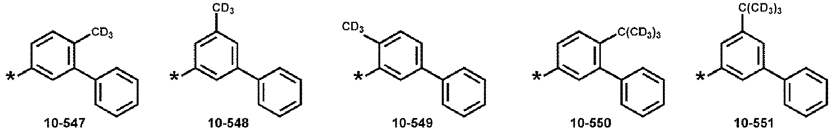

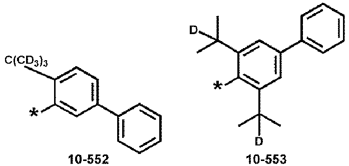

The "group represented by one of Formulae 10-1 to 10-145 in which at least one hydrogen is substituted with -F" and the "group represented by one of Formulae 10-201 to 10-354 in which at least one hydrogen is substituted with -F" may be, for example, a group represented by one of Formulae 10-601 to 10-636:

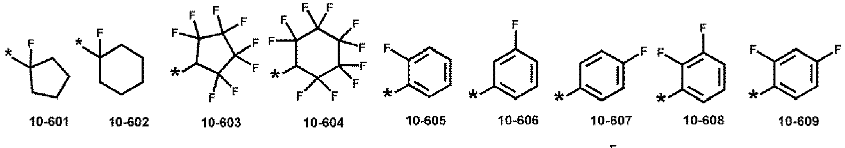

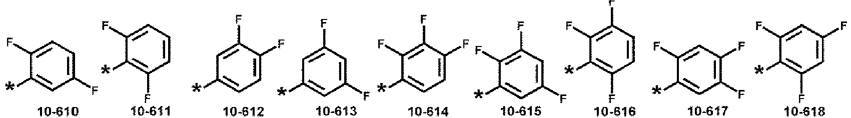

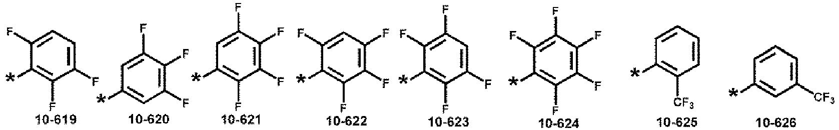

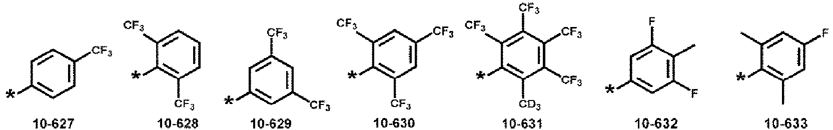

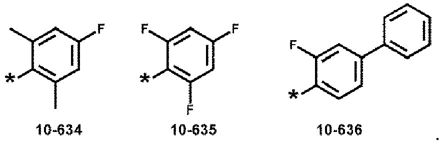

a1 to a4 in Formulae 2-1 and 2-2 each indicates the respective numbers of groups R₁ to R₄, wherein a1 is an integer from 0 to 3, a2 is an integer from 0 to 6, and a3 and a4 are each independently an integer from 0 to 20 (for example, an integer from 0 to 10). When a1 is 2 or greater, two or more R₁ groups may be identical to or different from each other, when a2 is 2 or greater, two or more R₂ groups may be identical to or different from each other, when a3 is 2 or greater, two or more R₃ groups may be identical to or different from each other, and when a4 is 2 or greater, two or more R₄ groups may be identical to or different from each other. In one or more embodiments, a1 to a4 may each independently be 0, 1, 2, or 3.

In one or more embodiments, a2 in Formula 2-1 may not be 0, and R₂ may not be hydrogen.

In one or more embodiments, the organometallic compound may include deuterium, a fluoro group, or a combination thereof.

In one or more embodiments, X₃ in Formulae 2-2 may be N-(T₃-Z₃), and i) Condition A, ii) Condition B, iii) Condition A and Condition B, or iv) Condition A and Condition C, may be satisfied:
Condition A
   T₃ is a C₅-C₃₀ carbocyclic group that is unsubstituted or substituted with at least one R₁₀ₐ, or a C₁-C₃₀ heterocyclic group that is unsubstituted or substituted with at least one R₁₀ₐ (for example, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof);
Condition B
   Z₃ is a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group (for example, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), -Ge(Q₃₃)(Q₃₄)(Q₃₅), or a combination thereof);
Condition C
   Z₃ is:
   hydrogen, deuterium, -F, or a cyano group; or
   a substituted or unsubstituted C₁-C₂₀ alkyl group, a substituted or unsubstituted C₃-C₁₀ cycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group (for example, a C₁-C₂₀ alkyl group, a cyclopentyl group, a cyclohexyl group, a cycloheptyl group, a cyclooctyl group, an adamantanyl group, a norbornanyl group(bicyclo[2.2.1]heptyl group), a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, - Si(Q₃₃)(Q₃₄)(Q₃₅), -Ge(Q₃₃)(Q₃₄)(Q₃₅), or a combination thereof).

In one or more embodiments, the organometallic compound represented by Formula 1 may satisfy at least one of Conditions 1 to 4, 6 to 10 and 12:
Condition 1
   a1 in Formula 2-1 is not 0, and at least one of R₁ in the number of a1 includes deuterium;
Condition 2
   a2 in Formula 2-1 is not 0, and at least one of R₂ in the number of a2 includes deuterium;
Condition 3
   X₃ in Formulae 2-2 is N-(T₃-Z₃), and a group represented by *-T₃-Z₃ includes deuterium;
Condition 4
   a3 in Formula 2-2 is not 0, and at least one of R₃ in the number of a3 includes deuterium;
Condition 6
   a4 in Formulae 2-2 is not 0, and at least one of R₄ in the number of a4 includes deuterium;
Condition 7
   a1 in Formula 2-1 is not 0, and at least one of R₁ in the number of a1 includes a fluoro group;
Condition 8
   a2 in Formula 2-1 is not 0, and at least one of R₂ in the number of a2 includes a fluoro group;
Condition 9
   X₃ in Formulae 2-2 is N-(T₃-Z₃), and a group represented by *-T₃-Z₃ includes a fluoro group;
Condition 10
   a3 in Formula 2-2 is not 0, and at least one of R₃ in the number of a3 includes a fluoro group;
Condition 12
   a4 in Formulae 2-2 is not 0, and at least one of R₄ in the number of a4 includes a fluoro group.

In Formulae 2-1 and 2-2, i) two or more of a plurality of R₁, ii) two or more of a plurality of R₂, iii) two or more of a plurality of R₃, iv) two or more of a plurality of R₄, and v) two or more of R₁ to R₄ are each optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ. In other words, two or more of a plurality of R₁ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, two or more of a plurality of R₂ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, two or more of a plurality of R₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, two or more of a plurality of R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and two or more of R₁ to R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

R₁₀ₐ is as described in connection with R₂. In one or more embodiments, R₁₀ₐ may be as described in connection with R₂, wherein R₁₀ₐ may not be hydrogen.

In Formulae 2-1 and 2-2, * and *' each indicates a binding site to M in Formula 1.

In one or more embodiments, a group represented by 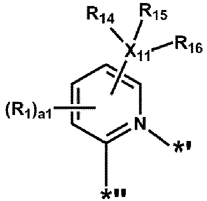 in Formula 2-1 may be a group represented by one of Formulae CY1-1 to CY1-6: 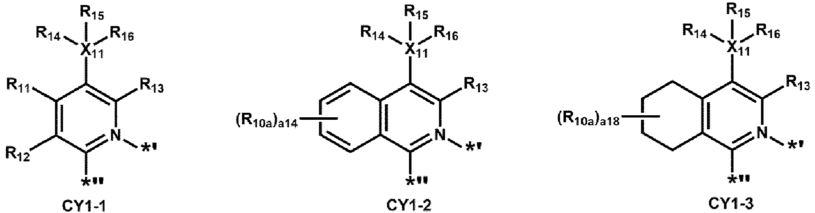 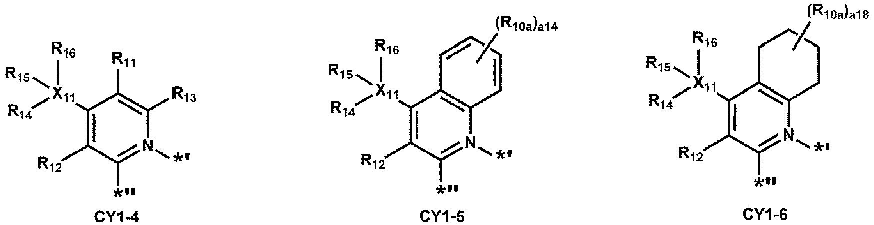 wherein, in Formulae CY1-1 to CY1-6,
X₁₁, R₁₄ to R₁₆, and R₁₀ₐ may each independently be as described herein,
R₁₁ to R₁₃ may each independently be as described in connection with R₁,
a14 may be an integer from 0 to 4,
a18 may be an integer from 0 to 8,
*' may indicate a binding site to M in Formula 1, and
*" may indicate a binding site to one of A₁ to A₄ in Formula 2-1.

In one or more embodiments, R₁₁ in Formulae CY1-1 and/or CY1-4 may not be hydrogen.

In one or more embodiments, R₁₁ in Formulae CY1-1 and/or CY1-4 may be neither hydrogen nor a methyl group.

In one or more embodiments, R₁₁ in Formulae CY1-1 and/or CY1-4 may not be hydrogen, a methyl group, or a cyano group.

In one or more embodiments, in Formulae CY1-1 and/or CY1-4, R₁₁ may not be hydrogen, and R₁₂ and R₁₃ may each be hydrogen.

In one or more embodiments, R₁₁ in Formulae CY1-1 and/or CY1-4 may have two or more carbon atoms, three or more carbon atoms, or four or more carbon atoms.

In one or more embodiments, R₁₁ in Formulae CY1-1 and/or CY1-4 may be:
a methyl group that is substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof; or
a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In one or more embodiments, in Formulae CY1-1 and/or CY1-4, R₁₁, R₁₂ and R₁₃ may each be hydrogen.

In one or more embodiments, a group represented by 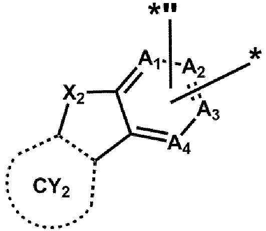 in Formula 2-1 may be a group represented by one of Formulae CY2-1 to CY2-20: 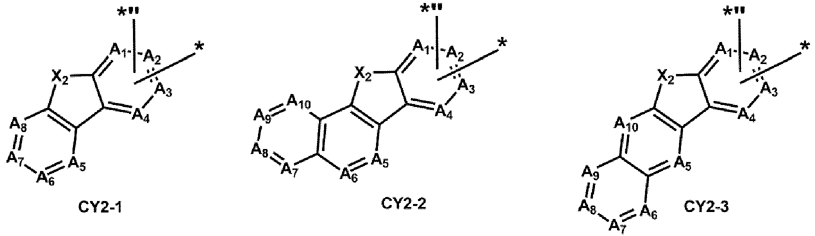 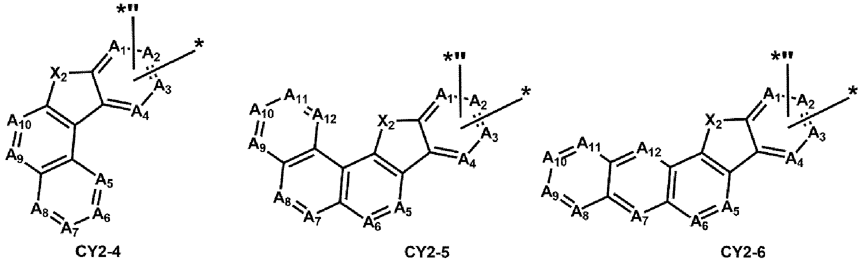 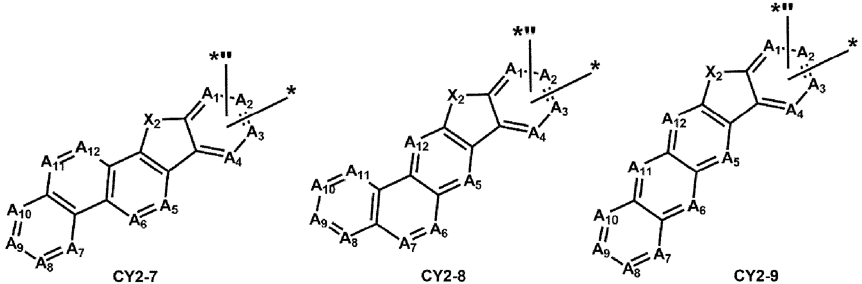 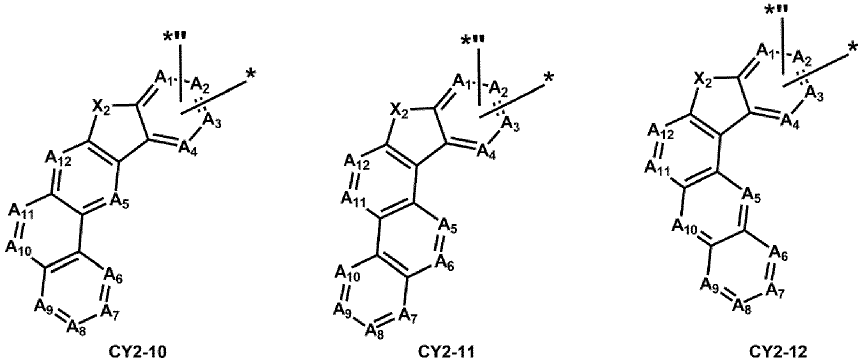 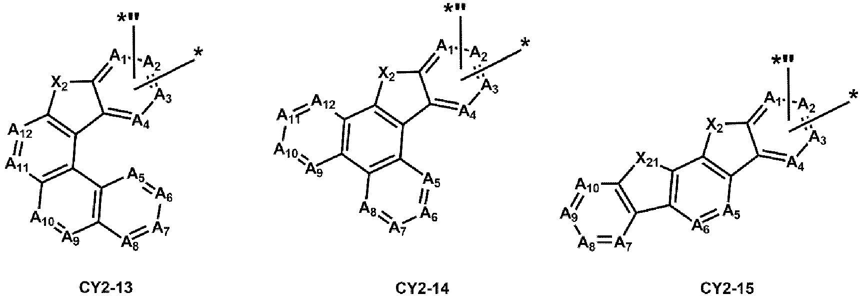 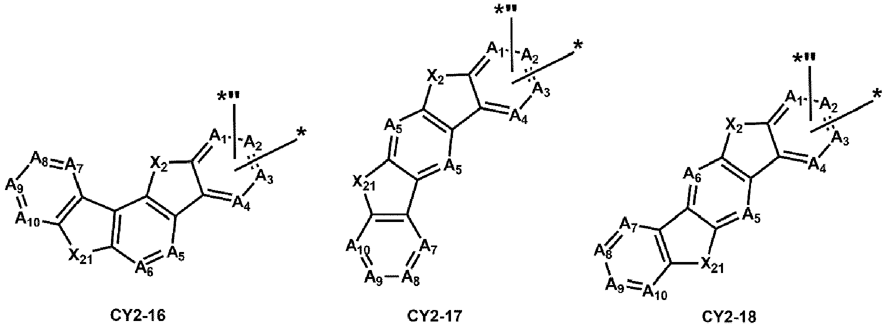 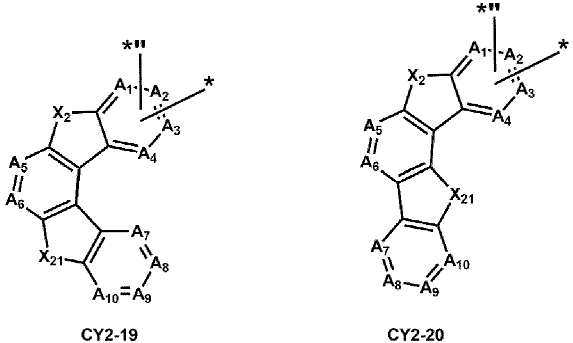 wherein, in Formulae CY2-1 to CY2-20,
X₂ may be as described herein,
X₂₁ may be as described in connection with X₂,
A₁ to A₁₂ may each independently be C or N, at least one of A₁ to A₈ in Formula CY2-1 may be N, at least one of A₁ to A₁₀ in Formulae CY2-2 to CY2-4 and CY2-15 to CY2-20 may be N, and at least one of A₁ to A₁₂ in Formulae CY2-5 to CY2-14 may be N,
   *" may indicate a binding site to a neighboring pyridine group in Formula 2-1, and
   * may indicate a binding site to M in Formula 1.

In one or more embodiments,
at least one of A₄ to A₈ in Formula CY2-1 may be N,
at least one of A₄ to A₁₀ in Formulae CY2-2 to CY2-4 and CY2-15 to CY2-20 may be N, and
at least one of A₄ to A₁₂ in Formulae CY2-5 to CY2-14 may be N.

In one or more embodiments, a group represented by 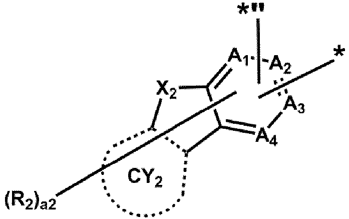 in Formula 2-1 may be a group represented by Formula CY2(1) or CY2(2): 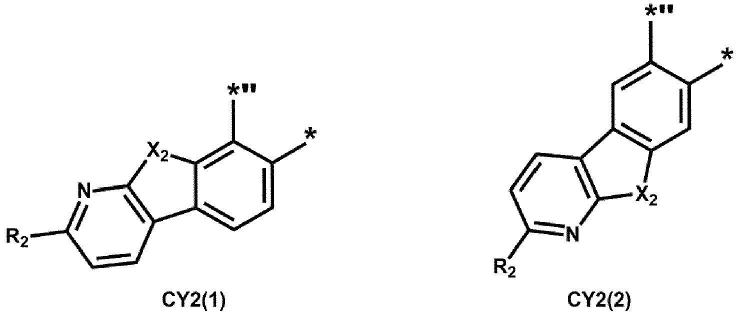 wherein, in Formula CY2(1),
X₂ and R₂ may each independently be as described herein, provided that R₂ may not be hydrogen,
*" may indicate a binding site to a neighboring pyridine group in Formula 2-1, and
* may indicate a binding site to M in Formula 1.

In one or more embodiments, a group represented by 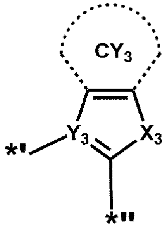 in Formula 2-2 may be a group represented by one of Formulae CY3-1 to CY3-20: 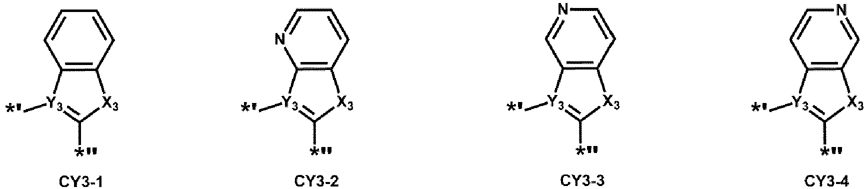 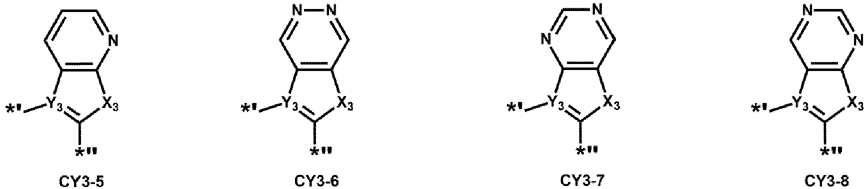 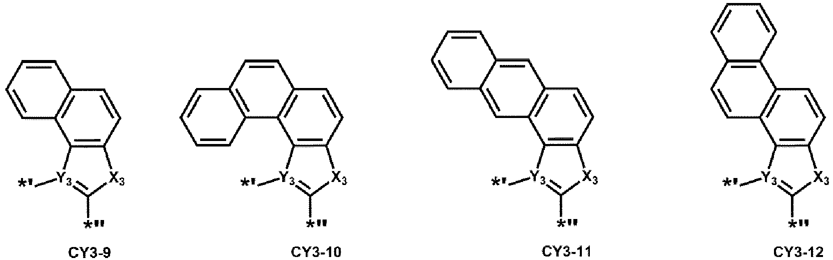 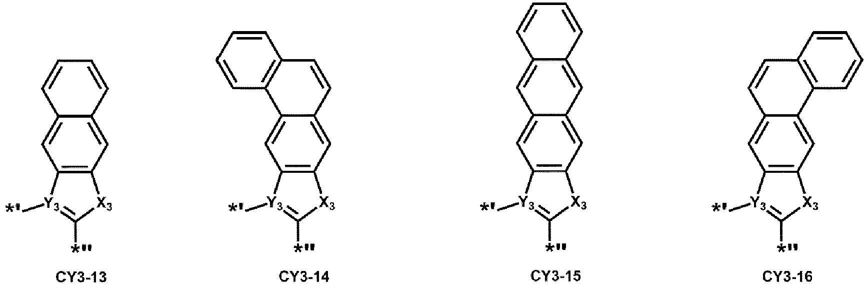 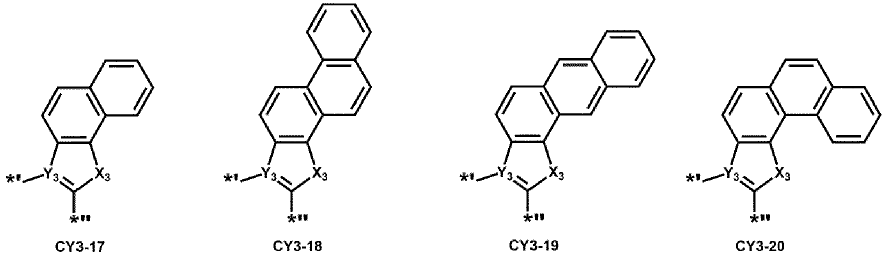 wherein, in Formulae CY3-1 to CY3-20,
Y₃ and X₃ may each independently be as described herein,
*' may indicate a binding site to M in Formula 1, and
*" may indicate a binding site to a neighboring atom in Formula 2-2.

In one or more embodiments, a group represented by 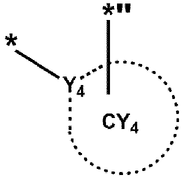 in Formulae 2-2 may be a group represented by one of Formulae CY4-1 to CY4-21: 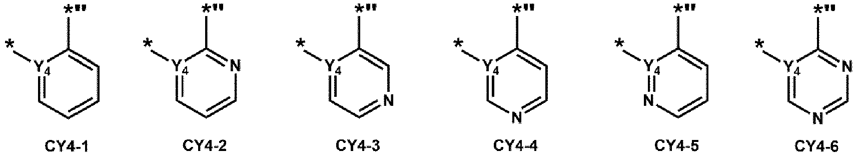 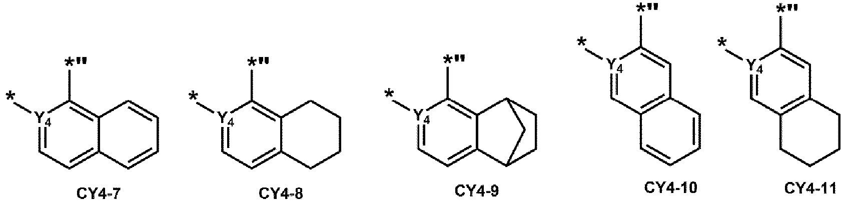 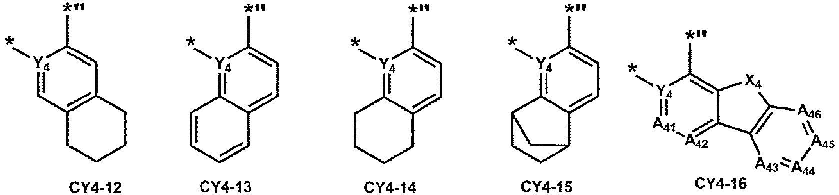 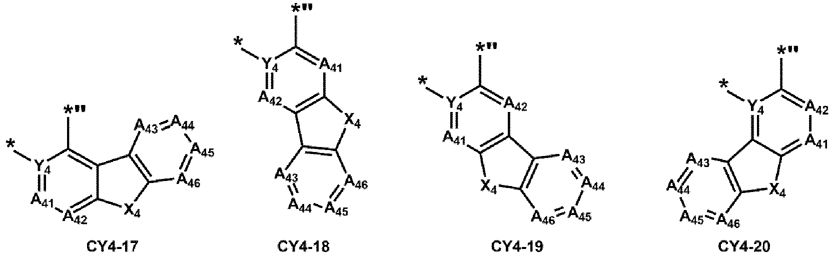 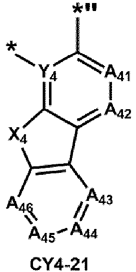 wherein, in Formulae CY4-1 to CY4-21,
Y₄ may be C,
A₄₁ to A₄₆ may each independently be C or N,
X₄ may be O, S, Se, N(R₄₉), C(R₄₉ₐ)(R_{49b}), or Si(R₄₉ₐ)(R_{49b}),
R₄₉, R₄₉ₐ, and R_{49b} may each independently be as described in connection with R₄,
* may indicate a binding site to M in Formula 1, and
*" may indicate a binding site to a neighboring atom in Formula 2-2.

In one or more embodiments, A₄₁ to A₄₆ in Formulae CY4-16 to CY4-21 may each be C.

In one or more embodiments, A₄₆ in Formulae CY4-16 to CY4-21 may be N.

In one or more embodiments, a group represented by 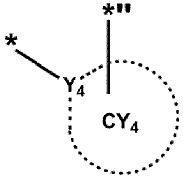 in Formula 2-2 may be a group represented by one of Formulae CY4-1 and CY4-16.

A group represented by 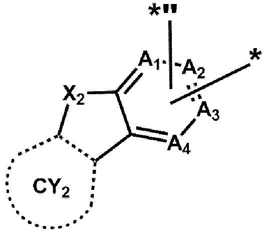 in Formula 2-1 may be substituted with at least one R₂,
ring CY₃ in a group represented by 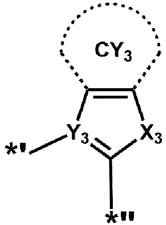 in Formula 2-2 may be substituted with at least one R₃.

In one or more embodiments, the organometallic compound represented by Formula 1 may be one of Compounds Ir1 to Ir295:

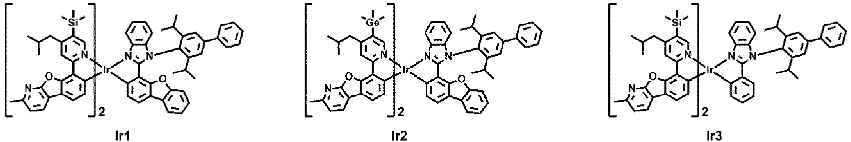

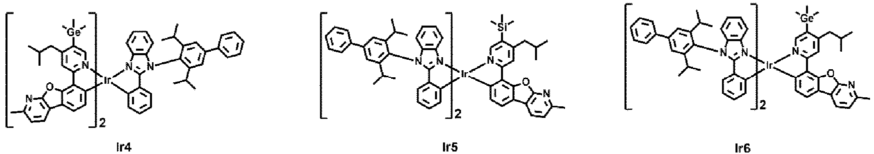

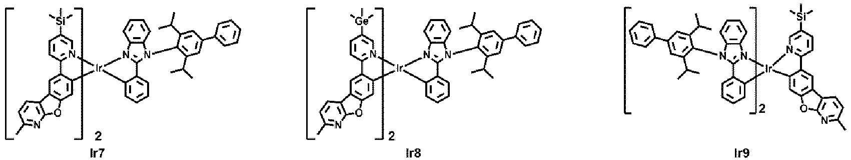

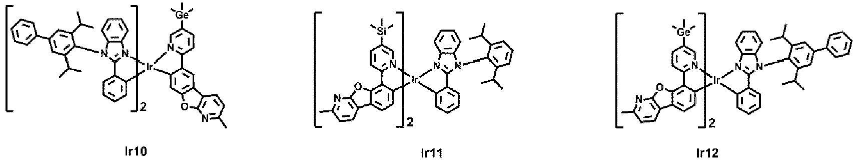

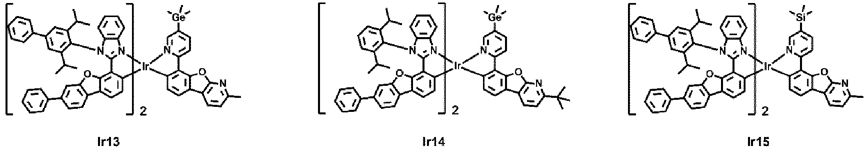

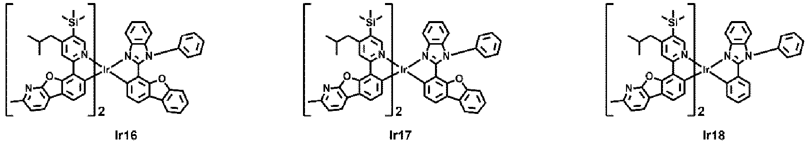

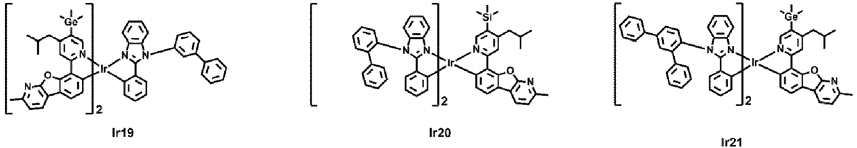

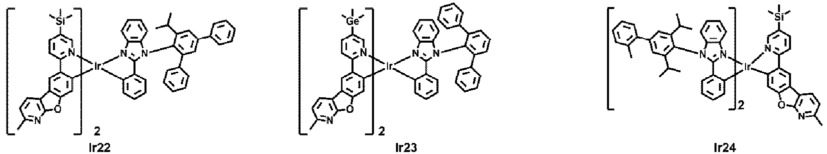

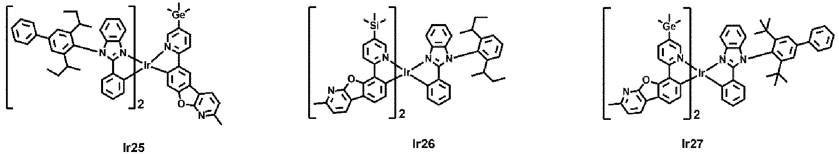

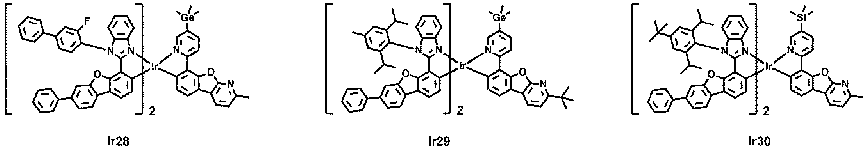

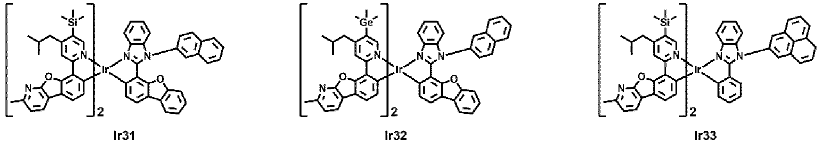

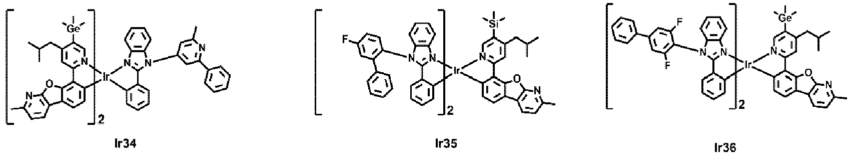

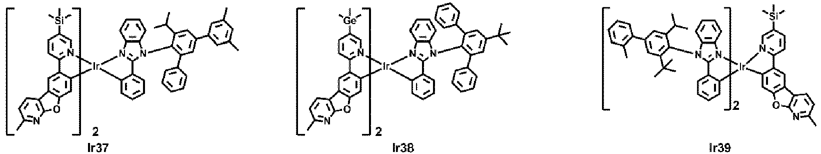

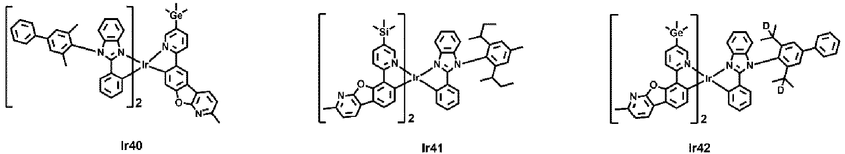

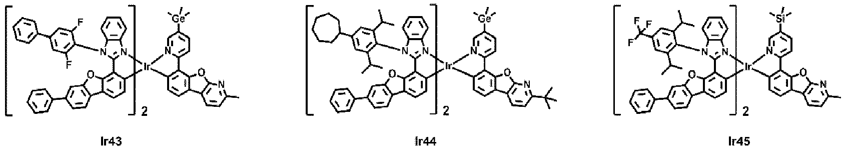

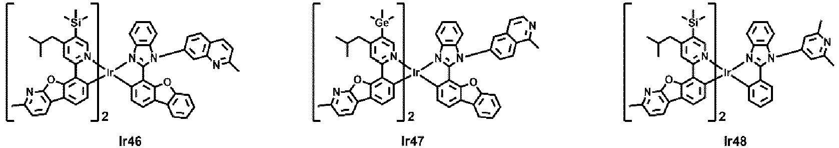

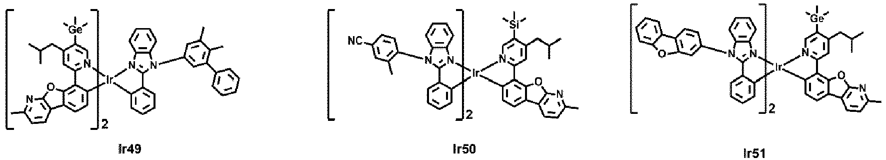

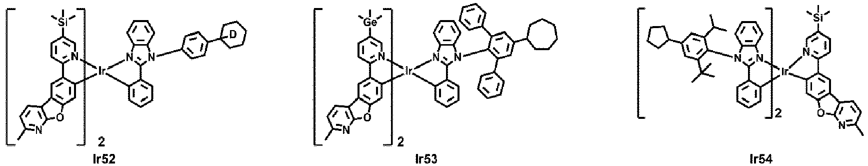

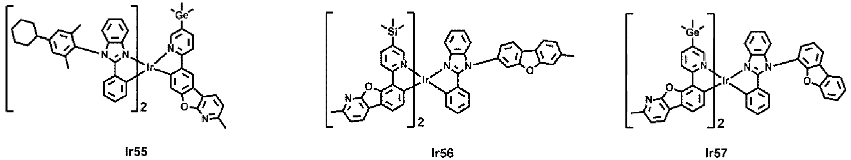

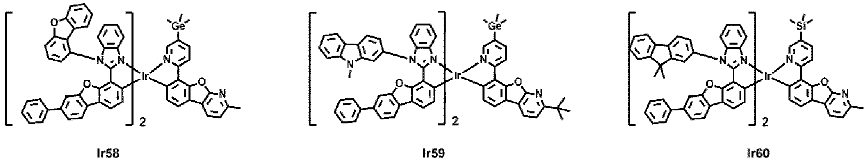

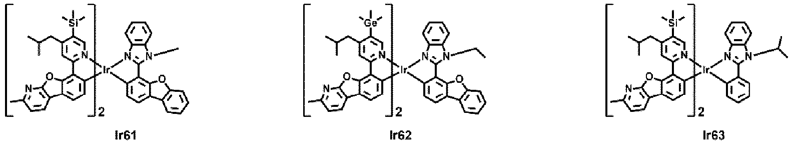

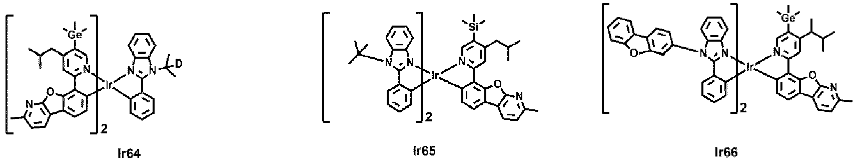

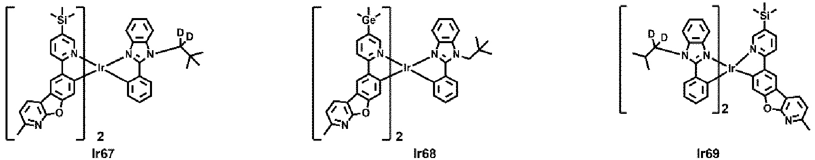

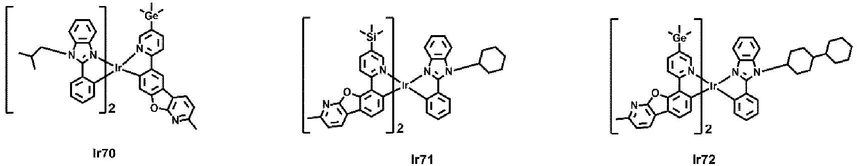

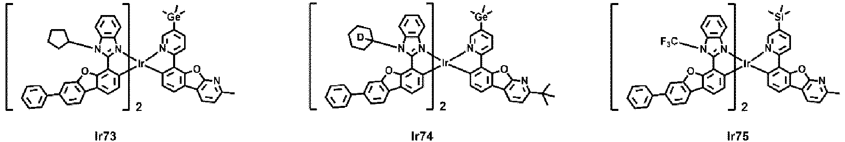

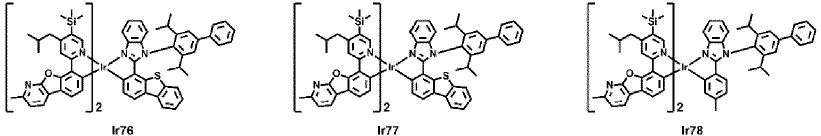

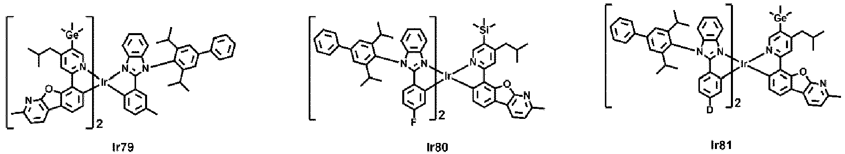

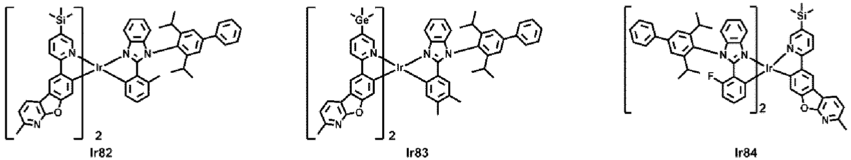

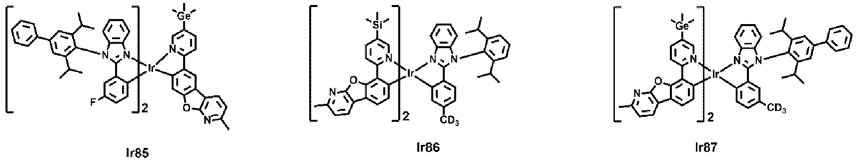

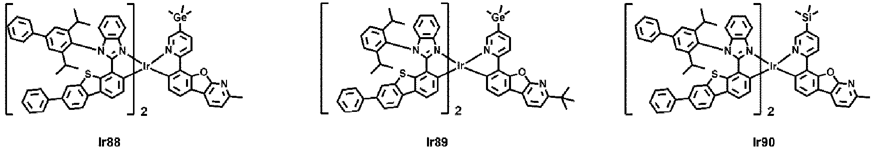

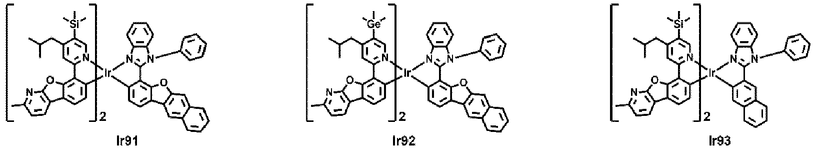

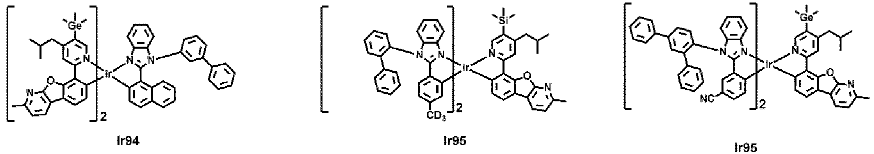

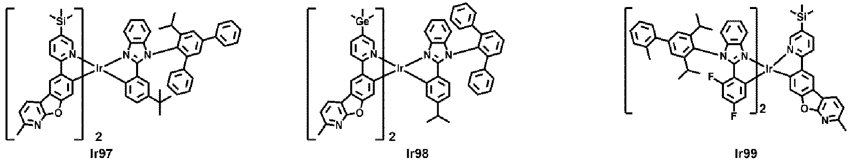

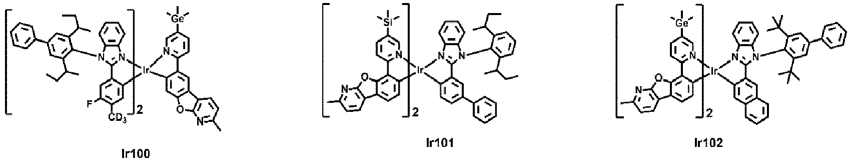

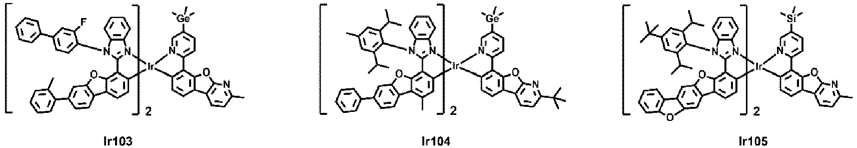

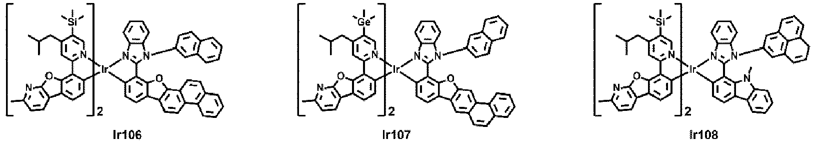

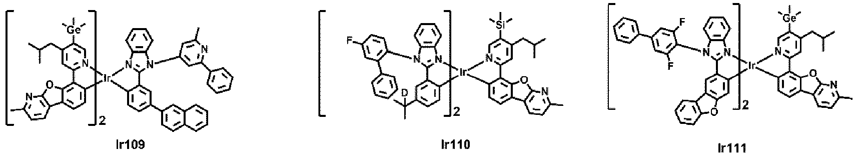

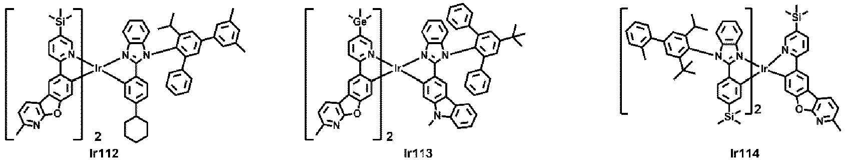

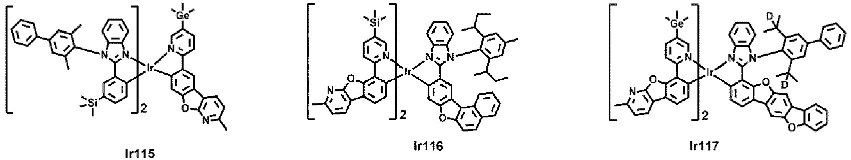

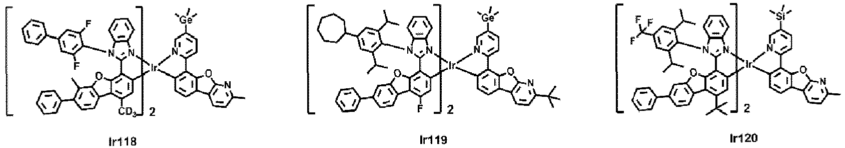

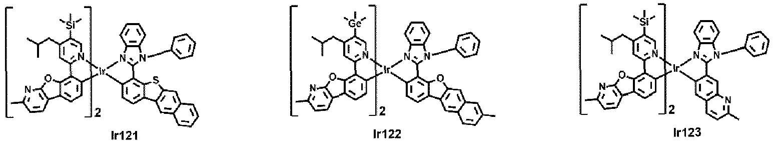

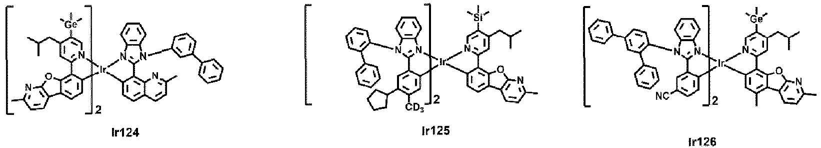

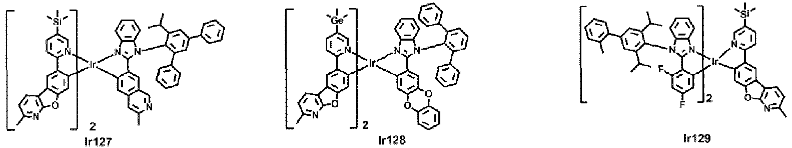

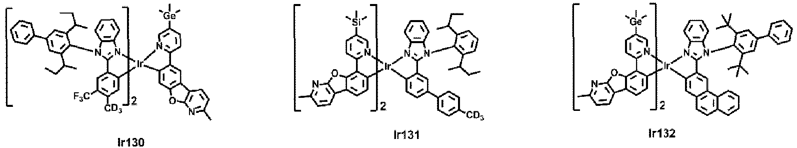

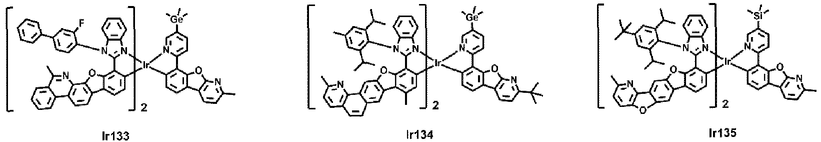

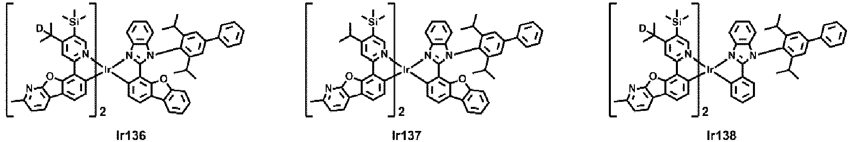

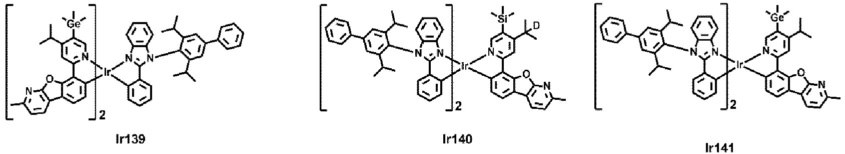

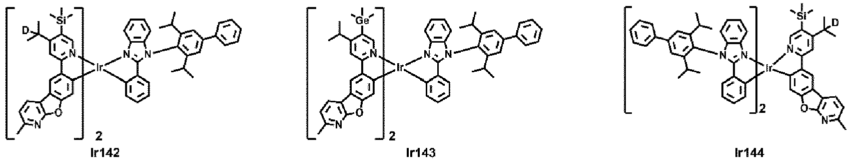

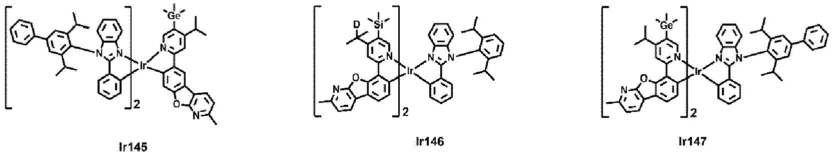

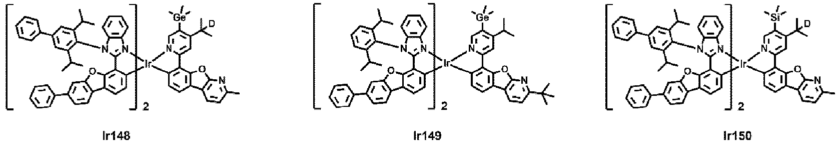

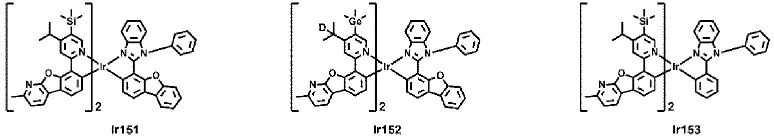

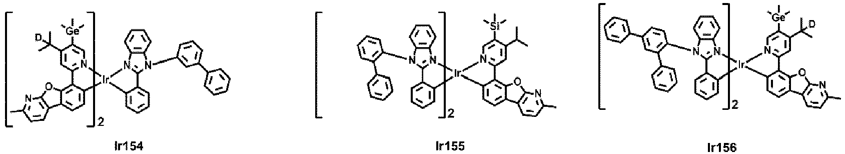

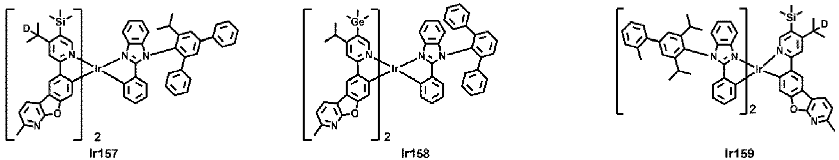

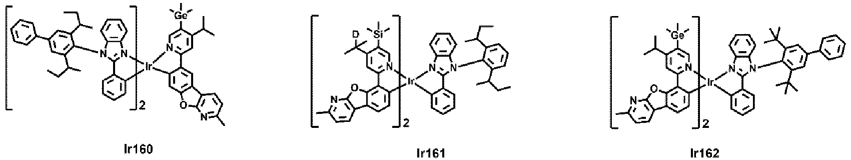

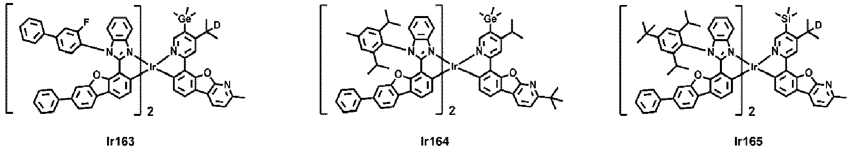

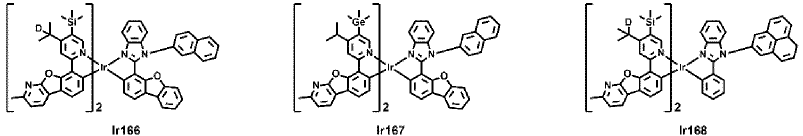

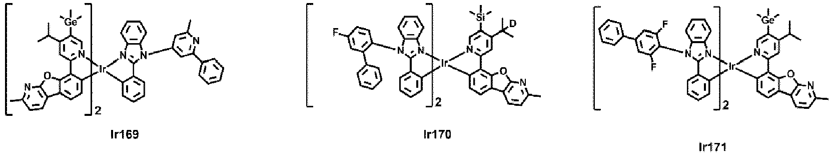

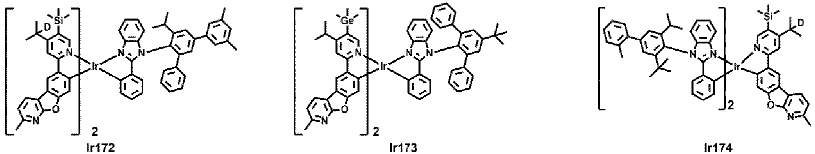

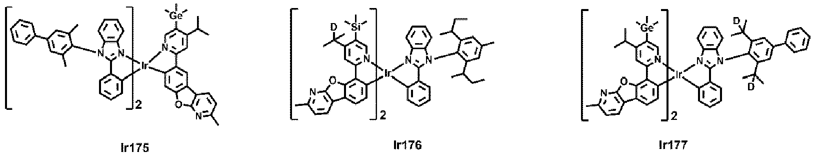

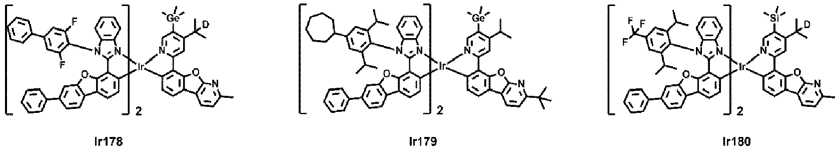

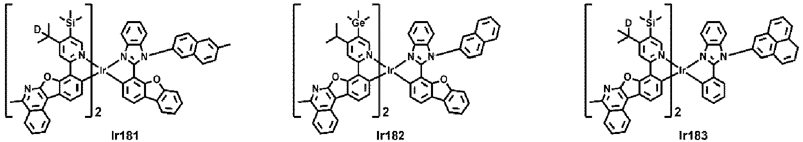

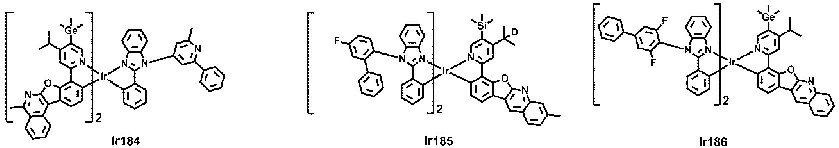

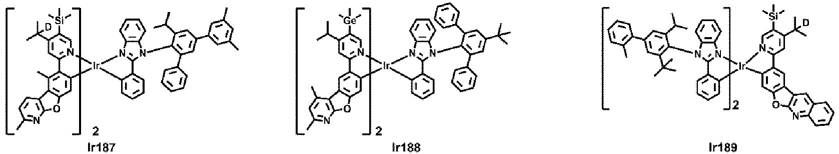

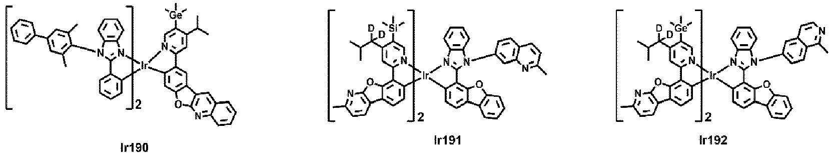

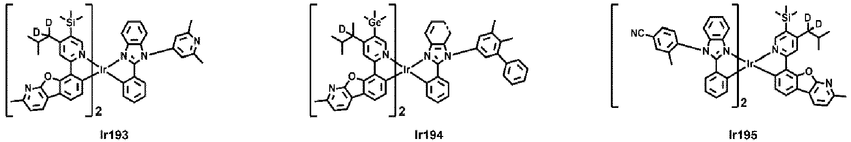

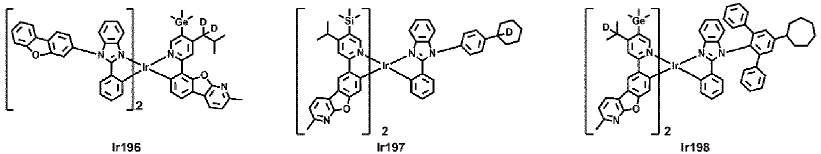

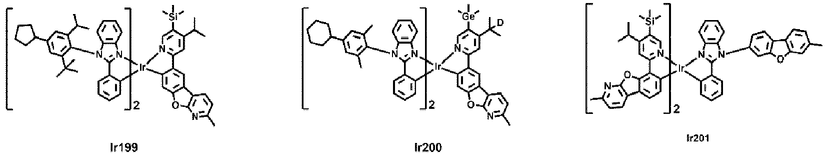

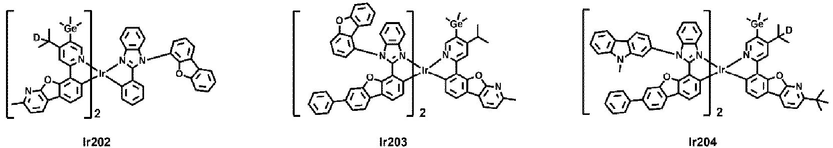

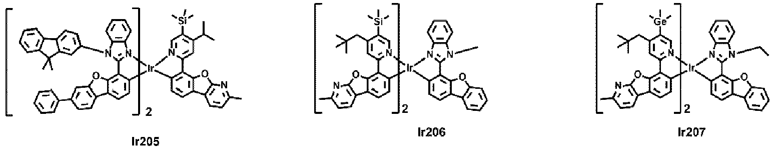

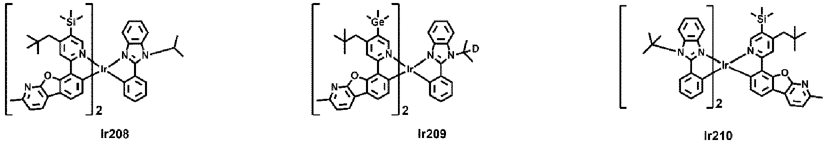

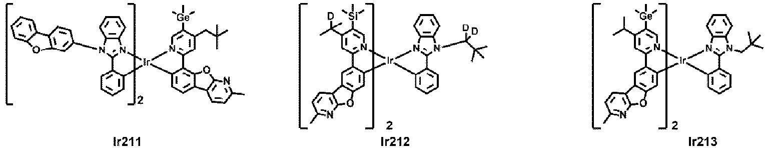

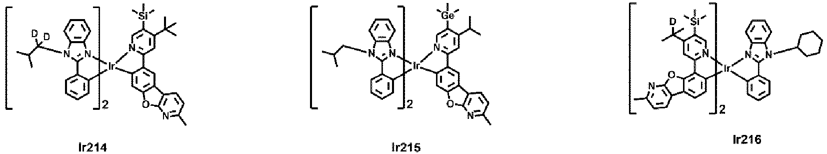

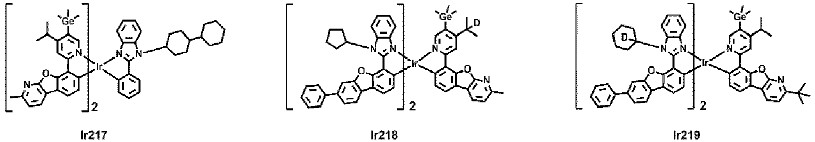

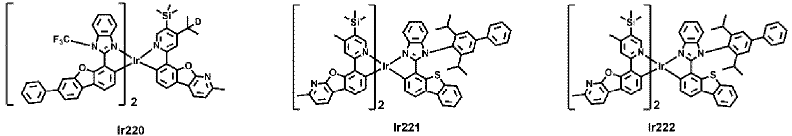

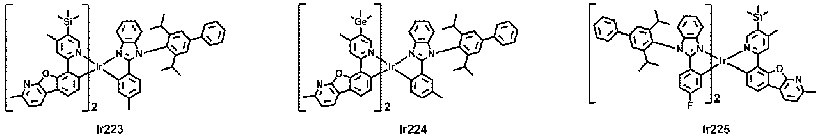

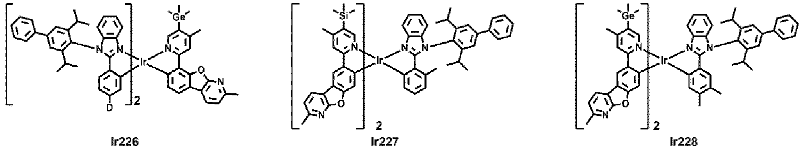

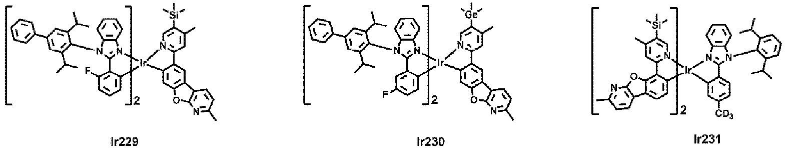

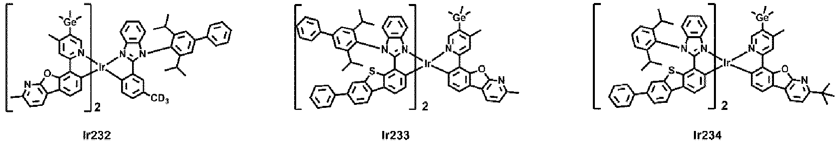

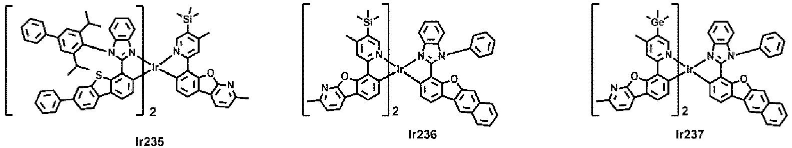

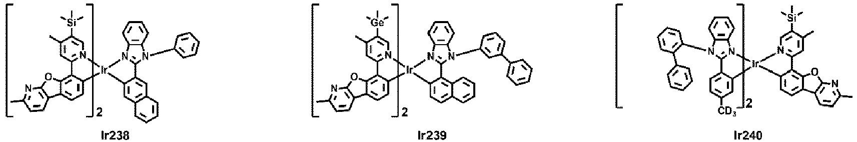

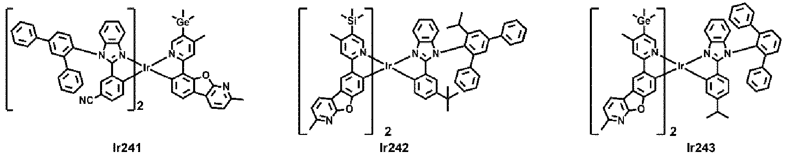

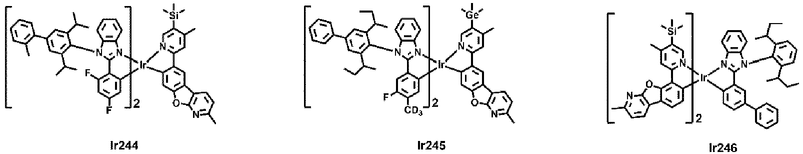

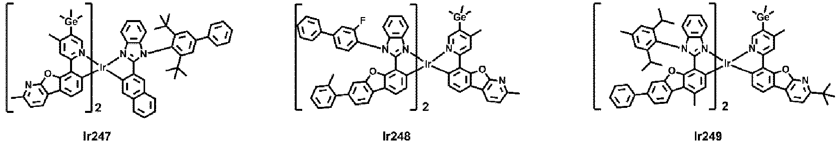

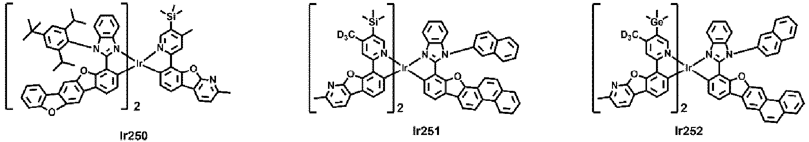

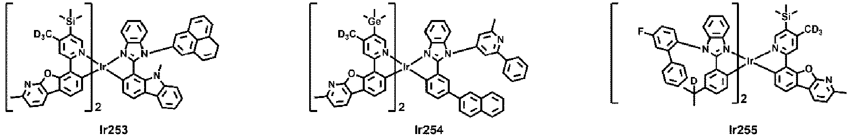

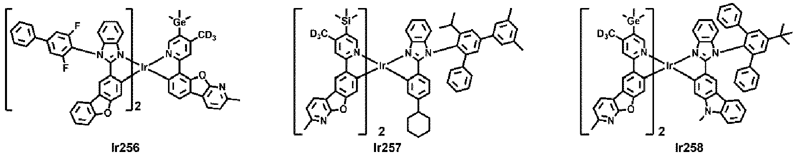

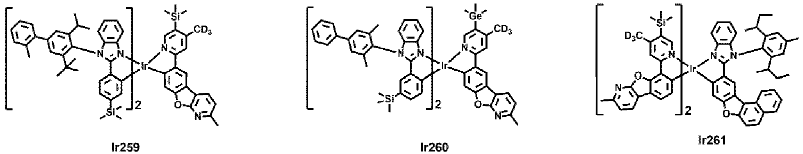

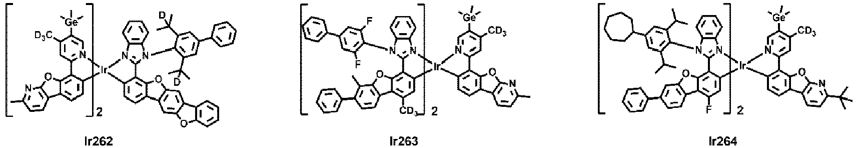

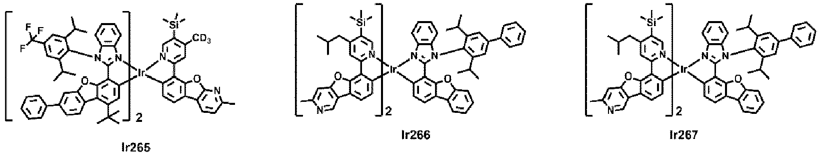

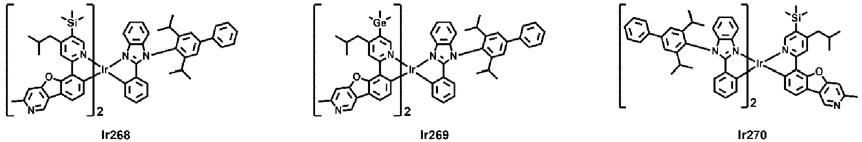

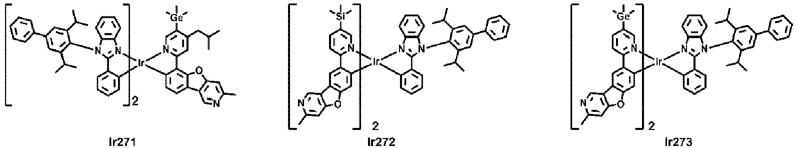

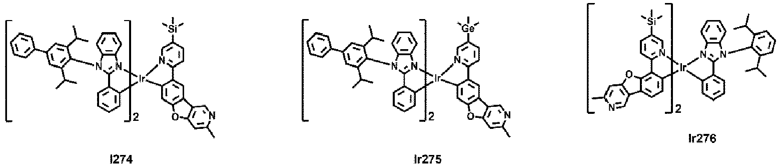

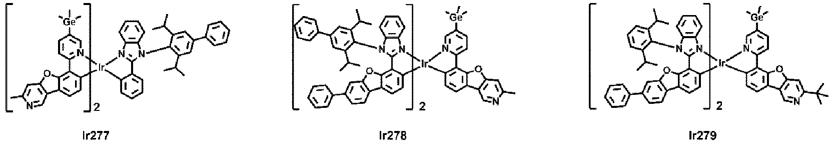

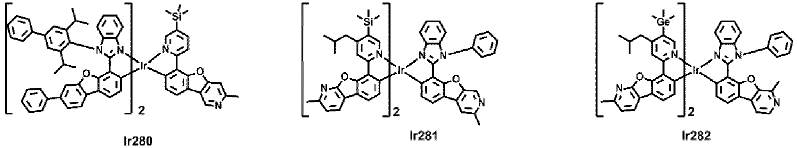

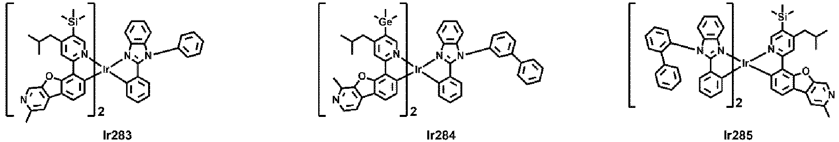

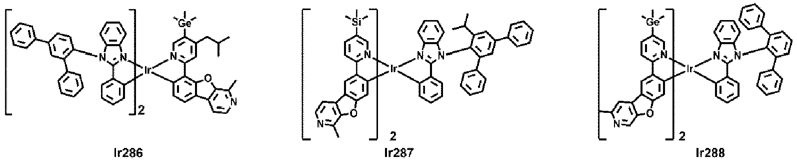

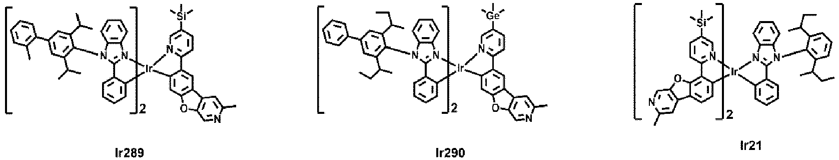

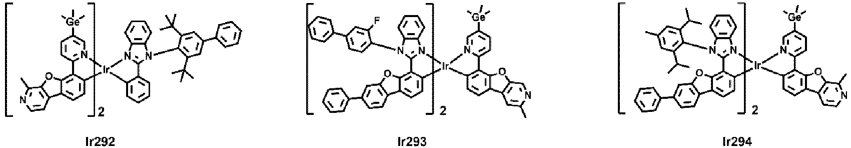

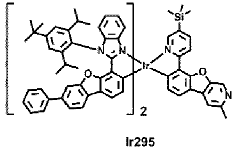

In one or more embodiments, the organometallic compound represented by Formula 1 may emit a red light or a green light, for example, a red light or a green light having a maximum emission wavelength (λₘₐₓ) of about 500 nanometers (nm) or greater, for example, about 500 nm to about 750 nm. In one or more embodiments, the organometallic compound may emit a green light. In one or more embodiments, the organometallic compound may emit a light (for example, a green light) having a maximum emission wavelength of about 515 nm to about 550 nm, or about 520 nm to about 540 nm.

In the organometallic compound represented by Formula 1, L₁ is a ligand represented by Formula 2-1, L₂ is a ligand represented by Formula 2-2, and n1 and n2, which are respectively the numbers of L₁ ligands and L₂ ligands, are each independently be 1 or 2. Accordingly, the organometallic compound represented by Formula 1 may have a high horizontal orientation ratio, and thus, an electronic device, for example, an organic light-emitting device, including at least one of the organometallic compounds may have an increased quantum efficiency. Also, the organometallic compound represented by Formula 1 is relatively easy to synthesize and may be efficiently synthesized with high purity.

A highest occupied molecular orbital (HOMO) energy level, a lowest unoccupied molecular orbital (LUMO) energy level, and a triplet (T₁) energy level of some compounds of the organometallic compound represented by Formula 1 were calculated using a density functional theory (DFT) method of the Gaussian 09 program with the molecular structure optimization at the B3LYP level, and results thereof are shown in Table 1. The energy levels are expressed in electron volts (eV).

**Table 1**

| Compound No. | HOMO (eV) | LUMO (eV) | T₁ (eV) |
|---|---|---|---|
| Ir11 | -5.5203 | -1.1684 | 2.3233 |
| Ir12 | -5.4719 | -1.6259 | 2.3504 |
| Ir13 | -5.4622 | -1.6994 | 2.3334 |
| Ir14 | -5.4488 | -1.6706 | 2.3354 |

Referring to Table 1, it was confirmed that the organometallic compound represented by Formula 1 had suitable electrical characteristics for use as a dopant in an electronic device, for example, an organic light-emitting device.

A method of synthesizing the organometallic compound represented by Formula 1 may be recognizable by one of ordinary skill in the art by referring to Synthesis Examples provided herein.

Therefore, the organometallic compound represented by Formula 1 may be suitable for use as a material for an organic layer of an organic light-emitting device, for example, as a dopant in an emission layer of the organic layer. Thus, according to one or more embodiments, also provided is an organic light-emitting device including a first electrode; a second electrode; and an organic layer arranged between the first electrode and the second electrode, wherein the organic layer includes an emission layer, and wherein the organic layer includes at least one organometallic compound represented by Formula 1.

The organic light-emitting device includes the organic layer including at least one organometallic compound represented by Formula 1, and thus, may have an improved external quantum efficiency and an improved lifespan.

The organometallic compound of Formula 1 may be used or arranged between a pair of electrodes of the organic light-emitting device. In one or more embodiments, the organometallic compound represented by Formula 1 may be included in the emission layer. In this regard, the organometallic compound may act as a dopant, and the emission layer may further include a host (that is, an amount of the at least one organometallic compound represented by Formula 1 in the emission layer is less than an amount of the host in the emission layer). In other words, in one or more embodiments, an amount of the host in the emission layer is greater than an amount of the at least one organometallic compound represented by Formula 1 in the emission layer.

The emission layer may emit a red light or a green light, for example, a red light or a green light having a maximum emission wavelength of 500 nm or greater, for example, about 500 nm to about 750 nm. In one or more embodiments, the organometallic compound may emit a green light. In one or more embodiments, the emission layer (or the organic light-emitting device) may emit a light (for example, a green light) having a maximum emission wavelength of about 515 nm to about 550 nm, or about 520 nm to about 540 nm.

The expression "(organic layer) includes at least one organometallic compound represented by Formula 1" as used herein may indicate that the (organic layer) may include one kind of organometallic compound represented by Formula 1 or two or more different kinds of organometallic compounds, each represented by Formula 1. In one or more embodiments, the organic layer may include, as the at least one organometallic compound, only Compound 1. In this regard, Compound 1 may be present in the emission layer of the organic light-emitting device. In one or more embodiments, the organic layer may include, as the at least one organometallic compound, Compounds 1 and 2. In this regard, Compound 1 and Compound 2 may be present in the same layer (for example, both Compound 1 and Compound 2 may be present in the emission layer), wherein Compound 1 and Compound 2 are not the same.

The first electrode may be an anode, which is a hole injection electrode, and the second electrode may be a cathode, which is an electron injection electrode. Alternatively, the first electrode may be a cathode, which is an electron injection electrode, and the second electrode may be an anode, which is a hole injection electrode.

In one or more embodiments, in the organic light-emitting device, the first electrode may be an anode, the second electrode may be a cathode, and the organic layer may further include a hole transport region arranged between the first electrode and the emission layer, and an electron transport region arranged between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers arranged between the first electrode and the second electrode of the organic light-emitting device. The "organic layer" may include not only organic compounds but also organometallic complexes including metals.

The FIGURE is a schematic cross-sectional view of an organic light-emitting device 10 according to one or more embodiments. Hereinafter, the structure and manufacturing method of the organic light-emitting device 10 according to one or more embodiments will be described in further detail with reference to the FIGURE, but embodiments are not limited thereto. The organic light-emitting device 10 may include a first electrode 11, an organic layer 15, and a second electrode 19, which are sequentially stacked in this stated order.

A substrate may be additionally located under the first electrode 11 or over the second electrode 19. For use as the substrate, any suitable substrate that is used in organic light-emitting devices, including those available in the art, may be used, and for example, a glass substrate or a transparent plastic substrate, each having excellent mechanical strength, thermal stability, transparency, surface smoothness, ease of handling, and/or water resistance, may be used.

The first electrode 11 may be, for example, formed by depositing or sputtering a material for forming the first electrode 11 on a surface of the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be, for example, an indium tin oxide (ITO), an indium zinc oxide (IZO), a tin oxide (SnO₂), or a zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. In one or more embodiments, the first electrode 11 may have a three-layered structure of ITO/Ag/ITO.

The organic layer 15 may be arranged on the first electrode 11.

The organic layer 15 may include the hole transport region, the emission layer, and the electron transport region.

The hole transport region may be arranged between the first electrode 11 and the emission layer.

The hole transport region may include a hole injection layer, a hole transport layer, an electron blocking layer, a buffer layer, or a combination thereof.

The hole transport region may include only a hole injection layer or only a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, such as vacuum deposition, spin coating, casting, and/or Langmuir-Blodgett (LB) deposition.

When the hole injection layer is formed by vacuum deposition, the deposition conditions may vary depending on a material that is used to form the hole injection layer, and the structure and thermal characteristics of the hole injection layer. For example, the deposition conditions may include a deposition temperature in a range of about 100°C to about 500°C, a vacuum pressure in a range of about 1.3 x 10⁻⁶ Pa (10⁻⁸ torr) to about 0.13 Pa (10⁻³ torr), and a deposition rate in a range of about 0.01 angstroms per second (Å/sec) to about 100 Å/sec.

When the hole injection layer is formed by spin coating, the coating conditions may vary depending on a material that is used to form the hole injection layer, and the structure and thermal characteristics of the hole injection layer. For example, the coating conditions may include a coating speed in a range of about 2,000 revolutions per minute (rpm) to about 5,000 rpm and a heat treatment temperature of about 80°C to about 200°C for removing a solvent after coating.

Conditions for forming the hole transport layer and the electron blocking layer may respectively be similar to or the same as the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto: 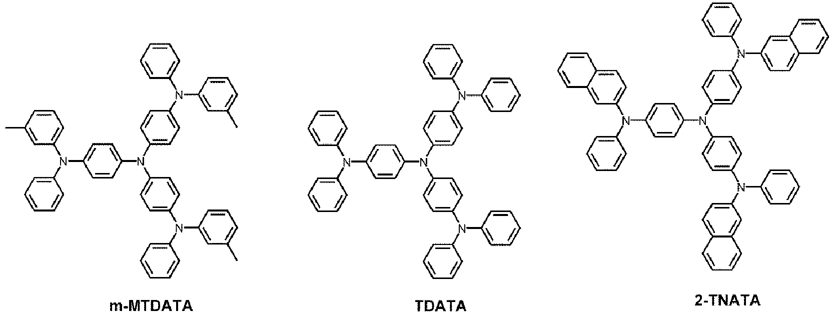 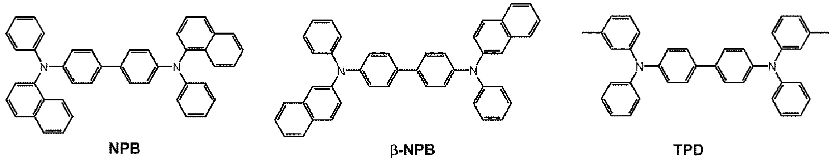 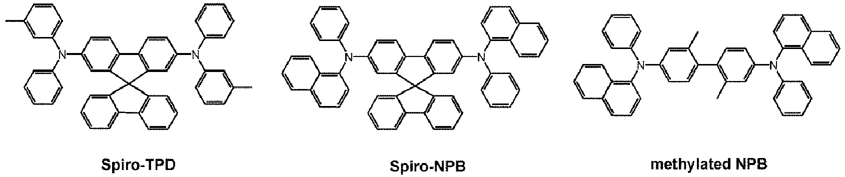 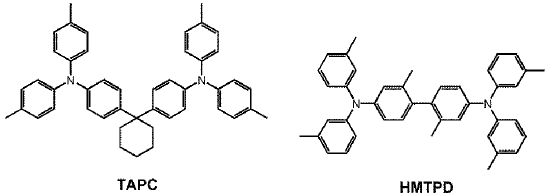 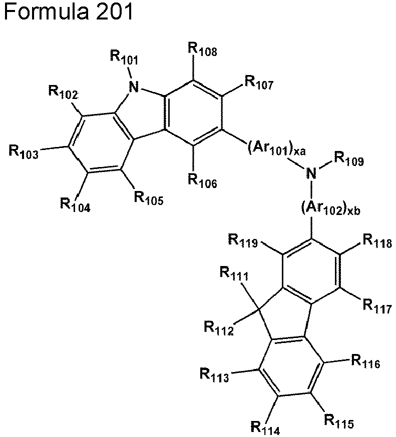 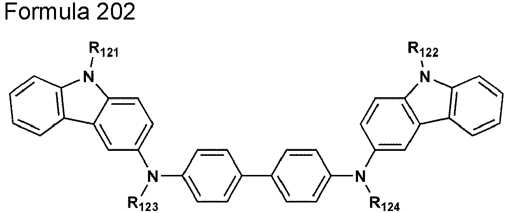 wherein, in Formula 201, Ar₁₀₁ and Ar₁₀₂ may each independently be a benzene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic, or a combination thereof.

xa and xb in Formula 201 may each independently be an integer from 0 to 5, or may each independently be 0, 1, or 2. In one or more embodiments, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, or a hexyl group), a C₁-C₁₀ alkoxy group (for example, a methoxy group, an ethoxy group, a propoxy group, a butoxy group, or a pentoxy group), or a C₁-C₁₀ alkylthio group;
a C₁-C₁₀ alkyl group, a C₁-C₁₀ alkoxy group, or a C₁-C₁₀ alkylthio group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A: 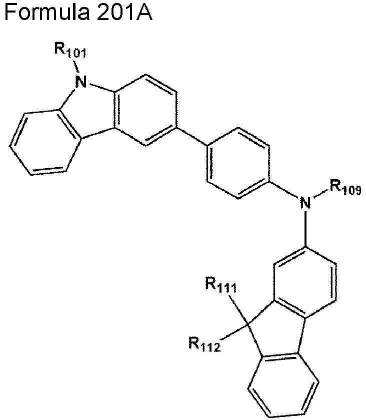 wherein, in Formula 201A, R₁₀₁, R₁₁₁, R₁₁₂, and R₁₀₉ may each independently be as described herein.

In one or more embodiments, the compound represented by Formula 201 and the compound represented by Formula 202 may include at least one of Compounds HT1 to HT20, but embodiments are not limited thereto:

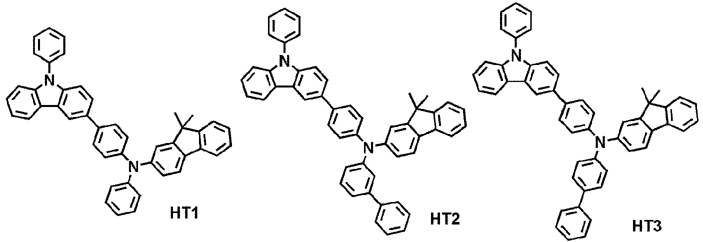

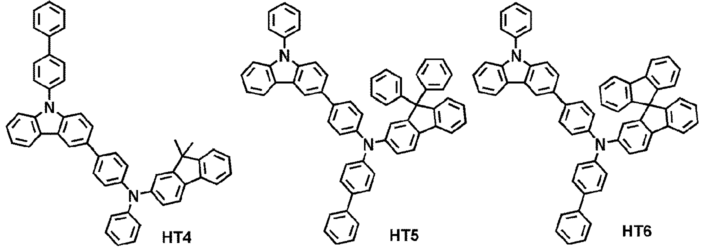

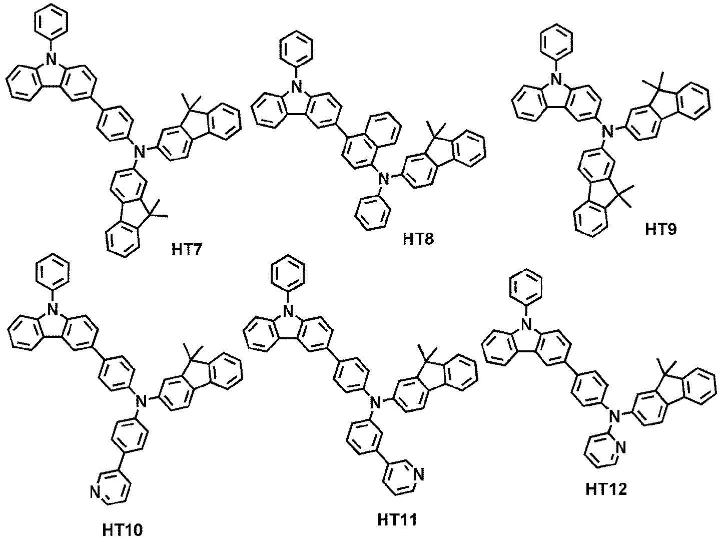

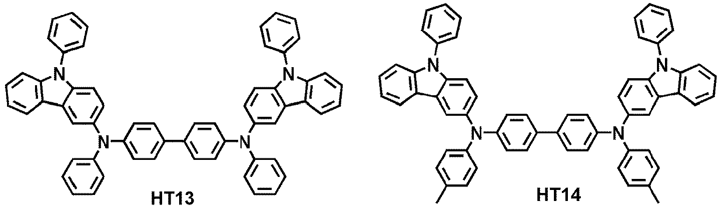

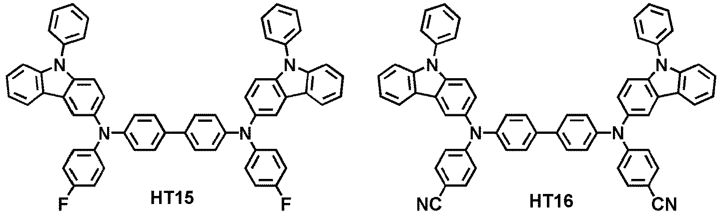

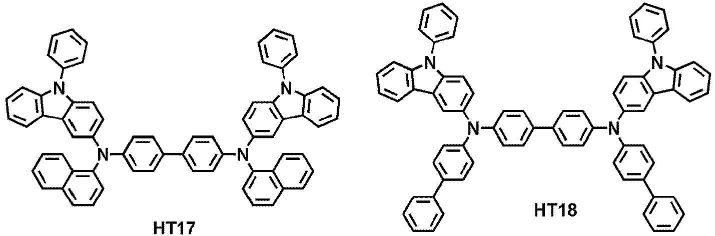

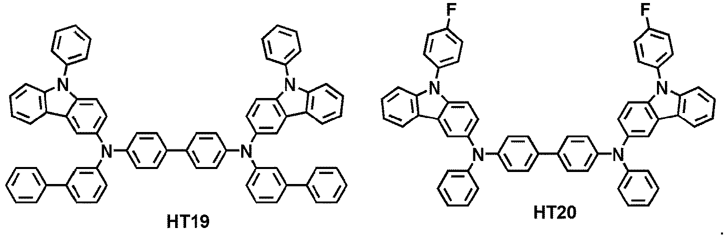

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. Without wishing to be bound to theory, when the thicknesses of the hole transport region, the hole injection layer, and/or the hole transport layer are within any of these ranges, excellent hole transport characteristics may be obtained without a substantial increase in driving voltage.

The hole transport region may further include, in addition to the materials as described herein, a charge-generation material for improving conductive properties. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound. In one or more embodiments, examples of the p-dopant may include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide such as a tungsten oxide, a molybdenum oxide, or the like; or a cyano group-containing compound such as Compound HT-D1, or the like, but embodiments are not limited thereto.

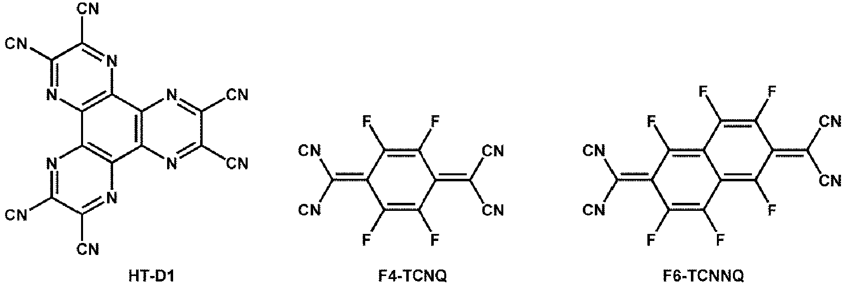

The hole transport region may further include a buffer layer.

The buffer layer may compensate for an optical resonance distance according to a wavelength of light emitted from the emission layer, and thus, efficiency may be improved.

When the hole transport region includes an electron blocking layer, a material for forming the electron blocking layer may include a material that is used in the hole transport region as described herein, a host material described herein, or a combination thereof. In one or more embodiments, when the hole transport region includes an electron blocking layer, a material for forming the electron blocking layer may include mCP or H-H1, which are described herein.

The emission layer may be formed on the hole transport region by using one or more suitable methods, such as vacuum deposition, spin coating, casting, and/or LB deposition. When the emission layer is formed by vacuum deposition or spin coating, although the deposition or coating conditions may vary according to a material that is used to form the emission layer, the deposition or coating conditions may be similar to those used in forming the hole injection layer.

The emission layer may include a host and a dopant, and the dopant may include at least one organometallic compound represented by Formula 1.

The host may include 1,3,5-tri(1-phenyl-1H-benzo[d]imidazol-2-yl)benznen (TPBi), 3-tert-butyl-9,10-di(naphth-2-yl)anthracene (TBADN), 9,10-di(naphthalen-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TCP), 1,3-bis(N-carbazolyl)benzene (mCP), Compound H50, Compound H51, Compound H52, Compound H-H1, Compound H-E43, or a combination thereof, but embodiments are not limited thereto:

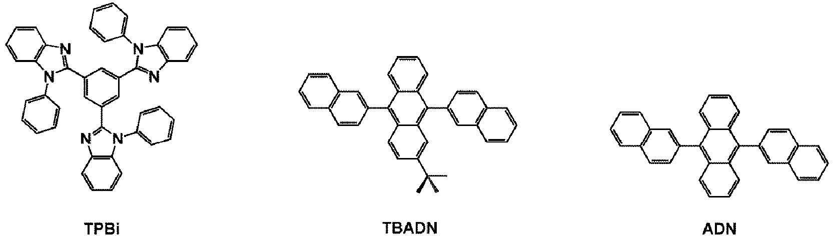

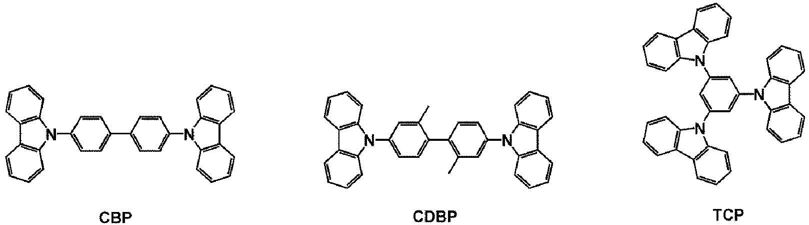

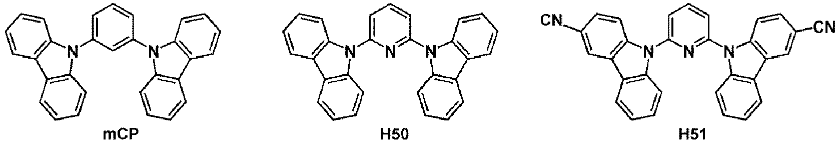

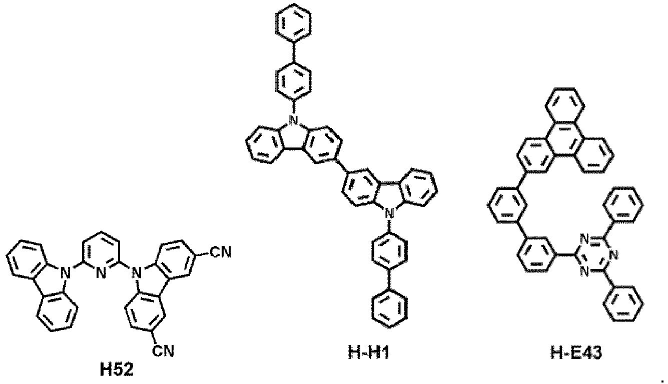

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light, and various modifications are possible.

When the emission layer includes both a host and a dopant, an amount (for example, weight) of the dopant in the emission layer may be about 0.01 parts by weight to about 15 parts by weight, based on 100 parts by weight of the emission layer.

A thickness of the emission layer may be about 100 Å to about 1,000 Å, for example, about 200 Å to about 600 Å. Without wishing to be bound to theory, when the thickness of the emission layer is within the range, excellent light-emission characteristics may be obtained without a substantial increase in driving voltage.

Next, the electron transport region may be arranged on the emission layer.

The electron transport region may include a hole blocking layer, an electron transport layer, an electron injection layer, or a combination thereof.

In one or more embodiments, the electron transport region may have a hole blocking layer/electron transport layer/electron injection layer structure or an electron transport layer/electron injection layer structure. The electron transport layer may have a single-layered structure or a multi-layered structure including two or more different materials.

The conditions for forming a hole blocking layer, an electron transport layer, and an electron injection layer of the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof, but embodiments are not limited thereto.

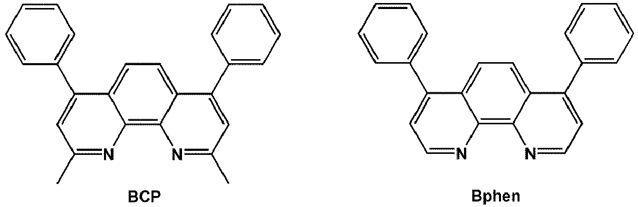

A thickness of the hole blocking layer may be about 20 Å to about 1,000 Å, for example, about 30 Å to about 300 Å. Without wishing to be bound to theory, when the thickness of the hole blocking layer is within this range, excellent hole blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto.

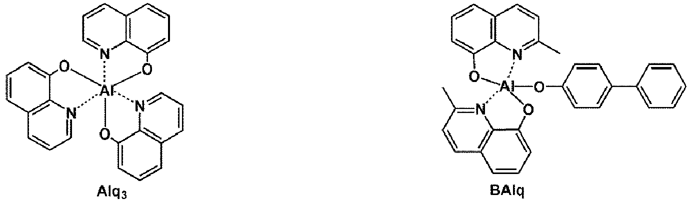

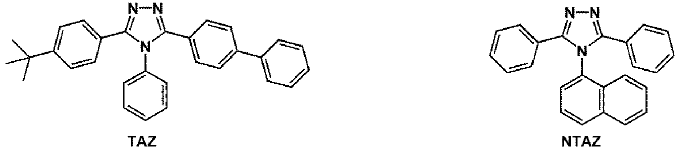

In one or more embodiments, the electron transport layer may include one of Compounds ET1 to ET25, or a combination thereof, but embodiments are not limited thereto.

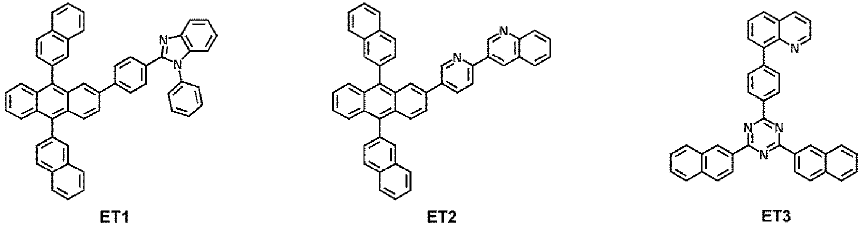

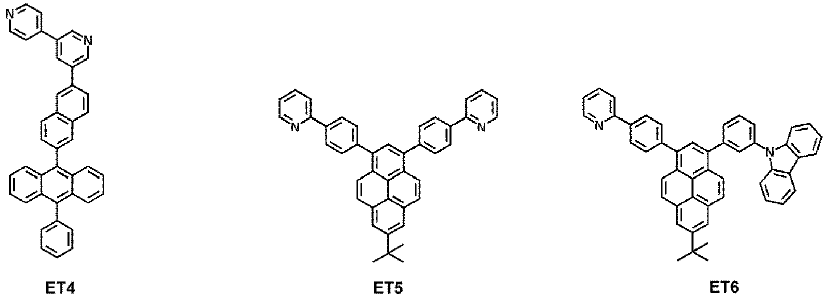

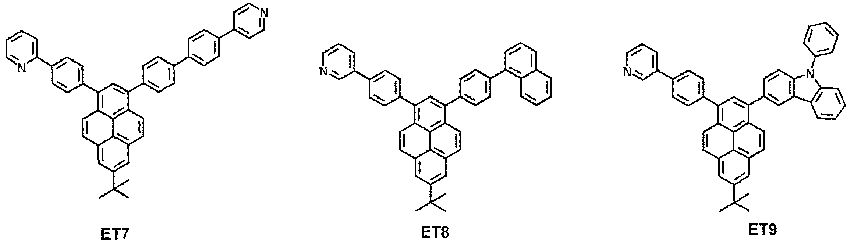

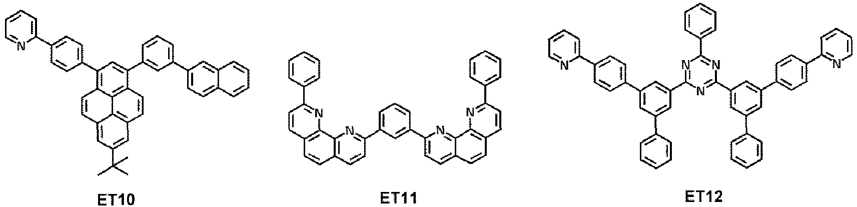

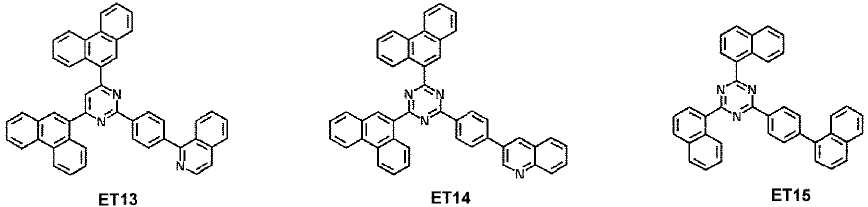

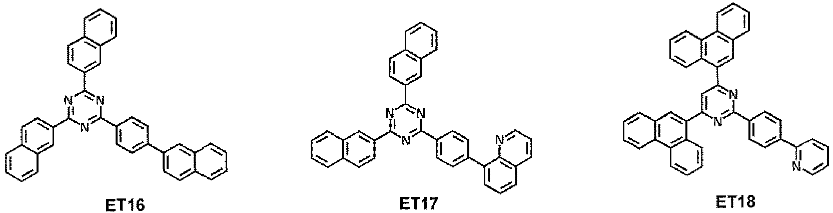

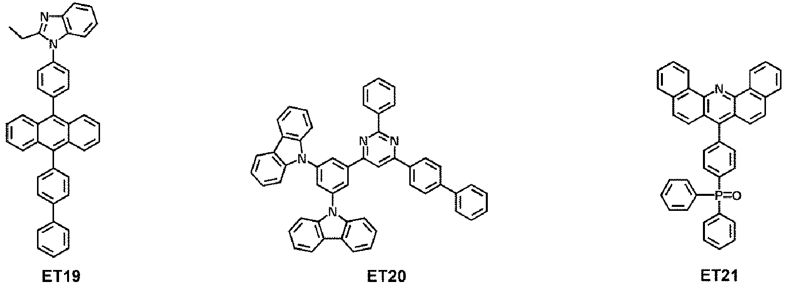

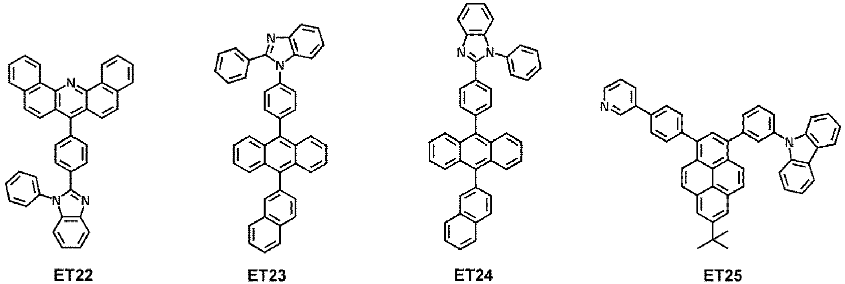

A thickness of the electron transport layer may be about 100 Å to about 1,000 Å, for example, about 150 Å to about 500 Å. Without wishing to be bound to theory, when the thickness of the electron transport layer is within these ranges, excellent electron transport characteristics may be obtained without a substantial increase in driving voltage.

The electron transport layer may include, in addition to the materials described above, a metal-containing material.

The metal-containing material may include a Li complex. The Li complex may include, for example, at least one of Compounds ET-D1 (LiQ) or ET-D2, but embodiments are not limited thereto.

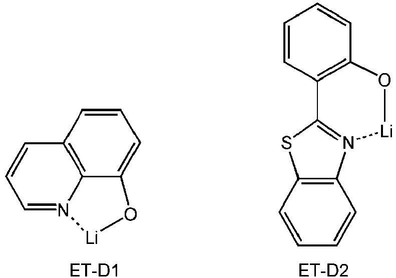

The electron transport region may include an electron injection layer that facilitates electron injection from the second electrode 19.

The electron injection layer may include at least one of LiF, NaCl, CsF, Li₂O, BaO, or a combination thereof, but embodiments are not limited thereto.

A thickness of the electron injection layer may be about 1 Å to about 100 Å, for example, about 3 Å to about 90 Å. Without wishing to be bound to theory, when the thickness of the electron injection layer is within the range described above, satisfactory electron injection characteristics may be obtained without a substantial increase in driving voltage.

The second electrode 19 may be located on or arranged on the organic layer 15. The second electrode 19 may be a cathode. A material for forming the second electrode 19 may be a metal, an alloy, an electrically conductive compound, or a combination thereof, which have a relatively low work function. Examples of the material for forming the second electrode 19 may include lithium (Li), silver (Ag), magnesium (Mg), aluminum (Al), aluminum-lithium (Al-Li), calcium (Ca), magnesium-indium (Mg-In), and magnesium-silver (Mg-Ag). In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments are not limited thereto.

According to one or more embodiments, an electronic apparatus may include the organic light-emitting device. Therefore, also provided is an electronic apparatus including the organic light-emitting device. The electronic apparatus may include, for example, a display, lighting, a sensor, or the like, but embodiments are not limited thereto.

According to one or more embodiments, also provided is a diagnostic composition including at least one organometallic compound represented by Formula 1.

Since the organometallic compound represented by Formula 1 provides a high luminescence efficiency, the diagnostic composition including the organometallic compound may have a high diagnostic efficiency.

The diagnostic composition may be used in various applications including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or the like, each unsubstituted or substituted with at least one of a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof. In one or more embodiments, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group). Non-limiting examples thereof may include a methoxy group, an ethoxy group, a propoxy group, a butoxy group, a pentoxy group, or the like.

The term "C₁-C₆₀ alkylthio group" as used herein refers to a monovalent group represented by -SA₁₀₂ (wherein A₁₀₂ is the C₁-C₆₀ alkyl group).

The term "C₂-C₆₀ alkenyl group" as used herein has a structure including at least one carbon-carbon double bond in the middle or at the terminus of the C₂-C₆₀ alkyl group. Non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group. Non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Non-limiting examples of the C₃-C₁₀ cycloalkyl group include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

The term "C₁-C₁₀ heterocycloalkyl group" as used herein refers to a monovalent cyclic group that includes at least one heteroatom selected from N, O, P, Si, S, Se, Ge, and B as a ring-forming atom, and 1 to 10 carbon atoms, and the term "C₁-C₁₀ heterocycloalkylene group" refers to a divalent group having the same structure as the C₁-C₁₀ heterocycloalkyl group.

Non-limiting examples of the C₁-C₁₀ heterocycloalkyl group include a silolanyl group, a silinanyl group, a tetrahydrofuranyl group, a tetrahydro-2H-pyranyl group, a tetrahydrothiophenyl group, or the like.

The term "C₃-C₁₀ cycloalkenyl group" as used herein refers to a monovalent cyclic group that has 3 to 10 carbon atoms and at least one carbon-carbon double bond in its ring, and is not aromatic. Non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has at least one heteroatom selected from N, O, P, Si, S, Se, Ge, and B as a ring-forming atom, 1 to 10 carbon atoms, and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group that includes a carbocyclic aromatic ring system having 6 to 60 carbon atoms, and the term "C₆-C₆₀ arylene group" as used herein refers to a divalent group that includes a carbocyclic aromatic ring system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include at least two rings, the at least two rings may be fused to each other.

The term "C₇-C₆₀ alkyl aryl group" as used herein refers to a C₆-C₆₀ aryl group that is substituted with at least one C₁-C₆₀ alkyl group. The term "C₇-C₆₀ aryl alkyl group" as used herein refers to a C₁-C₆₀ alkyl group that is substituted with at least one C₆-C₆₀ aryl group.

The term "C₁-C₆₀ heteroaryl group" as used herein refers to a monovalent group that includes a cyclic aromatic system having at least one heteroatom selected from N, O, P, Si, S, Se, Ge, and B as a ring-forming atom, and 1 to 60 carbon atoms. The term "C₁-C₆₀ heteroarylene group" as used herein refers to a divalent group that includes a cyclic aromatic system having at least one heteroatom selected from N, O, P, Si, S, Se, Ge, and B as a ring-forming atom, and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include at least two rings, the at least two rings may be fused to each other.

The term "C₂-C₆₀ alkyl heteroaryl group" as used herein refers to a C₁-C₆₀ heteroaryl group that is substituted with at least one C₁-C₆₀ alkyl group. The term "C₂-C₆₀ heteroaryl alkyl group" as used herein refers to a C₁-C₆₀ alkyl group that is substituted with at least one C₁-C₆₀ aryl group.

The term "C₆-C₆₀ aryloxy group" as used herein indicates -OA₁₀₄ (wherein A₁₀₄ is the C₆-C₆₀ aryl group), and the term "C₆-C₆₀ arylthio group" as used herein indicates -SA₁₀₅ (wherein A₁₀₅ is the C₆-C₆₀ aryl group).

The term "C₁-C₆₀ heteroaryloxy group" as used herein indicates -OA₁₀₆ (wherein A₁₀₆ is the C₁-C₆₀ heteroaryl group), and the term "C₁-C₆₀ heteroarylthio group" as used herein indicates -SA₁₀₇ (wherein A₁₀₇ is the C₁-C₆₀ heteroaryl group).

The term "monovalent non-aromatic condensed polycyclic group" as used herein refers to a monovalent group having two or more rings condensed with each other, only carbon atoms (for example, 8 to 60 carbon atoms) as ring-forming atoms, and no aromaticity in its molecular structure. Non-limiting examples of the monovalent non-aromatic condensed polycyclic group include a fluorenyl group or the like. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group having two or more rings condensed with each other, at least one heteroatom selected from N, O, P, Si, S, Se, Ge, and B, other than carbon atoms (for example, having 1 to 60 carbon atoms) as ring-forming atoms, and no aromaticity in its molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. The "C₅-C₃₀ carbocyclic group (that is unsubstituted or substituted with at least one R₁₀ₐ)" as used herein may include, for example, an adamantane group, a norbornene group, a bicyclo[1.1.1]pentane group, a bicyclo[2.1.1]hexane group, a bicyclo[2.2.1]heptane group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group, or the like (each unsubstituted or substituted with at least one R₁₀ₐ).

The term "C₁-C₃₀ heterocyclic group" as used herein refers to a saturated or unsaturated cyclic group having at least one heteroatom selected from N, O, P, Si, S, Se, Ge, and B, other than 1 to 30 carbon atoms, as ring-forming atoms. The C₁-C₃₀ heterocyclic group may be a monocyclic group or a polycyclic group. The "C₁-C₃₀ heterocyclic group (that is unsubstituted or substituted with at least one R₁₀ₐ)" may include, for example, a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

In one or more embodiments, examples of the "C₅-C₃₀ carbocyclic group" and the "C₁-C₃₀ heterocyclic group" include i) a first ring, ii) a second ring, iii) a condensed ring system in which two or more first rings are condensed with each other, iv) a condensed ring system in which two or more second rings are condensed with each other, or v) a condensed ring system in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group" (or, a fluorinated C₁-C₂₀ alkyl group or the like), "fluorinated C₃-C₁₀ cycloalkyl group", "fluorinated C₁-C₁₀ heterocycloalkyl group," and "fluorinated phenyl group" as used herein respectively refer to a C₁-C₆₀ alkyl group (or, a C₁-C₂₀ alkyl group or the like), a C₃-C₁₀ cycloalkyl group, a C₁-C₁₀ heterocycloalkyl group, and a phenyl group, each substituted with at least one fluoro group. In one or more embodiments, the term "fluorinated C₁ alkyl group" (that is, a fluorinated methyl group) includes -CF₃, -CF₂H, and -CFH₂. The "fluorinated C₁-C₆₀ alkyl group" (or, a fluorinated C₁-C₂₀ alkyl group or the like), the "fluorinated C₃-C₁₀ cycloalkyl group", the "fluorinated C₁-C₁₀ heterocycloalkyl group", or the "fluorinated phenyl group" may be i) a fully fluorinated C₁-C₆₀ alkyl group (or, a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein, in each group, all hydrogen atoms included therein are substituted with a fluoro group, or ii) a partially fluorinated C₁-C₆₀ alkyl group (or, a partially fluorinated C₁-C₂₀ alkyl group or the like), a partially fluorinated C₃-C₁₀ cycloalkyl group, a partially fluorinated C₁-C₁₀ heterocycloalkyl group, or a partially fluorinated phenyl group, wherein, in each group, at least one but not all of the hydrogen atoms included therein are substituted with a fluoro group.

The terms "deuterated C₁-C₆₀ alkyl group" (or, a deuterated C₁-C₂₀ alkyl group or the like), "deuterated C₃-C₁₀ cycloalkyl group", "deuterated C₁-C₁₀ heterocycloalkyl group," and "deuterated phenyl group" as used herein respectively refer to a C₁-C₆₀ alkyl group (or, a C₁-C₂₀ alkyl group or the like), a C₃-C₁₀ cycloalkyl group, a C₁-C₁₀ heterocycloalkyl group, and a phenyl group, each substituted with at least one deuterium atom. In one or more embodiments, the "deuterated C₁ alkyl group" (that is, a deuterated methyl group) may include -CD₃, -CD₂H, and -CDH₂, and non-limiting examples of the "deuterated C₃-C₁₀ cycloalkyl group" include Formula 10-501 or the like. The "deuterated C₁-C₆₀ alkyl group" (or, the deuterated C₁-C₂₀ alkyl group or the like), the "deuterated C₃-C₁₀ cycloalkyl group", the "deuterated C₁-C₁₀ heterocycloalkyl group", or the "deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen atoms included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, at least one hydrogen atom but not all hydrogen atoms included therein are substituted with a deuterium atom.

The term "(C₁-C₂₀ alkyl)'X' group" as used herein refers to a 'X' group that is substituted with at least one C₁-C₂₀ alkyl group. In one or more embodiments, the term "(C₁-C₂₀ alkyl)C₃-C₁₀ cycloalkyl group" as used herein refers to a C₃-C₁₀ cycloalkyl group that is substituted with at least one C₁-C₂₀ alkyl group, and the term "(C₁-C₂₀ alkyl)phenyl group" as used herein refers to a phenyl group that is substituted with at least one C₁-C₂₀ alkyl group. Non-limiting examples of the (C₁ alkyl)phenyl group include a toluyl group or the like.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" as used herein respectively refer to hetero rings having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group", in which, in each group, at least one ring-forming carbon atom thereof is substituted with N.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof.

Q₁ to Q₉, Q₁₁ to Q₁₉, Q₂₁ to Q₂₉, and Q₃₁ to Q₃₉ as used herein may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, Q₁ to Q₉, Q₁₁ to Q₁₉, Q₂₁ to Q₂₉, and Q₃₁ to Q₃₉ as used herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₂₀ alkyl group, a phenyl group, or a combination thereof.

Hereinafter, compounds and organic light-emitting devices according to one or more embodiments will be described in further detail with reference to Synthesis Examples and Examples, but embodiments are not limited thereto. The wording "B was used instead of A" used in describing Synthesis Examples means that an amount of B used was identical to an amount of A used based on molar equivalence.

### EXAMPLES

### Synthesis Example 1 (Compound Ir1)

### Synthesis of Compound Ir1-C

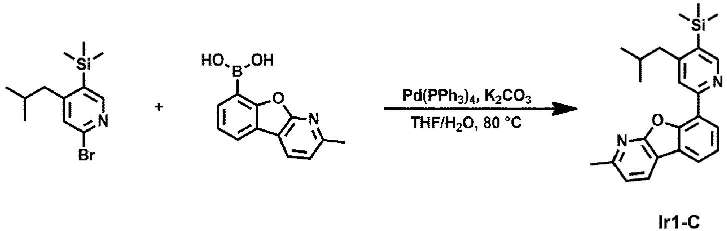

2-bromo-4-isobutyl-5-(trimethylsilyl)pyridine (5.00 grams (g), 17.54 millimoles (mmol)), (2-methylbenzofuro[2,3-b]pyridin-8-yl)boronic acid (3.98 g, 17.54 mmol), tetrakis(triphenylphosphine)palladium(0) (Pd(PPh₃)₄) (1.01 g, 0.88 mmol), and K₂CO₃ (7.27 g, 52.62 mmol) were mixed with 90 milliliters (mL) of tetrahydrofuran (THF) and 30 mL of deionized (DI) water, and then stirred while heating at reflux for 18 hours. The temperature was then allowed to lower to room temperature and methylene chloride (MC) was used to extract an organic layer from the reaction mixture. The organic layer was separated and dried with anhydrous magnesium sulfate (MgSO₄), filtered to remove the solids, and the solvent was removed under a reduced pressure. The residue was purified by column chromatography using ethyl acetate (EA):hexane (1:4, v/v) a eluents to obtain 5.50 g (81%) of Compound Ir1-C.

### Synthesis of Compound Ir1-B

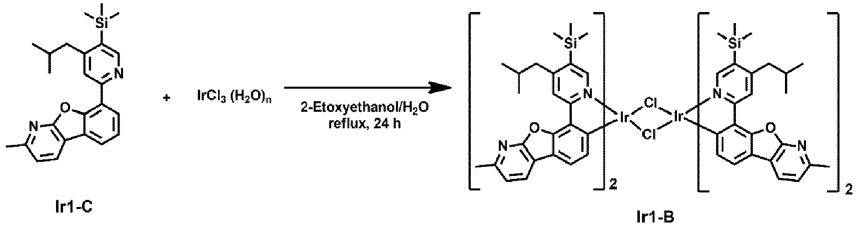

Compound Ir1-C (5.5 g, 14.15 mmol) and iridium chloride trihydrate (IrCl₃(H₂O), n=3) (2.50 g, 7.08 mmol) were mixed with 90 mL of 2-ethoxyethanol and 30 mL of DI water, and then stirred while heating at reflux for 24 hours. The temperature was then allowed to lower to room temperature. A solid thus produced was separated by filtration, washed sufficiently with water, methanol, and hexane, in this stated order, and then dried in a vacuum oven to obtain 5.61 g (44%) of Compound Ir1-B.

### Synthesis of Compound Ir1-A

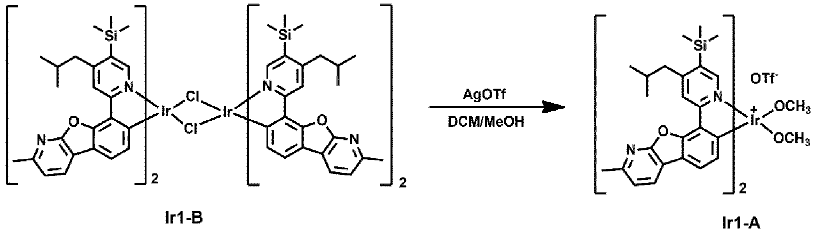

Compound Ir1-B (5.61 g, 2.80 mmol) was mixed with 90 mL of MC, and a separate mixture of silver trifluoromethanesulfonate (AgOTf) (6.86 g, 5.89 mmol) dissolved in 30 mL of methanol (MeOH) was added thereto. Afterwards, the reaction mixture was stirred for 18 hours at room temperature while light was blocked by an aluminum foil, followed by filtration through a Celite plug to remove a resultant solid from the reaction. A solid (Compound Ir1-A) was obtained by removing the solvents under reduced pressure from a filtrate and was used in the next reaction step without an additional purification process.

### Synthesis of Compound L1

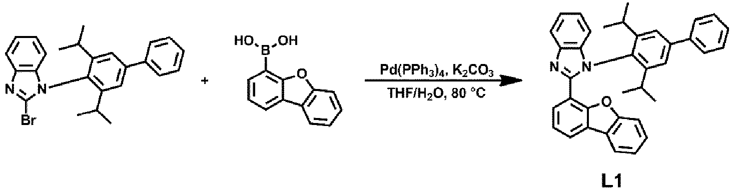

2-bromo-1-(3,5-diisopropyl-[1,1'-biphenyl]-4-yl)-1H-benzo[d]imidazole (5.00 g, 11.54 mmol), dibenzo[b,d]furan-4-ylboronic acid (2.47 g, 11.54 mmol), Pd(PPh₃)₄ (0.67 g, 0.58 mmol), and K₂CO₃ (4.78 g, 34.61 mmol) were mixed with 90 mL of THF and 30 mL of DI water, and then stirred and heated at reflux for 18 hours. The temperature was then allowed to lower to room temperature, MC was used to extract an organic layer, and the organic layer was dried with anhydrous MgSO₄. Following filtration, the solvent was removed under a reduced pressure to provide a residue that was purified by column chromatography using EA:hexane (1:2 v/v) as eluents to obtain 4.65 g (73%) of Compound L1.

### Synthesis of Compound Ir1

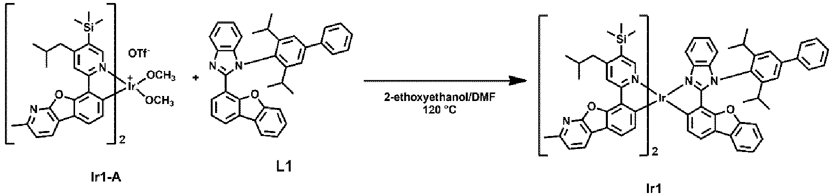

Compound Ir1-A (4.00 g, 3.43 mmol) and Compound L1 (1.79 g, 3.43 mmol) were mixed with 50 mL of 2-ethoxyethanol and 50 mL of N,N-dimethylformamide (DMF), and then stirred while heating at reflux at 120°C for 48 hours, and then the temperature was allowed to lower to room temperature. The solvents were removed under a reduced pressure and the product was purified by column chromatography using EA:hexane (1:8 v/v) as eluents to obtain 0.87 g (17%) of Compound Ir1. The product was identified by high resolution mass spectrometry using matrix assisted laser desorption ionization (HRMS (MALDI)) and high-performance liquid chromatography (HPLC) analysis. HRMS (MALDI) calculated for C₈₈H₈₈IrN₈O₃Si₂: m/z: 1486.5851 grams per mole (g/mol), found: 1486.5847 g/mol.

### Synthesis Example 2 (Compound Ir2)

### Synthesis of Compound Ir2-C

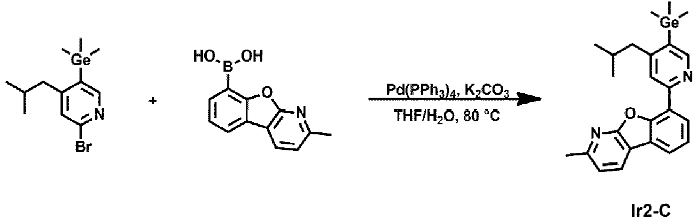

2-bromo-4-isobutyl-5-(trimethylgermyl)pyridine (5.00 g, 15.11 mmol), (2-methylbenzofuro[2,3-b]pyridin-8-yl)boronic acid (3.43 g, 15.11 mmol), Pd(PPh₃)₄ (0.87 g, 0.76 mmol), and K₂CO₃ (6.27 g, 45.34 mmol) were mixed with 90 mL of THF and 30 mL of DI water, and then stirred while heating at reflux for 18 hours. The temperature was then allowed to lower to room temperature, MC was used to extract an organic layer, and the organic layer was dried with anhydrous MgSO₄. The solvent was removed under a reduced pressure and the residue obtained was purified by column chromatography using EA:hexane (1:4 v/v) as eluents to obtain 4.31 g (66%) of Compound Ir2-C.

### Synthesis of Compound Ir2-B

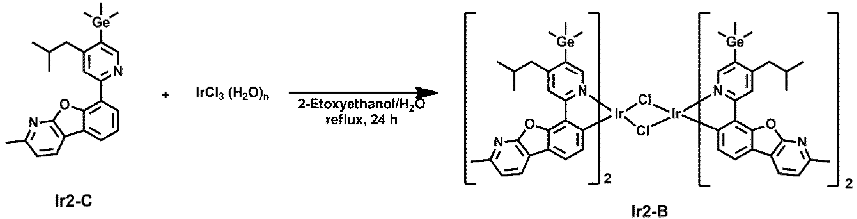

4.08 g (75%) of Compound Ir2-B was obtained in a similar manner as the synthesis of Compound Ir1-B of Synthesis Example 1, except that Compound Ir2-C (4.31 g, 9.95 mmol) was used instead of Compound Ir1-C, and an amount of iridium chloride trihydrate that was used was changed to 1.75 g (4.98 mmol).

### Synthesis of Compound Ir2-A

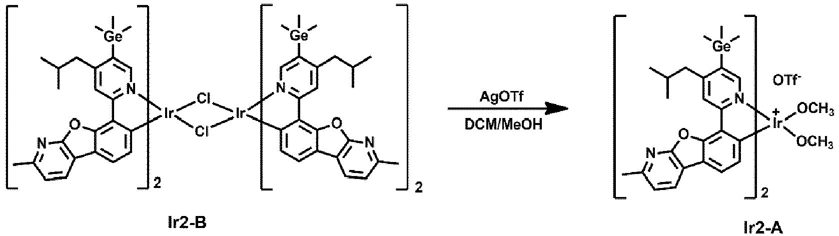

Compound Ir2-A was synthesized in a similar manner as the synthesis of Compound Ir1-A of Synthesis Example 1, except that Compound Ir2-B (4.08 g, 1.87 mmol) was used instead of Compound Ir1-B, and an amount of AgOTf that was used was changed to 1.01 g (3.92 mmol). Then, Compound Ir2-A was used in the next reaction step without an additional purification process.

### Synthesis of Compound Ir2

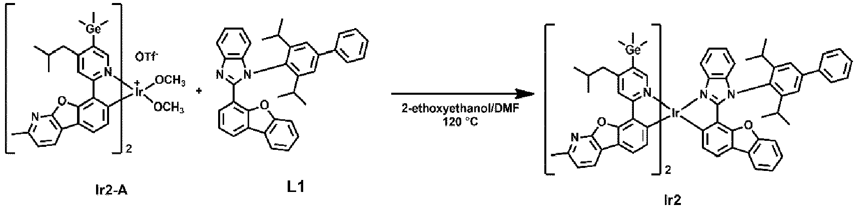

0.60 g (16%) of Compound Ir2 was obtained in a similar manner as the synthesis of Compound Ir1 of Synthesis Example 1, except that Compound Ir2-A (3.00 g, 2.36 mmol) was used instead of Compound Ir1-A, and an amount of Compound L1 that was used was changed to 1.23 g (2.36 mmol).

HRMS (MALDI) calculated for C₈₅H₈₅IrN₈O₃Ge₂: m/z: 1578.4736 g/mol, found: 1578.4742 g/mol.

### Synthesis Example 3 (Compound Ir3)

### Synthesis of Compound L3

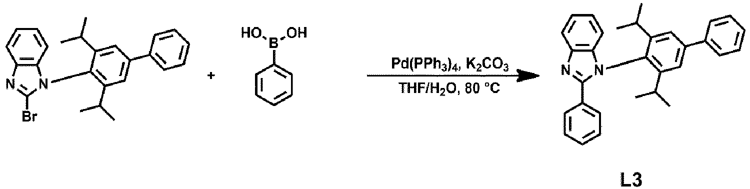

4.04 g (81%) of Compound L3 was obtained in a similar manner as the synthesis of Compound L1 of Synthesis Example 1, except that phenylboronic acid (1.41 g, 11.54 mmol) was used instead of dibenzo[b,d]furan-4-ylboronic acid.

### Synthesis of Compound Ir3

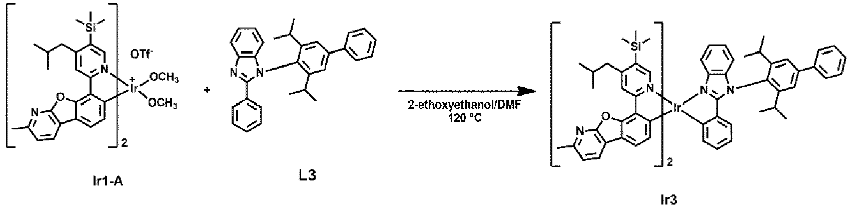

1.14 g (24 %) of Compound Ir3 was obtained in a similar manner as the synthesis of Compound Ir1 of Synthesis Example 1, except that an amount of Compound Ir1-A used was changed to 4.00 g (3.39 mmol), and Compound L3 (1.46 g, 3.39 mmol) was used instead of Compound L1.

HRMS (MALDI) calculated for C₇₉H₈₃IrN₆O₂Si₂: m/z: 1396.5745 g/mol, found: 1396.5752 g/mol.

### Synthesis Example 4 (Compound Ir4)

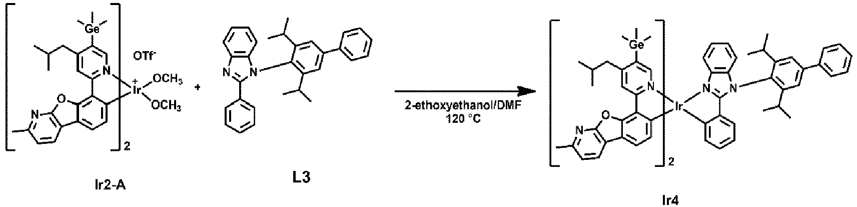

1.02 g (24%) of Compound Ir4 was obtained in a similar manner as the synthesis of Compound Ir1 of Synthesis Example 1, except that Compound Ir2-A (3.70 g, 2.91 mmol) was used instead of Compound Ir1-A, and Compound L3 (1.26 g, 2.91 mmol) was used instead of Compound L1.

HRMS (MALDI) calculated for C₇₉H₈₃IrN₈O₂Ge₂: m/z: 1488.4630 g/mol, found: 1488.4629 g/mol.

### Synthesis Example 5 (Compound Ir5)

### Synthesis of Compound Ir5-B

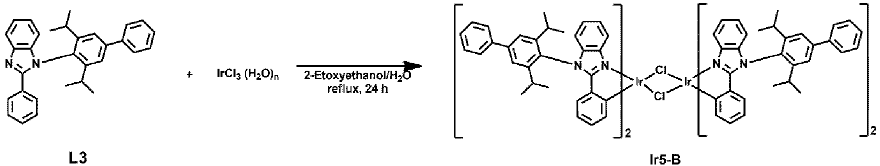

4.75 g (48%) of Compound Ir5-B was obtained in a similar manner as the synthesis of Compound Ir1-B of Synthesis Example 1, except that Compound L3 (4.0 g, 9.29 mmol) was used instead of Compound Ir1-C, and an amount of iridium chloride trihydrate that was used was changed to 1.64 g (4.64 mmol).

### Synthesis of Compound Ir5-A

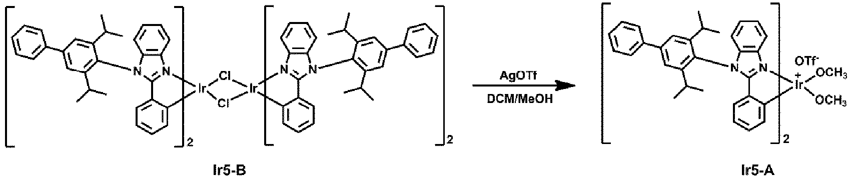

Compound Ir5-A was synthesized in a similar manner as the synthesis of Compound Ir1-A of Synthesis Example 1, except that Compound Ir5-B (3.50 g, 1.61 mmol) was used instead of Compound Ir1-B, and an amount of AgOTf that was used was changed to 0.87 g (3.38 mmol). Then, Compound Ir5-A was used in the next reaction without an additional purification process.

### Synthesis of Compound Ir5

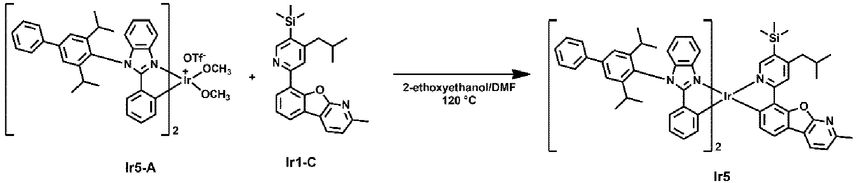

1.13 g (28%) of Compound Ir5 was obtained in a similar manner as the synthesis of Compound Ir1 of Synthesis Example 1, except that Compound Ir5-A (3.50 g, 2.77 mmol) was used instead of Compound Ir1-A, and Compound Ir1-C (1.08 g, 2.77 mmol) was used instead of Compound L1.

HRMS (MALDI) calculated for C₈₆H₈₅IrN₆OSi: m/z: 1438.6183 g/mol, found: 1438.6188 g/mol.

### Synthesis Example 6 (Compound Ir6)

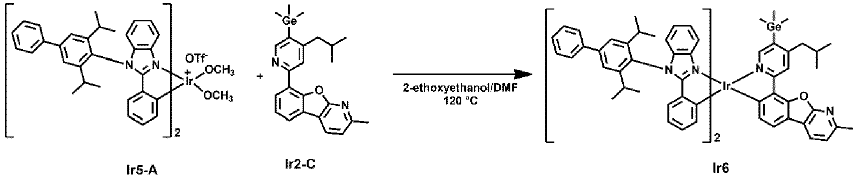

1.00 g (24%) of Compound Ir6 was obtained in a similar manner as the synthesis of Compound Ir1 of Synthesis Example 1, except that Compound Ir5-A (3.50 g, 2.77 mmol) was used instead of Compound Ir1-A, and Compound Ir2-C (1.20 g, 2.77 mmol) was used instead of Compound L1.

HRMS (MALDI) calculated for C₈₆H₈₅IrN₆OGe: m/z: 1484.5526 g/mol, found: 1484.5532 g/mol.

### Synthesis Example 7 (Compound Ir7)

### Synthesis of Compound Ir7-C

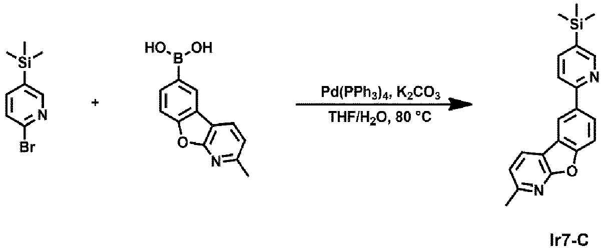

2-bromo-5-(trimethylsilyl)pyridine (5.00 g, 21.84 mmol), (2-methylbenzofuro[2,3-b]pyridin-6-yl)boronic acid (3.98 g, 21.84 mmol), Pd(PPh₃)₄ (1.26 g, 1.09 mmol), and K₂CO₃ (9.05 g, 65.50 mmol) were mixed with 90 mL of THF and 30 mL of DI water, and then stirred while heating at reflux for 18 hours. The temperature was then allowed to lower to room temperature, MC was used to extract an organic layer, and the organic layer was dried with anhydrous MgSO₄. A residue was obtained by removing the solvent under reduced pressure from a filtrate obtained by filtration. The residue was purified by column chromatography using EA:hexane (1:4, v/v) as eluents to obtain 3.85 g (59%) of Compound Ir7-C.

### Synthesis of Compound Ir7-B

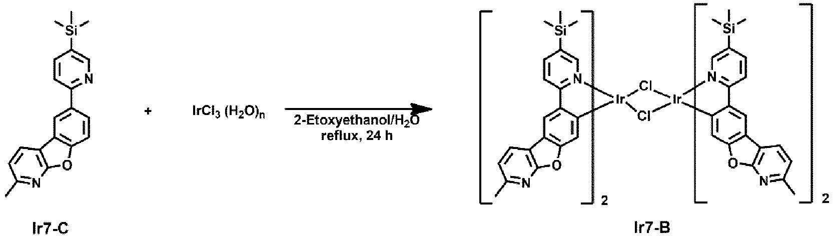

4.55 g (44%) of Compound Ir7-B was obtained in a similar manner as the synthesis of Compound Ir1-B of Synthesis Example 1, except that Compound Ir7-C (3.85 g, 11.58 mmol) was used instead of Compound Ir1-C, and an amount of iridium chloride trihydrate that was used was changed to 2.04 g (5.79 mmol).

### Synthesis of Compound Ir7-A

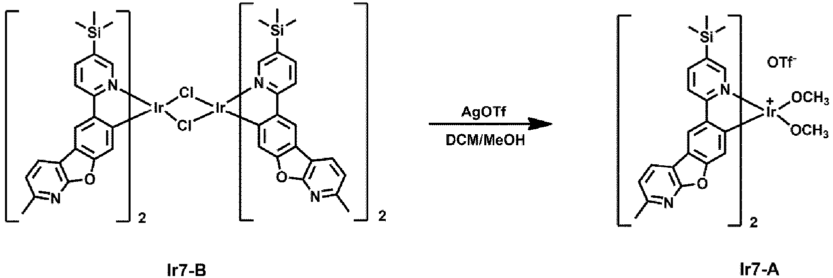

Compound Ir7-A was synthesized in a similar manner as the synthesis of Compound Ir1-A of Synthesis Example 1, except that Compound Ir7-B (4.55 g, 2.56 mmol) was used instead of Compound Ir1-B, and an amount of AgOTf that was used was changed to 1.38 g (5.37 mmol). Then, Compound Ir7-A was used in the next reaction step without an additional purification process.

### Synthesis of Compound Ir7

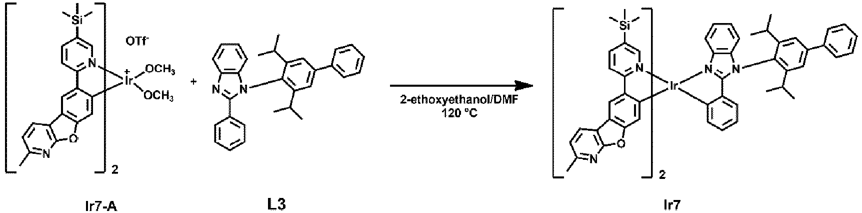

0.95 g (23%) of Compound Ir7 was obtained in a similar manner as the synthesis of Compound Ir1 of Synthesis Example 1, except that Compound Ir7-A (3.00 g, 2.81 mmol) was used instead of Compound Ir1-A, and Compound L3 (1.22 g, 2.81 mmol) was used instead of Compound L1.

HRMS (MALDI) calculated for C₇₁H₆₇IrfN₆O₂Si₂: m/z: 1284.7440 g/mol, found: 1284.7434 g/mol.

### Synthesis Example 8 (Compound Ir8)

### Synthesis of Compound Ir8-C

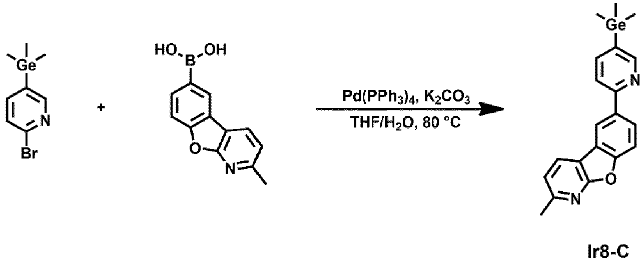

2-bromo-5-(trimethylgermyl)pyridine (5.00 g, 18.19 mmol), (2-methylbenzofuro[2,3-b]pyridin-6-yl)boronic acid (4.13 g, 18.19 mmol), Pd(PPh₃)₄ (1.26 g, 1.09 mmol), and K₂CO₃ (7.54 g, 54.56 mmol) were mixed with 90 mL of THF and 30 mL of DI water, and then the reaction mixture was stirred and heated at reflux for 18 hours. The temperature was allowed to lower to room temperature, MC was used to extract an organic layer, and the organic layer was dried with anhydrous MgSO₄. A residue was obtained by removing the solvent under reduced pressure from a filtrate obtained by filtration. The residue was purified by column chromatography using EA:hexane (1:4 v/v) as eluents to obtain 4.77 g (70%) of Compound Ir8-C.

### Synthesis of Compound Ir8-B

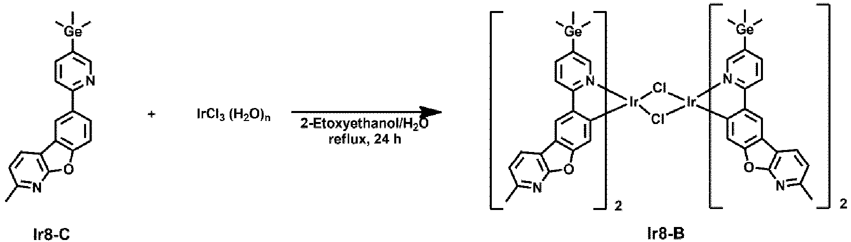

4.55 g (36%) of Compound Ir8-B was obtained in a similar manner as the synthesis of Compound Ir1-B of Synthesis Example 1, except that Compound Ir8-C (4.77 g, 12.65 mmol) was used instead of Compound Ir1-C, and an amount of iridium chloride trihydrate that was used was changed to 2.23 g (6.33 mmol).

### Synthesis of Compound Ir8-A

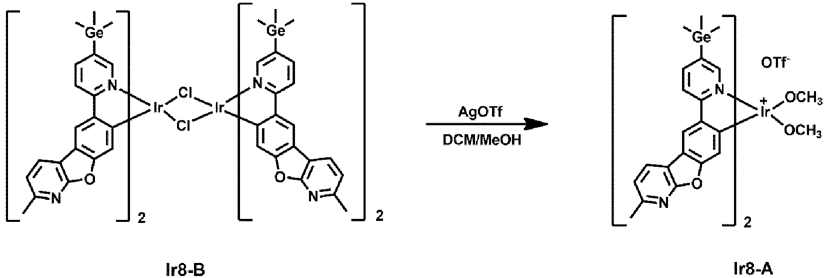

Compound Ir8-A was synthesized in a similar manner as the synthesis of Compound Ir1-A of Synthesis Example 1, except that Compound Ir8-B (4.55 g, 2.32 mmol) was used instead of Compound Ir1-B, and an amount of AgOTf that was used was changed to 1.25 g (4.88 mmol). Then, Compound Ir8-A was used in the next reaction step without an additional purification process.

### Synthesis of Compound Ir8

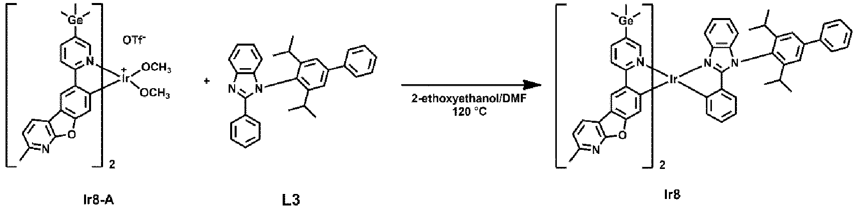

0.89 g (25%) of Compound Ir8 was obtained in a similar manner as the synthesis of Compound Ir1 of Synthesis Example 1, except that Compound Ir8-A (3.00 g, 2.59 mmol) was used instead of Compound Ir1-A, and Compound L3 (1.12 g, 2.59 mmol) was used instead of Compound L1.

HRMS (MALDI) calculated for C₇₁H₆₇IrN₆O₂Ge₂: m/z: 1376.3378 g/mol, found: 1376.3377 g/mol.

### Synthesis Example 9 (Compound Ir9)

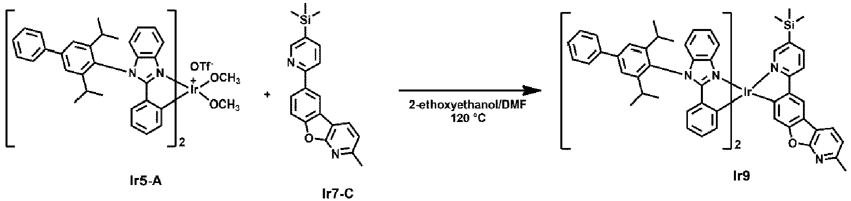

1.11 g (30%) of Compound Ir9 was obtained in a similar manner as the synthesis of Compound Ir1 of Synthesis Example 1, except that Compound Ir5-A (3.33 g, 2.63 mmol) was used instead of Compound Ir1-A, and Compound Ir7-C (0.88 g, 2.63 mmol) was used instead of Compound L1.

HRMS (MALDI) calculated for C₈₂H₇₇IrN₆OSi: m/z: 1382.5557 g/mol, found: 1382.5552 g/mol.

### Synthesis Example 10 (Compound Ir10)

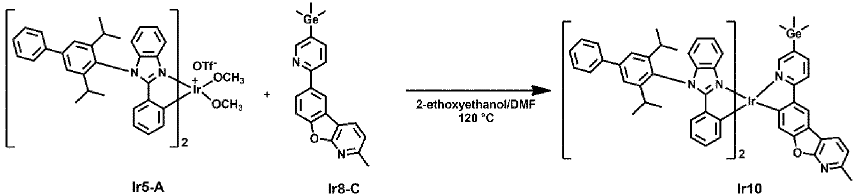

1.00 g (35%) of Compound Ir10 was obtained in a similar manner as the synthesis of Compound Ir1-A of Synthesis Example 1, except that Compound Ir5-A (2.52 g, 1.99 mmol) was used instead of Compound Ir1-A, and Compound Ir8-C (0.66 g, 1.99 mmol) was used instead of Compound L1.

HRMS (MALDI) calculated for C₈₂H₇₇IrN₆OGe: m/z: 1428.5000 g/mol, found: 1428.4995 g/mol.

### Synthesis Example 11 (Compound Ir11)

### Synthesis of Compound Ir11-C

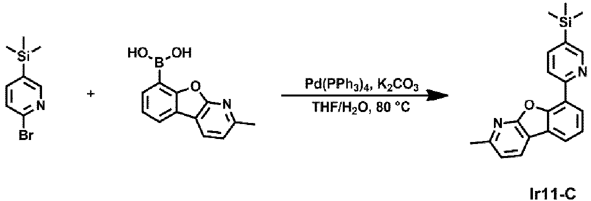

2-bromo-5-(trimethylsilyl)pyridine (5.00 g, 21.72 mmol), (2-methylbenzofuro[2,3-b]pyridin-8-yl)boronic acid (4.93 g, 21.72 mmol), Pd(PPh₃)₄ (1.01 g, 0.88 mmol), and K₂CO₃ (7.27 g, 52.62 mmol) were mixed with 90 mL of THF and 30 mL of DI water, and then heated and stirred at reflux for 18 hours. The temperature was then allowed to lower to room temperature, MC was used to extract an organic layer, and the organic layer was dried over anhydrous MgSO₄. A residue was obtained by removing the solvents under a reduced pressure from a filtrate obtained by filtration. The residue was purified by column chromatography using EA:hexane (1:4 v/v) as eluents to obtain 5.00 g (69%) of Compound Ir11-C.

### Synthesis of Compound Ir11-B

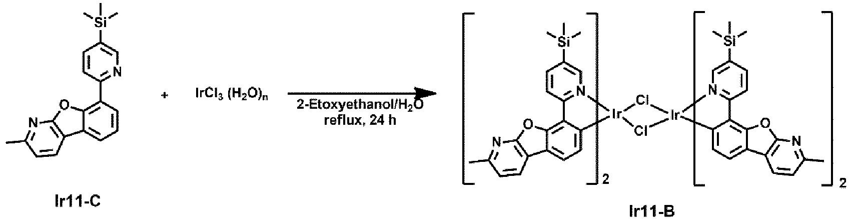

4.65 g (69%) of Compound Ir11-B was obtained in a similar manner as the synthesis of Compound Ir1-B of Synthesis Example 1, except that Compound Ir11-C (5.00 g, 15.04 mmol) was used instead of Compound Ir1-C, and an amount of iridium chloride trihydrate that was used was changed to 2.65 g (7.52 mmol).

### Synthesis of Compound Ir11-A

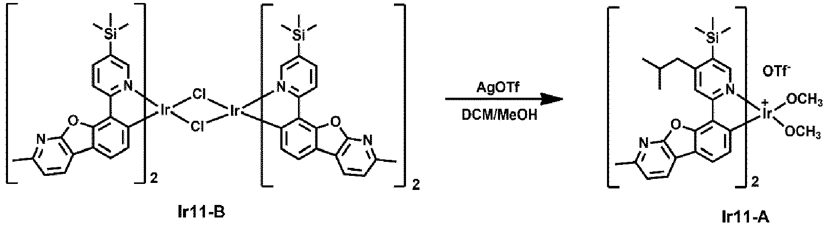

Compound Ir11-A was synthesized in a similar manner as the synthesis of Compound Ir1-A of Synthesis Example 1, except that Compound Ir11-B (4.65 g, 2.61 mmol) was used instead of Compound Ir1-B, and an amount of AgOTf that was used was changed to 1.41 g (5.48 mmol). Then, Compound Ir11-A was used in the next reaction step without an additional purification process.

### Synthesis of Compound L11

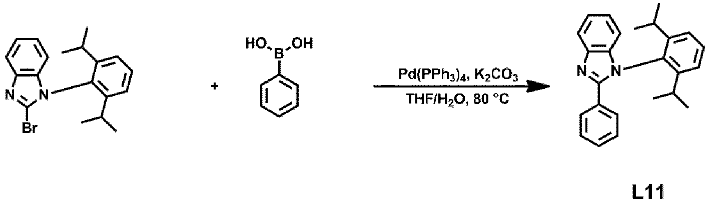

2-bromo-1-(2,6-diisopropylphenyl)-1H-benzo[d]imidazole (5.00 g, 14.00 mmol), phenylboronic acid (2.47 g, 14.00 mmol), Pd(PPh₃)₄ (0.81 g, 0.70 mmol), and K₂CO₃ (5.80 g, 41.98 mmol) were mixed with 90 mL of THF and 30 mL of DI water, and then stirred and heated at reflux for 18 hours. The temperature was then allowed to lower to room temperature, MC was used to extract an organic layer, and the organic layer was dried with MgSO₄. A residue was obtained by removing the solvent under a reduced pressure from a filtrate obtained by filtration. The residue was purified by column chromatography using EA:hexane (1:2 v/v) as eluents to obtain 4.19 g (84%) of Compound L11.

### Synthesis of Compound Ir11

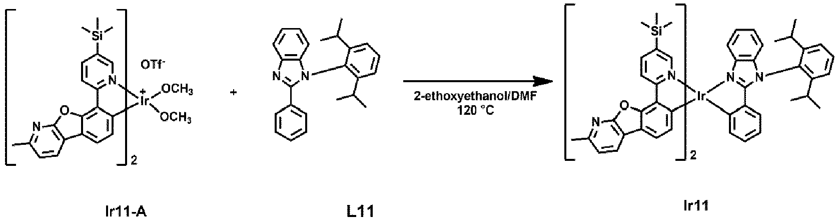

0.99 g (29%) of Compound Ir11 was obtained in a similar manner as the synthesis of Compound Ir1 of Synthesis Example 1, except that Compound Ir11-A (3.00 g, 2.81 mmol) was used instead of Compound Ir1-A, and Compound L11 (1.00 g, 2.81 mmol) was used instead of Compound L1.

HRMS (MALDI) calculated for C₆₅H₆₃IrN₆O₂Si₂: m/z: 1208.4180 g/mol, found: 1208.4184 g/mol.

### Synthesis Example 12 (Compound Ir12)

### Synthesis of Compound Ir12-C

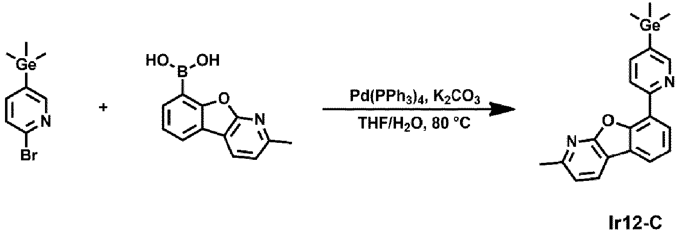

2-bromo-5-(trimethylgermyl)pyridine (5.00 g, 18.20 mmol), (2-methylbenzofuro[2,3-b]pyridin-8-yl)boronic acid (4.13 g, 18.20 mmol), Pd(PPh₃)₄ (1.05 g, 0.91 mmol), and K₂CO₃ (7.55 g, 54.60 mmol) were mixed with 90 mL of THF and 30 mL of DI water, and then stirred and heated at reflux for 18 hours. The temperature was then allowed to lower to room temperature, MC was used to extract an organic layer, and the organic layer was dried with MgSO₄. A residue was obtained by removing the solvent under a reduced pressure from a filtrate obtained by filtration. The residue was purified by column chromatography using EA:hexane (1:4 v/v) as eluents to obtain 6.15 g (90%) of Compound Ir12-C.

### Synthesis of Compound Ir12-B

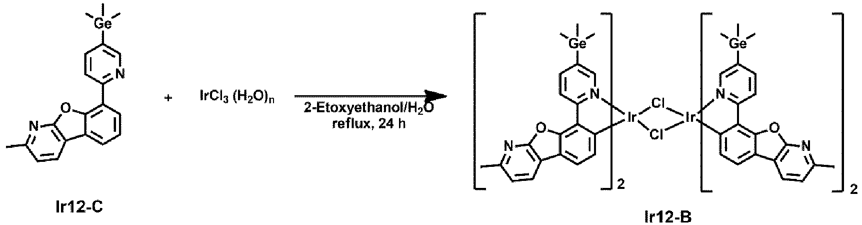

5.78 g (36%) of Compound Ir12-B was obtained in a similar manner as the synthesis of Compound Ir1-B of Synthesis Example 1, except that Compound Ir12-C (6.15 g, 16.31 mmol) was used instead of Compound Ir1-C, and an amount of iridium chloride trihydrate that was used was changed to 2.65 g (7.52 mmol).

### Synthesis of Compound Ir12-A

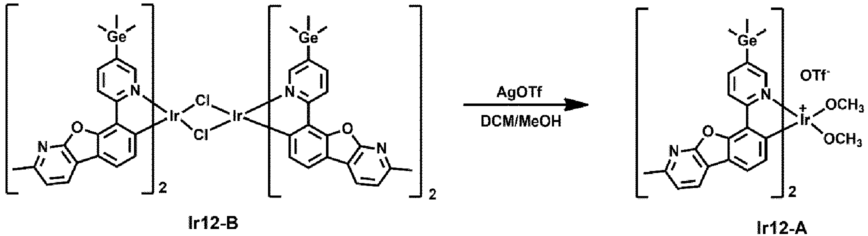

Compound Ir12-A was synthesized in a similar manner as the synthesis of Compound Ir1-A of Synthesis Example 1, except that Compound Ir12-B (5.78 g, 2.37 mmol) was used instead of Compound Ir1-B, and an amount of AgOTf that was used was changed to 1.28 g (4.98 mmol). Then, Compound Ir12-A was used in the next reaction step without an additional purification process.

### Synthesis of Compound Ir12

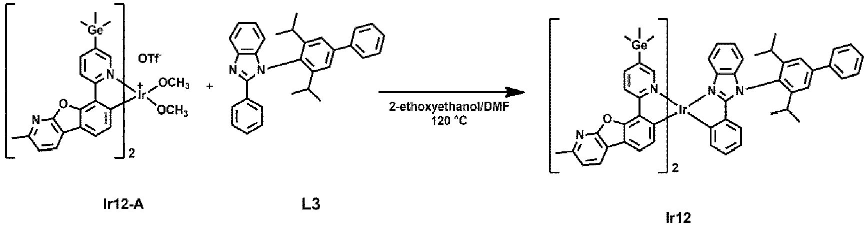

0.74 g (21%) of Compound Ir12 was obtained in a similar manner as the synthesis of Compound Ir1 of Synthesis Example 1, except that Compound Ir12-A (3.00 g, 2.59 mmol) was used instead of Compound Ir1-A, and Compound L3 (1.12 g, 2.59 mmol) was used instead of Compound L1.

HRMS (MALDI) calculated for C₇₁H₆₇IrN₆O₂Ge₂: m/z: 1373.3378 g/mol, found: 1373.3382 g/mol.

### Synthesis Example 13 (Compound Ir13)

### Synthesis of Compound Ir13-C

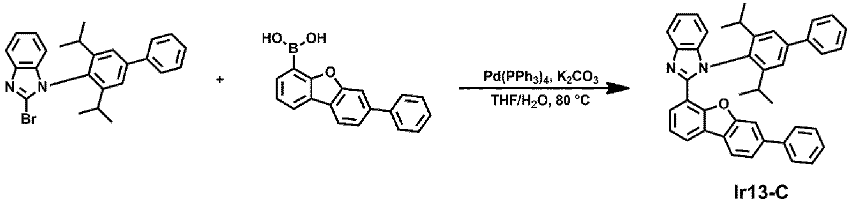

2-bromo-1-(3,5-diisopropyl-[1,1'-biphenyl]-4-yl)-1H-benzo[d]imidazole (5.00 g, 11.54 mmol), (7-phenyldibenzo[b,d]furan-4-yl)boronic acid (3.32 g, 11.54 mmol), Pd(PPh₃)₄ (0.67 g, 0.58 mmol), and K₂CO₃ (4.78 g, 34.61 mmol) were mixed with 90 mL of THF and 30 mL of DI water, and then stirred while heating at reflux for 18 hours. The temperature was then allowed to lower to room temperature, MC was used to extract an organic layer, and the organic layer was dried over anhydrous MgSO₄. A residue was obtained by removing the solvent under a reduced pressure from a filtrate obtained by filtration. The residue was purified by column chromatography using EA:hexane (1:2 v/v) as eluents to obtain 5.12 g (74%) of Compound Ir13-C.

### Synthesis of Compound Ir13-B

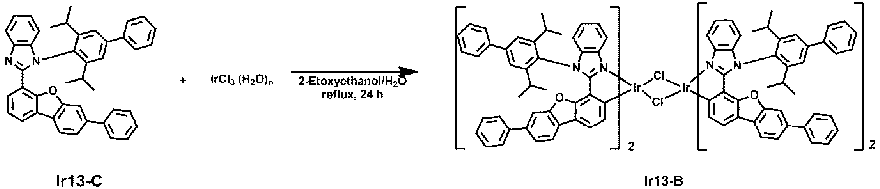

5.33 g (44%) of Compound Ir13-B was obtained in a similar manner as the synthesis of Compound Ir1-B of Synthesis Example 1, except that Compound Ir13-C (5.12 g, 8.58 mmol) was used instead of Compound Ir1-C, and an amount of iridium chloride trihydrate that was used was changed to 1.51 g (4.29 mmol).

### Synthesis of Compound Ir13-A

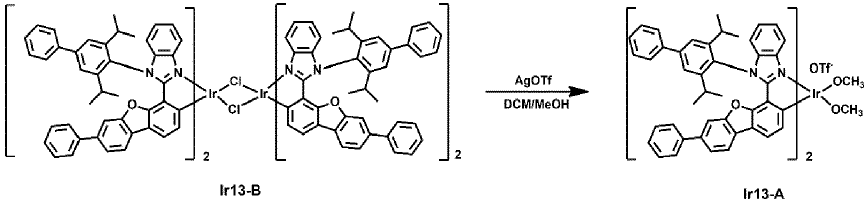

Compound Ir13-A was synthesized in a similar manner as the synthesis of Compound Ir1-A of Synthesis Example 1, except that Compound Ir13-B (3.53 g, 1.24 mmol) was used instead of Compound Ir1-B, and an amount of AgOTf that was used was changed to 0.67 g (2.61 mmol). Then, Compound Ir13-A was used in the next reaction step without an additional purification process.

### Synthesis of Compound Ir13

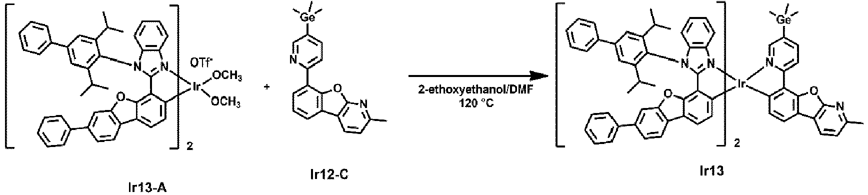

0.55 g (17%) of Compound Ir13 was obtained in a similar manner as the synthesis of Compound Ir1 of Synthesis Example 1, except that Compound Ir13-A (3.00 g, 1.88 mmol) was used instead of Compound Ir1-A, and Compound Ir12-C (0.71 g, 1.88 mmol) was used instead of Compound L1.

HRMS (MALDI) calculated for C₁₀₆H₈₉GeIrN₆O₃: m/z: 1760.5837 g/mol, found: 1760.5832 g/mol.

### Synthesis Example 14 (Compound Ir14)

### Synthesis of Compound Ir14-C

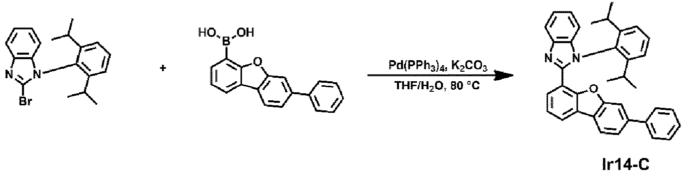

2-bromo-1-(2,6-diisopropylphenyl)-1H-benzo[d]imidazole (5.00 g, 14.00 mmol), (7-phenyldibenzo[b,d]furan-4-yl)boronic acid (4.03 g, 14.00 mmol), Pd(PPh₃)₄ (0.81 g, 0.70 mmol), and K₂CO₃ (5.80 g, 41.98 mmol) were mixed with 90 mL of THF and 30 mL of DI water, and then stirred while heating at reflux for 18 hours. The temperature was then allowed to lower to room temperature, MC was used to extract an organic layer, and the organic layer was dried with anhydrous MgSO₄. A residue was obtained by removing the solvents under a reduced pressure from a filtrate obtained by filtration. The residue was purified by column chromatography using EA:hexane (1:2 v/v) as eluents to obtain 4.75 g (57%) of Compound Ir14-C.

### Synthesis of Compound Ir14-B

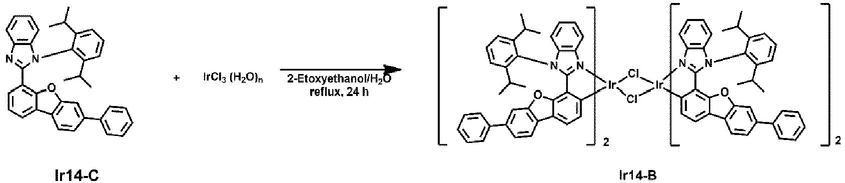

5.05 g (41%) of Compound Ir14-B was obtained in a similar manner as the synthesis of Compound Ir1-B of Synthesis Example 1, except that Compound Ir14-C (5.12 g, 9.83 mmol) was used instead of Compound Ir1-C, and an amount of iridium chloride trihydrate that was used was changed to 1.73 g (4.92 mmol).

### Synthesis of Compound Ir14-A

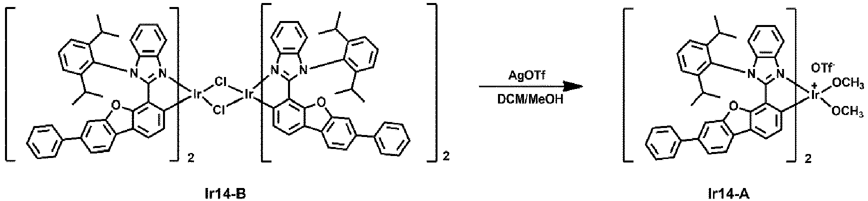

Compound Ir14-A was synthesized in a similar manner as the synthesis of Compound Ir1-A of Synthesis Example 1, except that Compound Ir14-B (5.05 g, 1.99 mmol) was used instead of Compound Ir1-B, and an amount of AgOTf that was used was changed to 1.08 g (4.19 mmol). Then, Compound Ir14-A was used in the next reaction step without an additional purification process.

### Synthesis of Compound L14

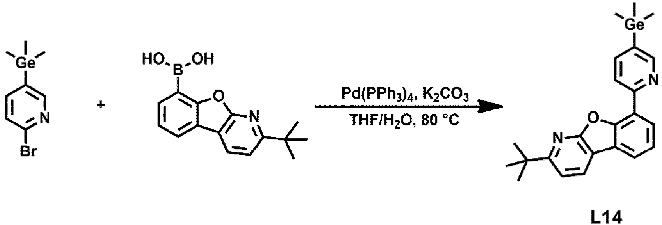

2-bromo-5-(trimethylgermyl)pyridine (5.00 g, 18.20 mmol), (2-(tert-butyl)benzofuro[2,3-b]pyridin-8-yl)boronic acid (4.90 g, 18.20 mmol), Pd(PPh₃)₄ (1.05 g, 0.91 mmol), and K₂CO₃ (7.55 g, 54.60 mmol) were mixed with 90 mL of THF and 30 mL of DI water, and then stirred while heating at reflux for 18 hours. The temperature was then allowed to lower to room temperature, MC was used to extract an organic layer, and the organic layer was dried over MgSO₄. A residue was obtained by removing the solvents under a reduced pressure from a filtrate obtained by filtration. The residue was purified by column chromatography using EA:hexane (1:4 v/v) as eluents to obtain 6.65 g (87%) of Compound L14.

### Synthesis of Compound Ir14

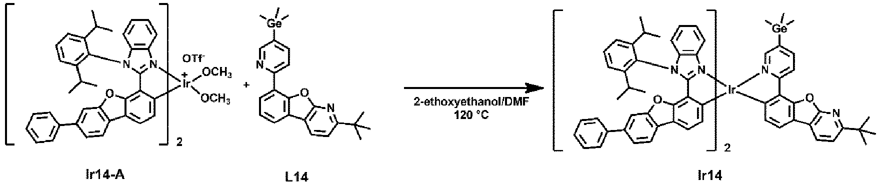

0.77 g (22%) of Compound Ir14 was obtained in a similar manner as the synthesis of Compound Ir1 of Synthesis Example 1, except that Compound Ir14-A (3.00 g, 2.08 mmol) was used instead of Compound Ir1-A, and Compound L14 (0.87 g, 2.08 mmol) was used instead of Compound L1.

HRMS (MALDI) calculated for C₉₇H₈₇GeIrN₆O₃: m/z: 1650.5681 g/mol, found: 1650.5687 g/mol.

### Example 1

A glass substrate with ITO/Ag/ITO (as an anode) deposited thereon to a thickness of 70 Å/1,000 Å/70 Å was cut to a size of 50 millimeters (mm) x 50 mm x 0.5 mm, sonicated with isopropyl alcohol and DI water each for 5 minutes, and then cleaned by irradiation of ultraviolet rays and exposure of ozone thereto for 30 minutes each. Then the resultant glass substrate was loaded onto a vacuum deposition apparatus.

Compound HT3 and F6-TCNNQ were co-deposited by vacuum on the anode at a weight ratio of 98:2 to form a hole injection layer having a thickness of 100 Å, Compound HT3 was vacuum-deposited on the hole injection layer to form a hole transport layer having a thickness of 1,350 Å, and then Compound H-H1 was vacuum-deposited on the hole transport layer to form an electron blocking layer having a thickness of 300 Å.

Next, Compound H-H1, Compound H-E43, and Compound Ir1 (dopant) were co-deposited on the electron blocking layer at a weight ratio of 57:38:5 to form an emission layer having a thickness of 400 Å.

Afterwards, Compounds ET3 and ET-D1 were co-deposited on the emission layer at a volume ratio of 50:50 to form an electron transport layer having a thickness of 350 Å, LiF was vacuum-deposited on the electron transport layer to form an electron injection layer having a thickness of 1 nm, and Mg and Ag were co-deposited on the electron injection layer at a weight ratio of 90:10 to form a cathode having a thickness of 120 Å, thereby completing manufacture of an organic light-emitting device.

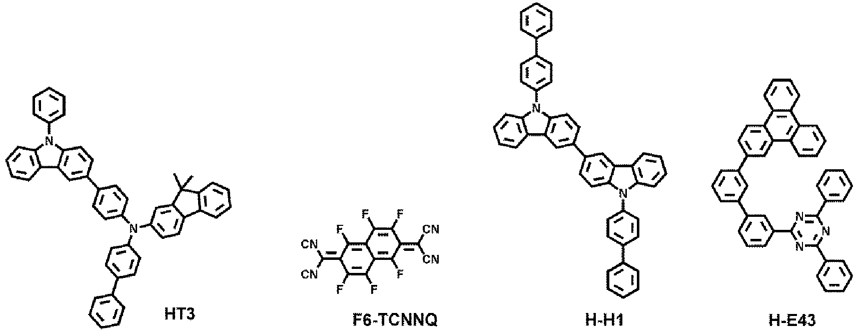

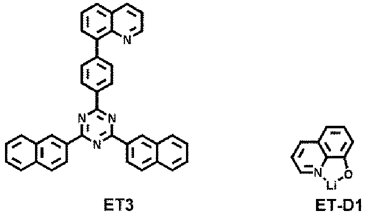

### Examples 2 to 4 and Comparative Examples R1 to R4

Organic light-emitting devices were manufactured in a similar manner as in Example 1, except that, in forming the emission layer, the compounds shown in Table 2 were used instead of Compound Ir1 as a dopant.

### Evaluation Example 1

For each of the organic light-emitting devices manufactured in Examples 1 to 4 and Comparative Examples R1 to R4, a maximum current efficiency (Max cd/A, %) at a target color coordinate CIEx=0.245, lifespan (LT₉₇, %), and a maximum emission wavelength (nm) of an electroluminescence (EL) spectrum were evaluated, and results thereof are shown in Table 2. As an evaluation device, a current-voltmeter (Keithley 2400) and a luminance meter (Minolta Cs-1000A) were used. The lifespan (LT₉₇) (at 15,000 candela per square meter) was evaluated as the time (hours, hr) taken for luminance to reduce to 97% of 100% of the initial luminance. The maximum current efficiency and lifespan were respectively expressed as relative values (%) with respect to the maximum current efficiency and lifespan of Comparative Example R1.

**Table 2**

| | Dopant in emission layer (Compound No.) | Max cd/A (relative %) | LT₉₇ (relative %) | Maximum emission wavelength (nm) |
|---|---|---|---|---|
| Example 1 | Ir1 | 103 | 100 | 531 |
| Comparative Example R1 | R1 | 100 | 87 | 532 |
| Example 2 | Ir2 | 103 | 100 | 531 |
| Comparative Example R2 | R2 | 100 | 86 | 532 |
| Example 3 | Ir3 | 103 | 103 | 530 |
| Comparative Example R3 | R3 | 96 | 100 | 529 |
| Example 4 | Ir4 | 103 | 101 | 530 |
| Comparative Example R4 | R4 | 95 | 99 | 529 |

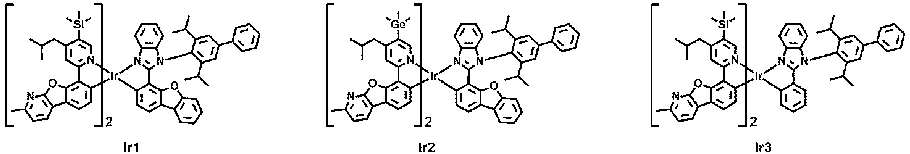

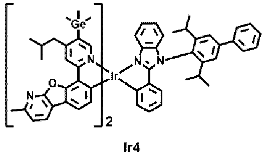

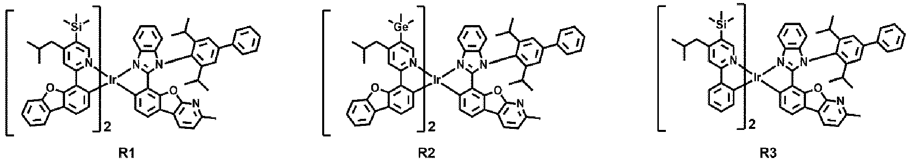

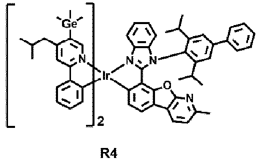

From Table 2, it was confirmed that the organic light-emitting devices of Examples 1 to 4 had improved maximum current efficiency and improved lifespan characteristics compared to those of the organic light-emitting devices of Comparative Examples R1 to R4, while emitting a green light.

### Examples 5 and 6 and Comparative Example R5

Organic light-emitting devices were manufactured in a similar manner as in Example 1, except that, in forming the emission layer, the compounds shown in Table 3 were used instead of Compound Ir1 as a dopant.

### Evaluation Example 2

For each of the organic light-emitting devices manufactured in Examples 5 and 6 and Comparative Example R5, maximum current efficiency (Max cd/A, %), lifespan (LT₉₇, %), and a maximum emission wavelength (nm) of an EL spectrum were evaluated in the same manner as in Evaluation Example 1, and results thereof are shown in Table 3. The maximum current efficiency and lifespan were respectively expressed as relative values (%) with respect to the maximum current efficiency and lifespan of Comparative Example R5. For comparison, relative values (%) of the maximum current efficiency and lifespan of the organic light-emitting devices of Examples 3 and 4 with respect to the maximum current efficiency and lifespan of Comparative Example R5 are also shown in Table 3.

**Table 3**

| | Dopant in emission layer (Compound No.) | Max cd/A (relative %) | LT₉₇ (relative %) | Maximum emission wavelength (nm) |
|---|---|---|---|---|
| Example 3 | Ir3 | 110 | 119 | 530 |
| Example 4 | Ir4 | 110 | 116 | 530 |
| Example 5 | Ir5 | 110 | 110 | 531 |
| Example 6 | Ir6 | 110 | 110 | 531 |
| Comparative Example R5 | R5 | 100 | 100 | 525 |

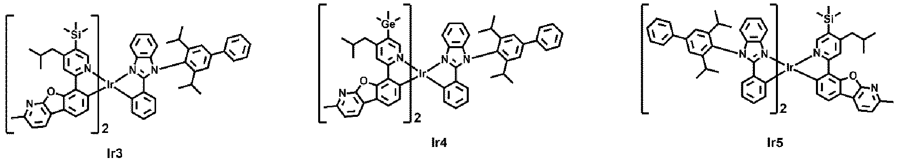

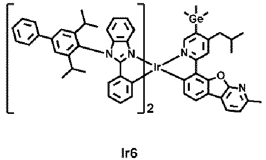

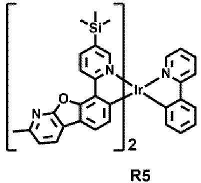

From Table 3, it was confirmed that the organic light-emitting devices of Examples 3 to 6 had improved maximum current efficiency and improved lifespan characteristics compared to those of the organic light-emitting device of Comparative Example R5 while emitting green light.

### Examples 7 to 10 and Comparative Example R6

Organic light-emitting devices were manufactured in a similar manner as in Example 1, except that, in forming the emission layer, the compounds shown in Table 4 were used instead of Compound Ir1 as a dopant.

### Evaluation Example 3

For each of the organic light-emitting devices manufactured in Examples 7 to 10 and Comparative Example R6, maximum current efficiency (Max cd/A, %), lifespan (LT₉₇, %), and a maximum emission wavelength (nm) of an EL spectrum were evaluated in the same manner as in Evaluation Example 1, and results thereof are shown in Table 4. The maximum current efficiency and lifespan were respectively expressed as relative values (%) with respect to the maximum current efficiency and lifespan of Comparative Example R6.

**Table 4**

| | Dopant in emission layer (Compound No.) | Max cd/A (relative %) | LT₉₇ (relative %) | Maximum emission wavelength (nm) |
|---|---|---|---|---|
| Example 7 | Ir7 | 103 | 103 | 535 |
| Example 8 | Ir8 | 103 | 103 | 535 |
| Example 9 | Ir9 | 110 | 104 | 534 |
| Example 10 | Ir10 | 112 | 103 | 534 |
| Comparative Example R6 | R6 | 100 | 100 | 534 |

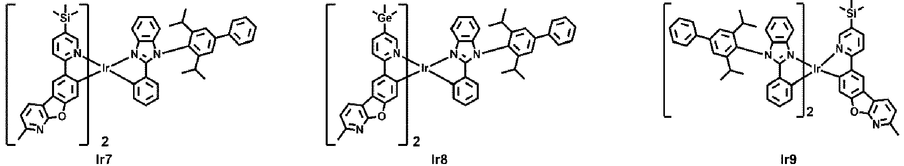

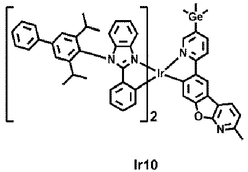

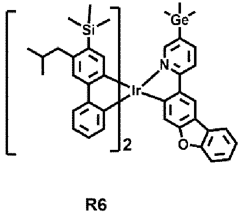

From Table 4, it was confirmed that the organic light-emitting devices of Examples 7 to 10 had improved maximum current efficiency and improved lifespan characteristics compared to those of the organic light-emitting device of Comparative Example R6 while emitting green light.

### Examples 11 to 14

Organic light-emitting devices were manufactured in a similar manner as in Example 1, except that, in forming the emission layer, the compounds shown in Table 5 were used instead of Compound Ir1 as a dopant.

### Evaluation Example 4

For each of the organic light-emitting devices manufactured in Examples 11 to 14, maximum current efficiency (Max cd/A, %), lifespan (LT₉₇, %), and a maximum emission wavelength (nm) of an EL spectrum were evaluated in the same manner as in Evaluation Example 1, and results thereof are shown in Table 5. The maximum current efficiency and lifespan were respectively expressed as relative values (%) with respect to the maximum current efficiency and lifespan of Comparative Example R1.

**Table 5**

| | Dopant in emission layer (Compound No.) | Max cd/A (relative %) | LT₉₇ (relative %) | Maximum emission wavelength (nm) |
|---|---|---|---|---|
| Example 11 | Ir11 | 100 | 112 | 529 |
| Example 12 | Ir12 | 100 | 110 | 529 |
| Example 13 | Ir13 | 110 | 106 | 531 |
| Example 14 | Ir14 | 105 | 103 | 530 |
| Comparative Example R1 | R1 | 100 | 100 | 532 |

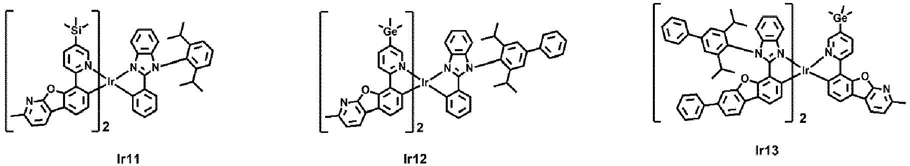

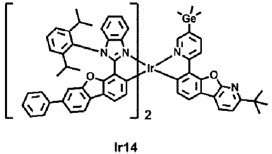

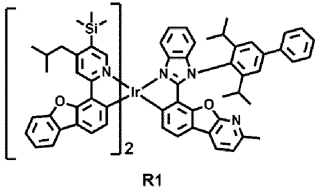

From Table 5, it was confirmed that each of the organic light-emitting devices of Examples 11 to 14 had improved maximum current efficiency and improved lifespan characteristics compared to those of the organic light-emitting device of Comparative Example R1 while emitting green light.

According to the one or more embodiments, the organometallic compound represented by Formula 1 has excellent thermal stability and/or electrical characteristics, and thus, an electronic device, for example, an organic light-emitting device, including at least one of the organometallic compounds may have an improved external quantum efficiency and an improved lifespan, and a high-quality electronic apparatus may be manufactured by using the organic light-emitting device.

It should be understood that exemplary embodiments described herein should be considered in a descriptive sense only and not for purposes of limitation. Descriptions of features or aspects within each exemplary embodiment should typically be considered as available for other similar features or aspects in other embodiments. While one or more exemplary embodiments have been described with reference to the figure, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁ (L₂)ₙ₂
wherein, in Formula 1,
M is iridium, platinum, osmium, or rhodium,
L₁ is a ligand represented by Formula 2-1,
L₂ is a ligand represented by Formula 2-2,
n1 and n2 are each independently 1 or 2,
when n1 is 2, two L₁ are identical to or different from each other, and when n2 is 2, two L₂ are identical to or different from each other, and
L₁ and L₂ are different from each other, 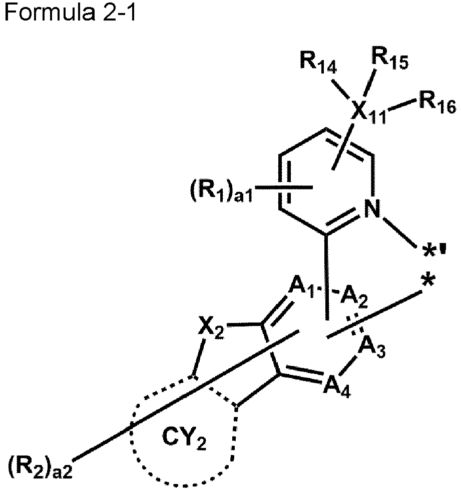 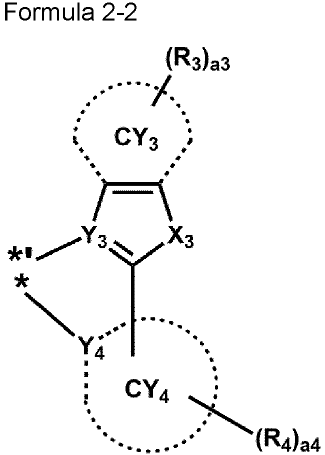
wherein, in Formulae 2-1 and 2-2,
X₁₁ is Si or Ge,
X₂ is O, S, Se, N(R₂₉), C(R₂₉ₐ)(R_{29b}), or Si(R₂₉ₐ)(R_{29b}),
A₁ to A₄ are each independently C or N, wherein one of A₁ to A₄ is C bonded to a neighboring pyridine group, and another of A₁ to A₄ is C bonded to M in Formula 1,
Y₃ is N,
X₃ is O, S, or N-(T₃-Z₃),
T₃ is a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
Y₄ is C or N,
ring CY₂ to ring CY₄ are each independently a C₅-C₃₀ carbocyclic group or a C₁-C₃₀ heterocyclic group, wherein ring CY₂ is a C₃-C₃₀ heterocyclic group comprising at least one N as a ring-forming atom; at least one of A₁ to A₄ is N; or ring CY₂ is a C₃-C₃₀ heterocyclic group comprising at least one N as a ring-forming atom, and at least one of A₁ to A₄ is N,
R₁ to R₄, R₁₄ to R₁₆, R₂₉, R₂₉ₐ, R_{29b}, and Z₃ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
a1 is an integer from 0 to 3,
a2 is an integer from 0 to 6,
a3 and a4 are each independently an integer from 0 to 20,
two or more of a plurality of R₁ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₂ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of R₁ to R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is as described in connection with R₂,
* and *' each indicate a binding site to M in Formula 1,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof, and
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein X₂ is O or S.

3. The organometallic compound of claims 1 or 2, wherein, in Formula 2-1,
A₁ is C bonded to a neighboring pyridine group, and A₂ is C bonded to M in Formula 1; or
A₃ is C bonded to a neighboring pyridine group, and A₂ is C bonded to M in Formula 1.

4. The organometallic compound of any of claims 1-3, wherein ring CY₂ is a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group; and/or
wherein ring CY₃ is a benzene group, a naphthalene group, an anthracene group, a phenanthrene group, a pyridine group, a pyrimidine group, a pyridazine group, a pyrazine group, a quinoline group, or an isoquinoline group; and/or
wherein ring CY₄ is a benzene group, a naphthalene group, an anthracene group, a phenanthrene group, a 1,2,3,4-tetrahydronaphthalene group, a benzene group condensed with a norbornane group, a carbazole group, a fluorene group, a dibenzosilole group, a dibenzothiophene group, a dibenzofuran group, a dibenzoselenophene group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group.

5. The organometallic compound of any of claims 1-4, wherein R₁ to R₄, R₂₉, R₂₉ₐ, R_{29b}, and Z₃ are each independently:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, - Si(Q₃₃)(Q₃₄)(Q₃₅), -Ge(Q₃₃)(Q₃₄)(Q₃₅), or a combination thereof, and
R₁₄ to R₁₆ are each independently a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

6. The organometallic compound of any of claims 1-5, wherein a2 in Formula 2-1 is not 0, and R₂ is not hydrogen; and/or
wherein the organometallic compound comprises deuterium, a fluoro group, or a combination thereof.

7. The organometallic compound of any of claims 1-6, wherein a group represented by 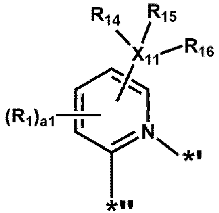 in Formula 2-1 is a group represented by one of Formulae CY1-1 to CY1-6: 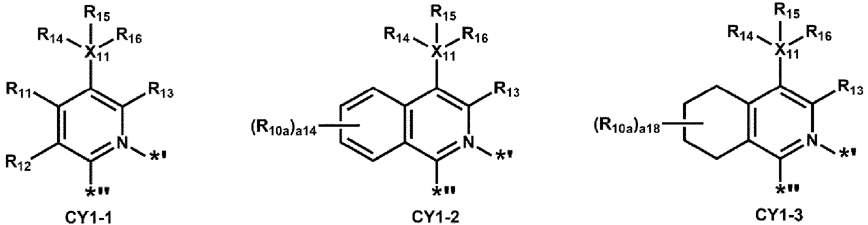 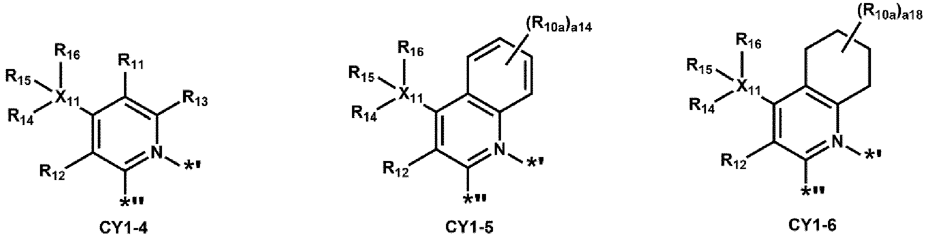 wherein, in Formulae CY1-1 to CY1-6,
X₁₁, R₁₄ to R₁₆, and R₁₀ₐ are each as described in claim 1,
R₁₁ to R₁₃ are each independently as described in connection with R₁ in claim 1,
a14 is an integer from 0 to 4,
a18 is an integer from 0 to 8,
*' indicates a binding site to M in Formula 1, and
*" indicates a binding site to one of A₁ to A₄ in Formula 2-1.

8. The organometallic compound of any of claims 1-7, wherein a group represented by 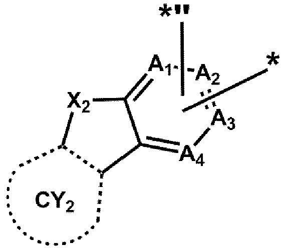 in Formula 2-1 is a group represented by one of Formulae CY2-1 to CY2-20: 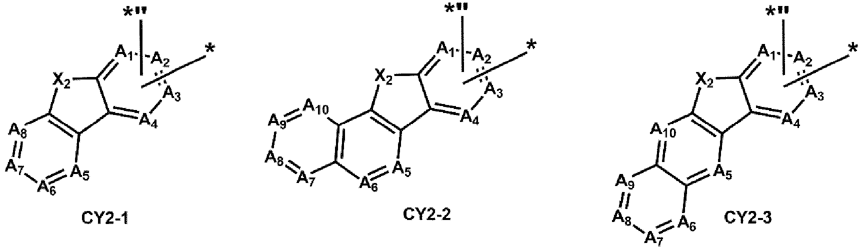 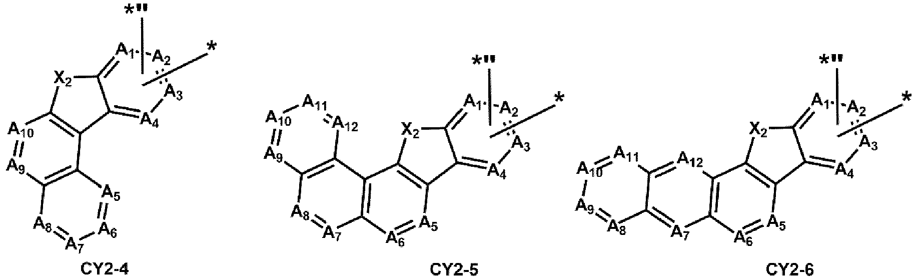 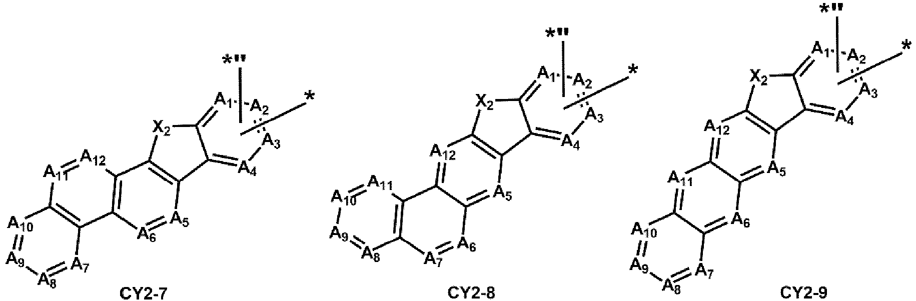 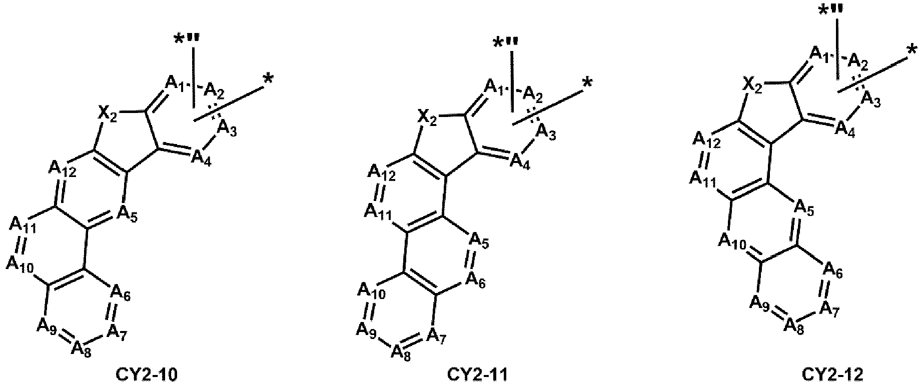 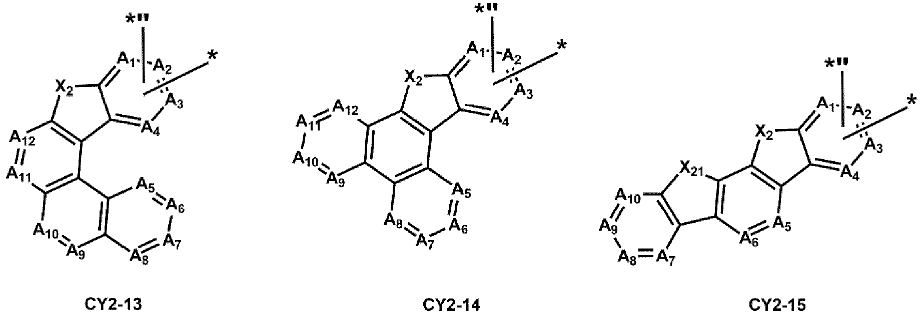 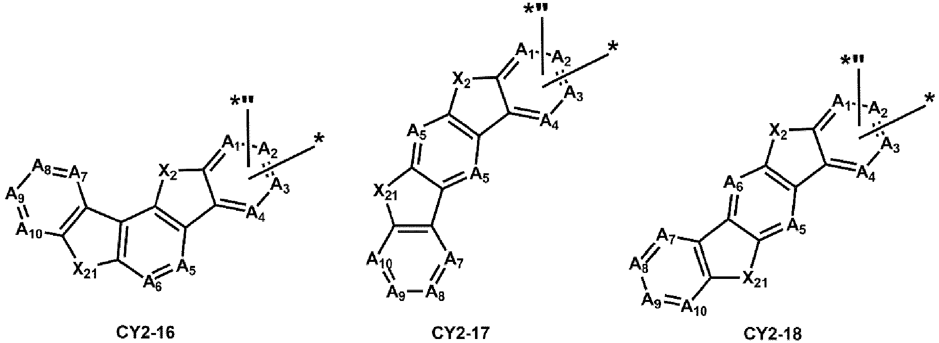 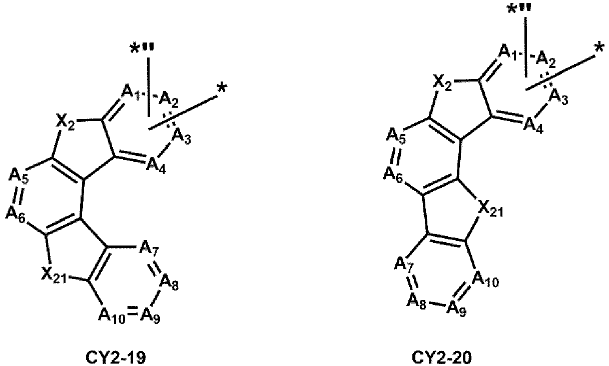 wherein, in Formulae CY2-1 to CY2-20,
X₂ is as described in claim 1,
X₂₁ is as described in connection with X₂ in claim 1,
A₁ to A₁₂ are each independently C or N, wherein at least one of A₁ to A₈ in Formula CY2-1 is N, at least one of A₁ to A₁₀ in Formulae CY2-2 to CY2-4 and CY2-15 to CY2-20 is N, and at least one of A₁ to A₁₂ in Formulae CY2-5 to CY2-14 is N,
*" indicates a binding site to a neighboring pyridine group in Formula 2-1, and
* indicates a binding site to M in Formula 1.

9. The organometallic compound of claim 8, wherein
at least one of A₄ to A₈ in Formula CY2-1 is N,
at least one of A₄ to A₁₀ in Formulae CY2-2 to CY2-4 and CY2-15 to CY2-20 is N, and
at least one of A₄ to A₁₂ in Formulae CY2-5 to CY2-14 is N.

10. The organometallic compound of any of claims 1-9, wherein a group represented by 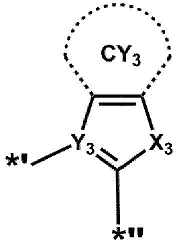 in Formula 2-2 is a group represented by one of Formulae CY3-1 to CY3-20: 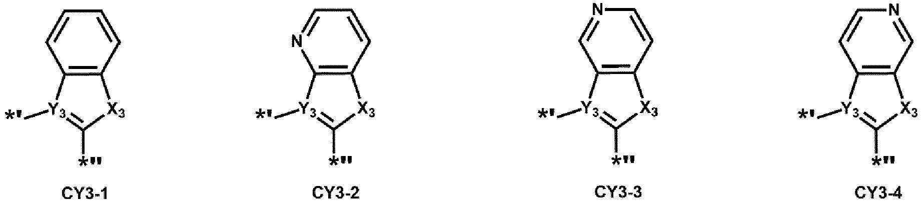 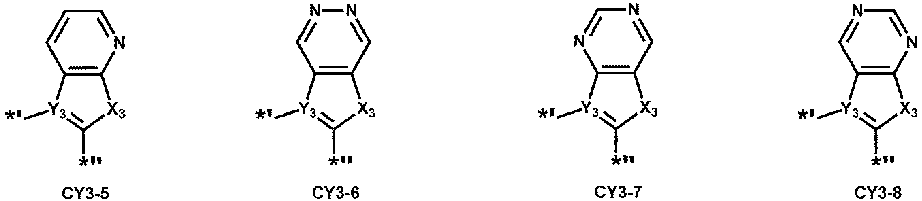 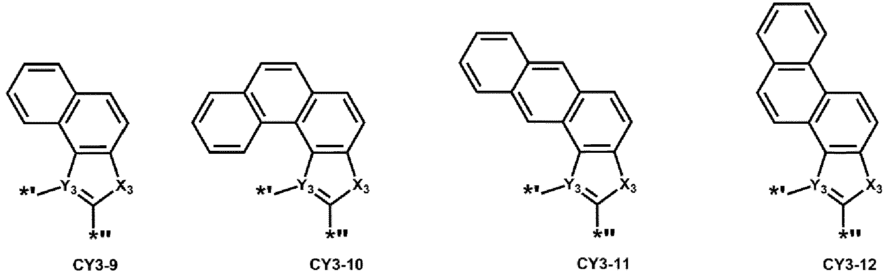 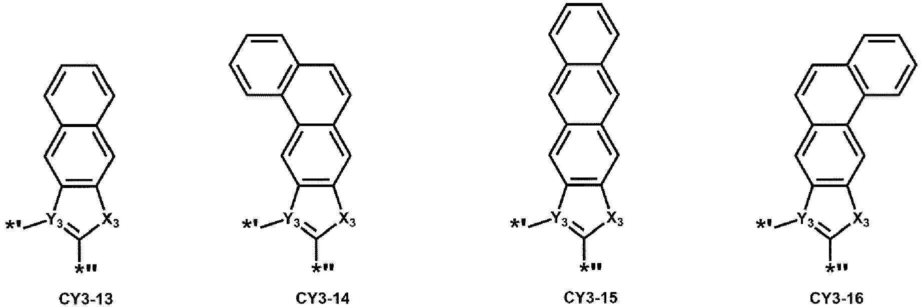 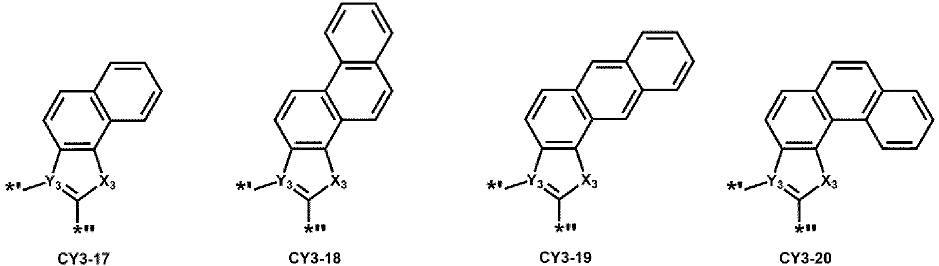 wherein, in Formulae CY3-1 to CY3-20,
Y₃ and X₃ are each as described in claim 1,
*' indicates a binding site to M in Formula 1, and
*" indicates a binding site to a neighboring atom in Formula 2-2.

11. The organometallic compound of any of claims 1-10, wherein a group represented by 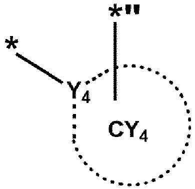 in Formulae 2-2 is a group represented by one of Formulae CY4-1 to CY4-21: 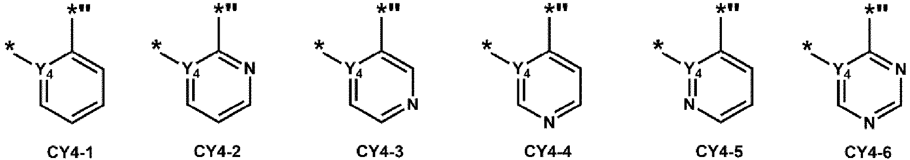 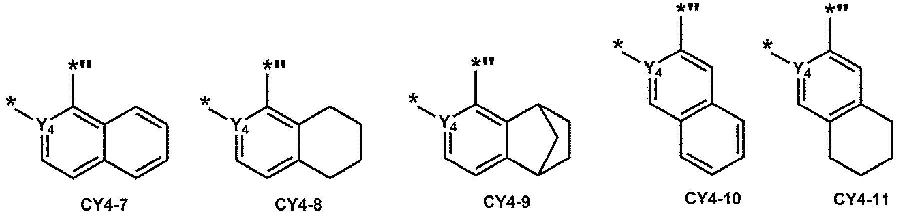 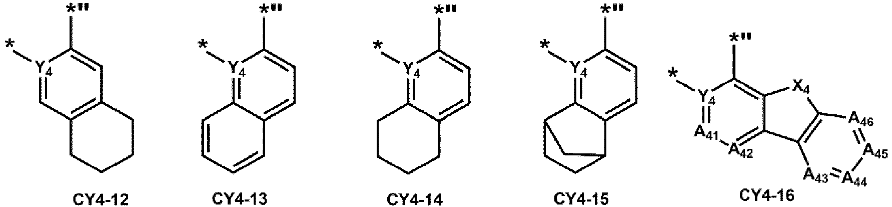 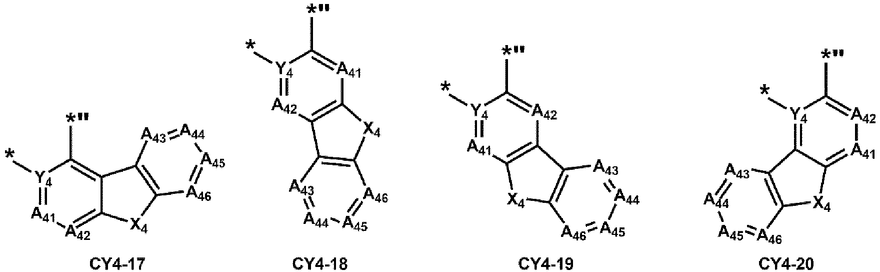 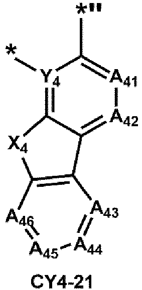 wherein, in Formulae CY4-1 to CY4-21,
Y₄ is C,
A₄₁ to A₄₆ are each independently C or N,
X₄ is O, S, Se, N(R₄₉), C(R₄₉ₐ)(R_{49b}), or Si(R₄₉ₐ)(R_{49b}),
R₄₉, R₄₉ₐ, and R_{49b} are each independently as described in connection with R₄ in claim 1,
* indicates a binding site to M in Formula 1, and
*" indicates a binding site to a neighboring atom in Formulae 2-2.

12. An organic light-emitting device, comprising:
a first electrode;
a second electrode; and
an organic layer arranged between the first electrode and the second electrode,
wherein the organic layer comprises an emission layer, and
wherein the organic layer further comprises at least one organometallic compound of any of claims 1-11;
preferably wherein
the first electrode is an anode,
the second electrode is a cathode,
the organic layer further comprises a hole transport region arranged between the first electrode and the emission layer and an electron transport region arranged between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

13. The organic light-emitting device of claim 12, wherein the emission layer comprises the at least one organometallic compound.

14. The organic light-emitting device of claim 13, wherein the emission layer emits a green light; and/or
wherein the emission layer further comprises a host, and an amount of the host in the emission layer is greater than an amount of the at least one organometallic compound in the emission layer.

15. An electronic apparatus, comprising the organic light-emitting device of any of claims 12-14.

## Patentansprüche

1. Organometallische Verbindung, dargestellt durch Formel 1:
Formel 1 M(L₁)ₙ₁(L₂)ₙ₂
wobei in Formel 1
M Iridium, Platin, Osmium oder Rhodium ist,
L₁ ein durch Formel 2-1 dargestellter Ligand ist,
L₂ ein durch Formel 2-2 dargestellter Ligand ist,
n1 und n2 jeweils unabhängig 1 oder 2 sind,
wenn n1 2 ist, zwei L₁ miteinander identisch oder voneinander unterschiedlich sind, und wenn n2 2 ist, zwei L₂ miteinander identisch oder voneinander unterschiedlich sind, und
L₁ und L₂ voneinander unterschiedlich sind, 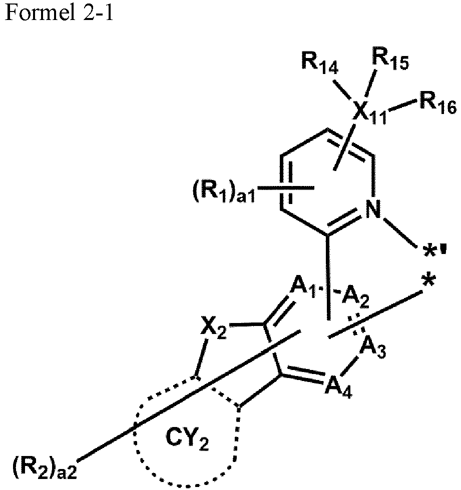 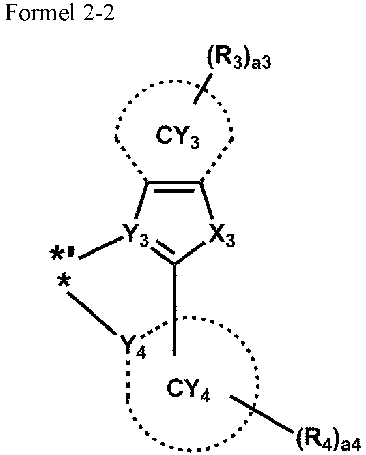
wobei in Formeln 2-1 und 2-2
X₁₁ Si oder Ge ist,
X₂ O, S, Se, N(R₂₉), C(R₂₉ₐ)(R_{29b}) oder Si(R₂₉ₐ)(R_{29b}) ist,
A₁ bis A₄ jeweils unabhängig C oder N sind, wobei eines von A₁ bis A₄ C ist, das an eine benachbarte Pyridingruppe gebunden ist, und ein anderes von A₁ bis A₄ C ist, das an M in Formel 1 gebunden ist,
Y₃ N ist,
X₃ O, S oder N-(T₃-Z₃) ist,
T₃ eine Einfachbindung, eine unsubstituierte oder mit mindestens einem R₁₀ₐ substituierte C₁-C₂₀-Alkylengruppe, eine unsubstituierte oder mit mindestens einem R₁₀ₐ substituierte carbocyclische C₅-C₃₀-Gruppe oder eine unsubstituierte oder mit mindestens einem R₁₀ₐ substituierte heterocyclische C₁-C₃₀-Gruppe ist,
Y₄ C oder N ist,
Ring CY₂ bis Ring CY₄ jeweils unabhängig eine C₅-C₃₀ carbocyclische Gruppe oder eine C₁-C₃₀ heterocyclische Gruppe sind, wobei Ring CY₂ eine C₃-C₃₀ heterocyclische Gruppe ist, die mindestens ein N als ringbildendes Atom umfasst; mindestens eines von A₁ bis A₄ N ist; oder Ring CY₂ eine heterocyclische C₃-C₃₀-Gruppe ist, die mindestens ein N als ringbildendes Atom umfasst, und mindestens eines von A₁ bis A₄ N ist,
R₁ bis R₄, R₁₄ bis R₁₆, R₂₉, R₂₉ₐ, R_{29b} und Z₃ jeweils unabhängig Wasserstoff, Deuterium, -F, -Cl, -Br, -I, -SF₅, eine Hydroxygruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, - N(Q₁)(Q₂), -Si(Q₃)(Q₄)(Q₅), -Ge(Q₃)(Q₄)(Q₅), -B(Q₆)(Q₇), -P(=O)(Q₈)(Q₉) oder -P(Q₈)(Q₉) ist,
a1 eine ganze Zahl von 0 bis 3 ist,
a2 eine ganze Zahl von 0 bis 6 ist,
a3 und a4 jeweils unabhängig eine ganze Zahl von 0 bis 20 sind,
zwei oder mehr aus einer Vielzahl von R₁ optional miteinander verknüpft sind, um eine carbocyclische C₅-C₃₀-Gruppe, die unsubstituiert oder mit mindestens einem R₁₀ₐ substituiert ist, oder eine heterocyclische C₁-C₃₀-Gruppe, die unsubstituiert oder mit mindestens einem R₁₀ₐ substituiert ist, zu bilden,
zwei oder mehr aus einer Vielzahl von R₂ optional miteinander verknüpft sind, um eine carbocyclische C₅-C₃₀-Gruppe zu bilden, die unsubstituiert oder mit mindestens einem R₁₀ₐ substituiert ist, oder eine heterocyclische C₁-C₃₀-Gruppe, die unsubstituiert oder mit mindestens einem R₁₀ₐ substituiert ist,
zwei oder mehr aus einer Vielzahl von R₃ optional miteinander verknüpft sind, um eine carbocyclische C₅-C₃₀-Gruppe zu bilden, die unsubstituiert oder mit mindestens einem R₁₀ₐ substituiert ist, oder eine heterocyclische C₁-C₃₀-Gruppe, die unsubstituiert oder mit mindestens einem R₁₀ₐ substituiert ist,
zwei oder mehr aus einer Vielzahl von R₄ optional miteinander verknüpft sind, um eine carbocyclische C₅-C₃₀-Gruppe zu bilden, die unsubstituiert oder mit mindestens einem R₁₀ₐ substituiert ist, oder eine heterocyclische C₁-C₃₀-Gruppe, die unsubstituiert oder mit mindestens einem R₁₀ₐ substituiert ist,
zwei oder mehr von R₁ bis R₄ gegebenenfalls miteinander verknüpft sind, um eine carbocyclische C₅-C₃₀-Gruppe zu bilden, die unsubstituiert oder mit mindestens einem R₁₀ₐ substituiert ist, oder eine heterocyclische C₁-C₃₀-Gruppe, die unsubstituiert oder mit mindestens einem R₁₀ₐ substituiert ist,
R₁₀ₐ wie in Verbindung mit R₂ beschrieben ist,
* und *' jeweils eine Bindungsstelle an M in Formel 1 anzeigen,
mindestens ein Substituent der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -SF₅, -CD₃, -CD₂H, -CDH₂, -CF₃, -CF₂H, -CFH₂, eine Hydroxygruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe,
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit mindestens einem von Deuterium, -F, -Cl, -Br, -I, -SF₅, -CD₃, -CD₂H, -CDH₂, -CF₃, -CF₂H, -CFH₂, einer Hydroxygruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils unsubstituiert oder substituiert mit mindestens einem von Deuterium, -F, -Cl, -Br, -I, -SF₅, -CD₃, -CD₂H, -CDH₂, - CF₃, -CF₂H, -CFH₂, einer Hydroxygruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), P(Q₂₈)(Q₂₉) oder einer Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P (Q₃₈)(Q₃₉) oder
eine Kombination davon, und
Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, -SF₅, eine Hydroxygruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe oder eine substituierte oder unsubstituierte einwertige nichtaromatische kondensierte heteropolycyclische Gruppe sind.

2. Organometallische Verbindung nach Anspruch 1, wobei X₂ O oder S ist.

3. Organometallische Verbindung nach Anspruch 1 oder 2, wobei in Formel 2-1,
A₁ C ist, das an eine benachbarte Pyridingruppe gebunden ist, und A₂ C ist, das an M in Formel 1 gebunden ist, oder
A₃ C ist, das an eine benachbarte Pyridingruppe gebunden ist, und A₂ C ist, das an M in Formel 1 gebunden ist.

4. Organometallische Verbindung nach einem der Ansprüche 1-3, wobei Ring CY₂ eine Pyridingruppe, eine Pyrimidingruppe, eine Pyridazingruppe, eine Pyrazingruppe, eine Chinolingruppe, eine Isochinolingruppe, eine Chinoxalingruppe, eine Chinazolingruppe, eine Phenanthridingruppe, eine Phenanthrolingruppe, eine Benzochinolingruppe, eine Benzoisochinolingruppe, eine Azacarbazolgruppe, eine Azafluorengruppe, eine Azadibenzosilolgruppe, eine Azadibenzothiophengruppe, eine Azadibenzofurangruppe, eine Azadibenzoselenophengruppe, eine Azabenzocarbazolgruppe, eine Azabenzofluorengruppe, eine Azanaphthobenzosilolgruppe, eine Azanaphthobenzothiophengruppe, eine Azanaphthobenzofurangruppe, eine Azanaphthobenzoselenophengruppe, eine Azadibenzocarbazolgruppe, eine Azadibenzofluorengruppe, eine Azadinaphthosilolgruppe, eine Azadinaphthothiophengruppe, eine Azadinaphthofurangruppe, eine Azadinaphthoselenophengruppe, eine Azanaphthocarbazolgruppe, eine Azanaphthofluorengruppe, eine Azaphenanthrobenzosilolgruppe, eine Azaphenanthrobenzothiophengruppe, eine Azaphenanthrobenzofurangruppe oder eine Azaphenanthrobenzoselenophengruppe und/oder
wobei Ring CY₃ eine Benzolgruppe, eine Naphthalingruppe, eine Anthracengruppe, eine Phenanthrengruppe, eine Pyridingruppe, eine Pyrimidingruppe, eine Pyridazingruppe, eine Pyrazingruppe, eine Chinolingruppe oder eine Isochinolingruppe ist, und/oder
wobei der Ring CY₄ eine Benzolgruppe, eine Naphthalingruppe, eine Anthracengruppe, eine Phenanthrengruppe, eine 1,2,3,4-Tetrahydronaphthalingruppe, eine mit einer Norbornangruppe kondensierte Benzolgruppe, eine Carbazolgruppe, eine Fluorengruppe, eine Dibenzosilolgruppe, eine Dibenzothiophengruppe, eine Dibenzofurangruppe, eine Dibenzoselenophengruppe, eine Benzocarbazolgruppe, eine Benzofluorengruppe, eine Naphthobenzosilolgruppe, eine Naphthobenzothiophengruppe, eine Naphthobenzofurangruppe, eine Naphthobenzoselenophengruppe, eine Dibenzocarbazolgruppe, eine Dibenzofluorengruppe, eine Dinaphthosilolgruppe, eine Dinaphthothiophengruppe, eine Dinaphthofurangruppe, eine Dinaphthoselenophengruppe, eine Naphthocarbazolgruppe, eine Naphthofluorengruppe, eine Phenanthrobenzosilolgruppe, eine Phenanthrobenzothiophengruppe, eine Phenanthrobenzofurangruppe, eine Phenanthrobenzoselenophengruppe, eine Azacarbazolgruppe, eine Azafluorengruppe, eine Azadibenzosilolgruppe, eine Azadibenzothiophengruppe, eine Azadibenzofurangruppe, eine Azadibenzoselenophengruppe, eine Azabenzocarbazolgruppe, eine Azabenzofluorengruppe, eine Azanaphthobenzosilolgruppe, eine Azanaphthobenzothiophengruppe, eine Azanaphthobenzofurangruppe, eine Azanaphthobenzoselenophengruppe, eine Azadibenzocarbazolgruppe, eine Azadibenzofluorengruppe, eine Azadinaphthosilolgruppe, eine Azadinaphthothiophengruppe, eine Azadinaphthofurangruppe, eine Azadinaphthoselenophenylgruppe, eine Azanaphthocarbazolgruppe, eine Azanaphthofluorengruppe, eine Azaphenanthrobenzosilolgruppe, eine Azaphenanthrobenzothiophengruppe, eine Azaphenanthrobenzofurangruppe oder eine Azaphenanthrobenzoselenophengruppe ist.

5. Organometallische Verbindung nach einem der Ansprüche 1-4, wobei R₁ bis R₄, R₂₉, R₂₉ₐ, R_{29b} und Z₃ jeweils unabhängig Folgendes sind:
Wasserstoff, Deuterium, -F oder eine Cyanogruppe, oder
eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit mindestens einem von Deuterium, -F, einer Cyangruppe, einer C₁-C₂₀-Alkylgruppe, einer deuterierten C₁-C₂₀-Alkylgruppe, einer fluorierten C₁-C₂₀-Alkylgruppe, einer C₃-C₁₀-Cycloalkylgruppe, einer deuterierten C₃-C₁₀-Cycloalkylgruppe, einer fluorierten C₃-C₁₀-Cycloalkylgruppe, einer (C₁-C₂₀-Alkyl)C₃-C₁₀-Cycloalkylgruppe, einer Phenylgruppe, einer deuterierten Phenylgruppe, einer fluorierten Phenylgruppe, einer (C₁-C₂₀-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe, - Si(Q₃₃)(Q₃₄)(Q₃₅), -Ge(Q₃₃)(Q₃₄)(Q₃₅) oder einer Kombination davon, und
R₁₄ bis R₁₆ sind jeweils unabhängig eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit mindestens einem von Deuterium, -F, einer Cyanogruppe, einer C₁-C₂₀-Alkylgruppe, einer deuterierten C₁-C₂₀-Alkylgruppe, einer fluorierten C₁-C₂₀-Alkylgruppe, einer C₃-C₁₀-Cycloalkylgruppe, einer deuterierten C₃-C₁₀-Cycloalkylgruppe, einer fluorierten C₃-C₁₀-Cycloalkylgruppe, einer (C₁-C₂₀-Alkyl)C₃-C₁₀-Cycloalkylgruppe, einer Phenylgruppe, einer deuterierten Phenylgruppe, einer fluorierten Phenylgruppe, einer (C₁-C₂₀-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe oder einer Kombination davon.

6. Organometallische Verbindung nach einem der Ansprüche 1-5, wobei a2 in Formel 2-1 nicht 0 ist und R₂ nicht Wasserstoff ist, und/oder
wobei die organometallische Verbindung Deuterium, eine Fluorgruppe oder eine Kombination davon umfasst.

7. Organometallische Verbindung nach einem der Ansprüche 1-6, wobei eine Gruppe dargestellt durch 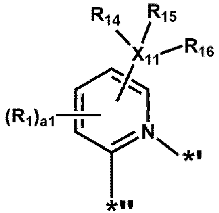 in Formel 2-1 eine Gruppe ist, dargestellt durch eine von Formeln CY1-1 bis CY1-6: 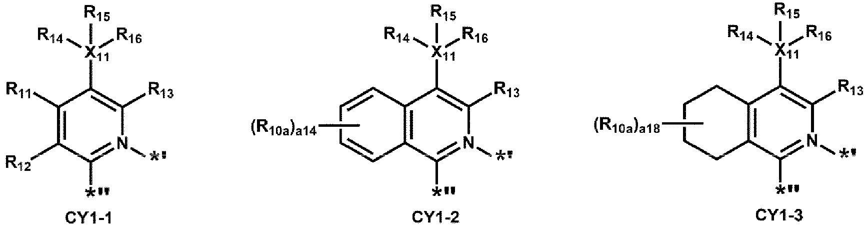 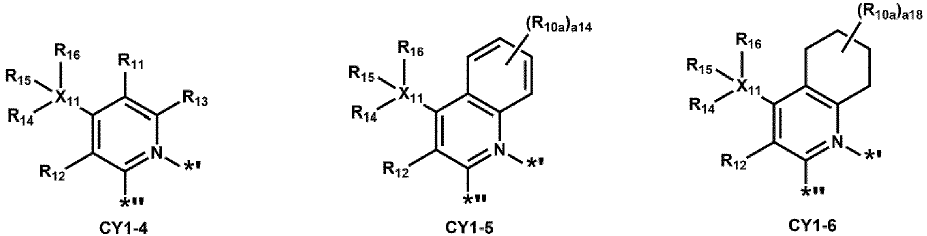 wobei in Formeln CY1-1 bis CY1-6
X₁₁, R₁₄ bis R₁₆ und R₁₀ₐ jeweils wie in Anspruch 1 beschrieben sind,
R₁₁ bis R₁₃ jeweils unabhängig wie in Verbindung mit R₁ in Anspruch 1 beschrieben sind, a14 eine ganze Zahl von 0 bis 4 ist,
a18 eine ganze Zahl von 0 bis 8 ist,
*' eine Bindungsstelle zu M in Formel 1 anzeigt, und
*" eine Bindungsstelle zu A₁ bis A₄ in Formel 2-1 anzeigt.

8. Organometallische Verbindung nach einem der Ansprüche 1-7, wobei eine Gruppe dargestellt durch 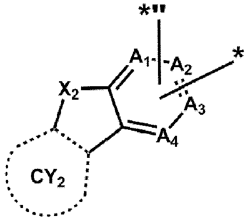 in Formel 2-1 eine Gruppe ist, dargestellt durch eine von Formeln CY2-1 bis CY2-20: 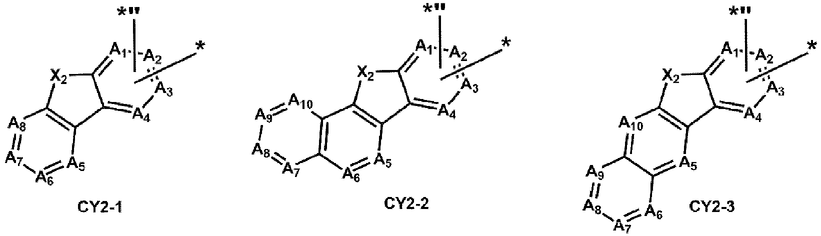 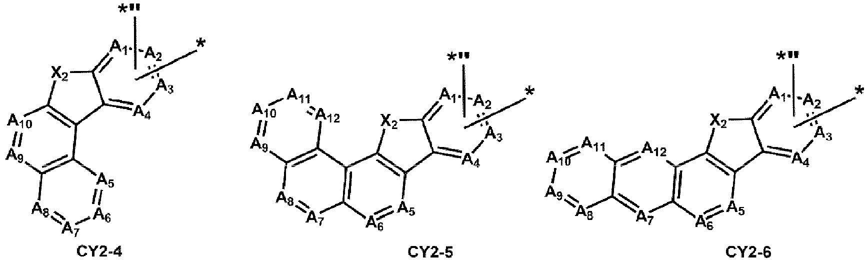 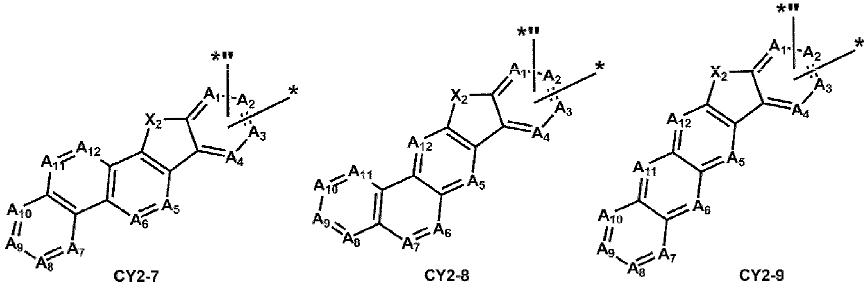 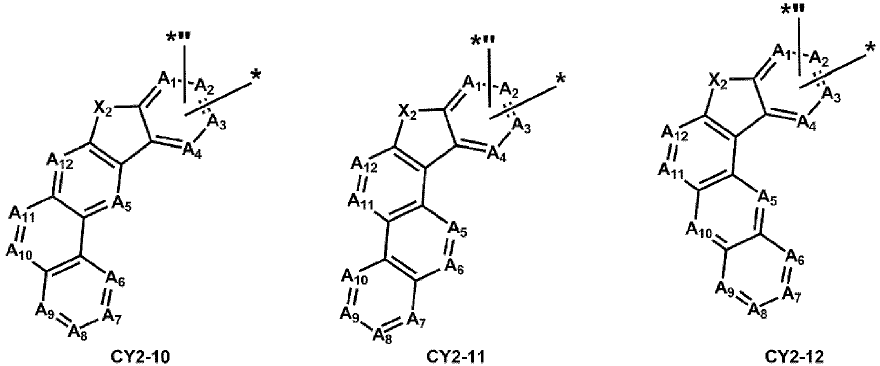 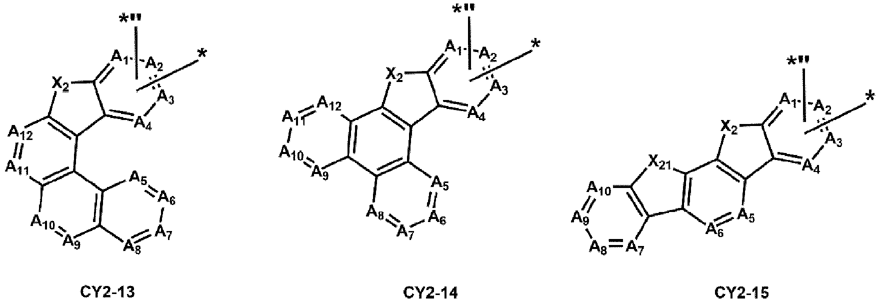 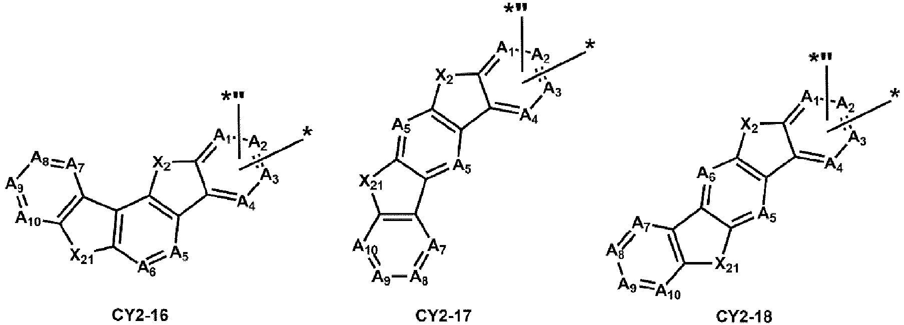 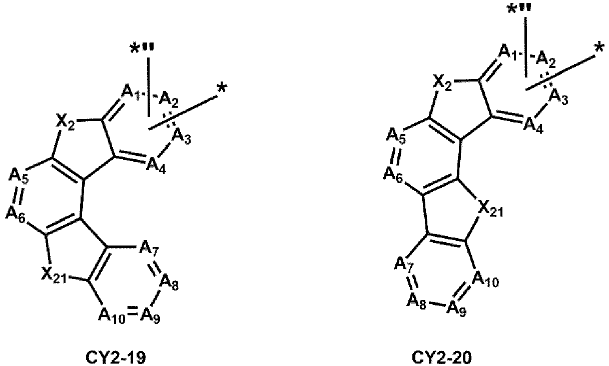 wobei in Formeln CY2-1 bis CY2-20,
X₂ wie in Anspruch 1 beschrieben ist,
X₂₁ wie in Verbindung mit X₂ in Anspruch 1 beschrieben ist,
A₁ bis A₁₂ jeweils unabhängig C oder N sind, wobei mindestens eines von A₁ bis A₈ in Formel CY2-1 N ist, mindestens eines von A₁ bis A₁₀ in Formeln CY2-2 bis CY2-4 und CY2-15 bis CY2-20 N ist, und mindestens eines von A₁ bis A₁₂ in Formeln CY2-5 bis CY2-14 N ist,
*" eine Bindungsstelle zu einer benachbarten Pyridingruppe in Formel 2-1 anzeigt, und
* eine Bindungsstelle zu M in Formel 1 anzeigt.

9. Organometallische Verbindung nach Anspruch 8, wobei
mindestens eines von A₄ bis Aₛ in Formel CY2-1 N ist,
mindestens eines von A₄ bis A₁₀ in Formeln CY2-2 bis CY2-4 und CY2-15 bis CY2-20 N ist, und
mindestens eines von A₄ bis A₁₂ in Formeln CY2-5 bis CY2-14 N ist.

10. Organometallische Verbindung nach einem der Ansprüche 1-9, wobei eine Gruppe dargestellt durch 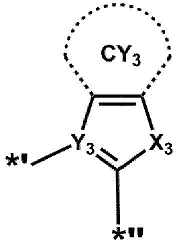 in Formel 2-2 eine Gruppe ist, dargestellt durch eine von Formeln CY3-1 bis CY3-20: 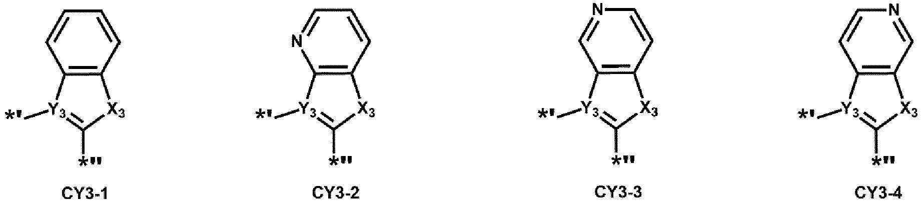 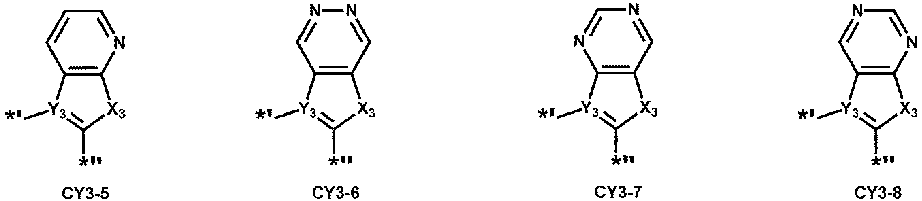 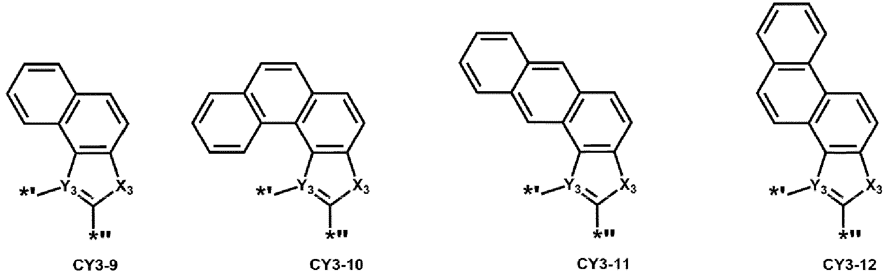 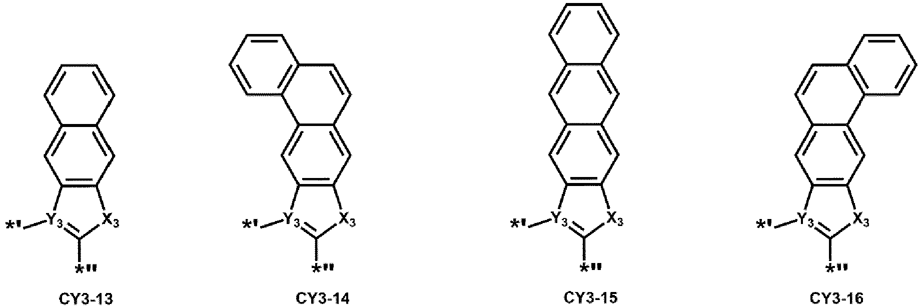 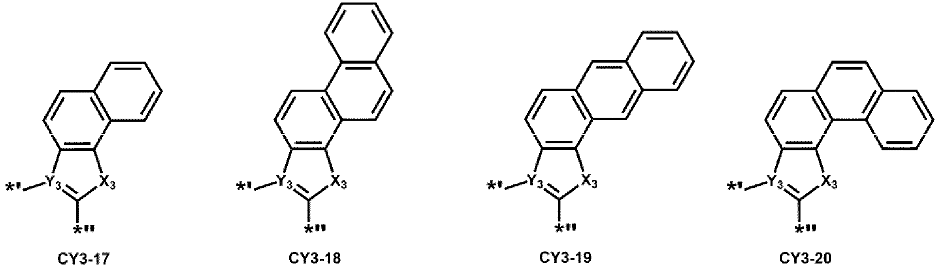 wobei, in Formeln CY3-1 bis CY3-20,
Y₃ und X₃ jeweils wie in Anspruch 1 beschrieben sind,
*' eine Bindungsstelle zu M in Formel 1 anzeigt, und
*" eine Bindungsstelle zu einem benachbarten Atom in Formel 2-2 anzeigt.

11. Organometallische Verbindung nach einem der Ansprüche 1-10, wobei eine Gruppe, dargestellt durch 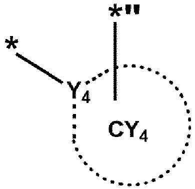 in Formel 2-2 eine Gruppe ist, dargestellt durch eine von Formeln CY4-1 bis CY4-21: 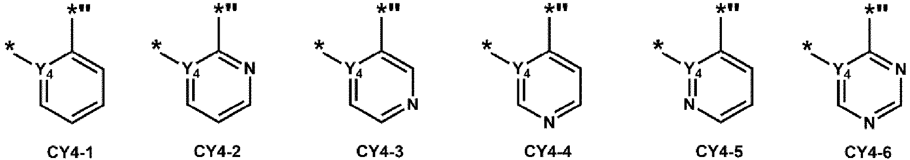 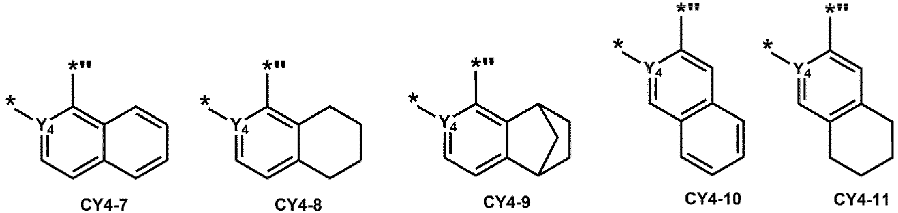 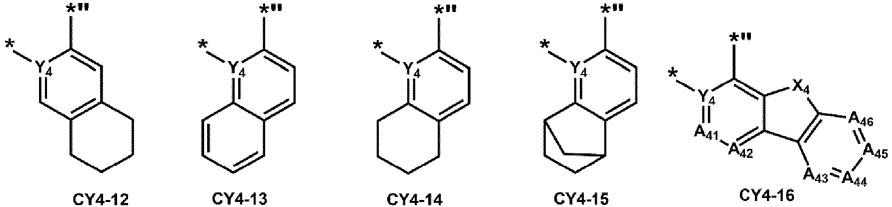 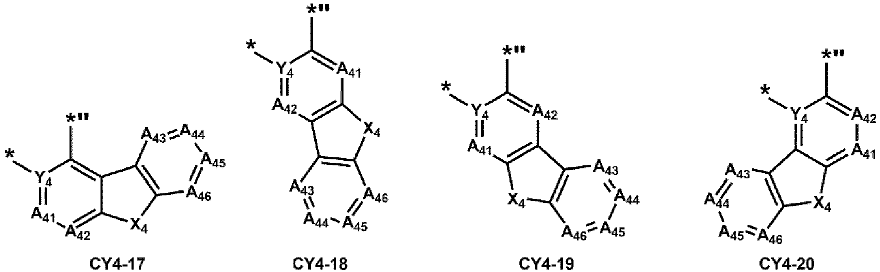 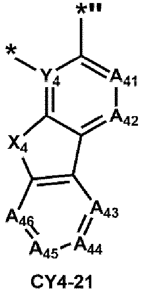 wobei in Formeln CY4-1 bis CY4-21,
Y₄ C ist,
A₄₁ bis A₄₆ jeweils unabhängig C oder N sind,
X₄ O, S, Se, N(R₄₉), C(R₄₉ₐ)(R_{49b}) oder Si(R₄₉ₐ)(R_{49b}) ist,
R₄₉, R₄₉ₐ und R_{49b} jeweils unabhängig wie in Verbindung mit R₄ in Anspruch 1 beschrieben sind,
* eine Bindungsstelle zu M in Formel 1 anzeigt, und
*" eine Bindungsstelle zu einem benachbarten Atom in Formel 2-2 anzeigt.

12. Organische lichtemittierende Vorrichtung, umfassend:
eine erste Elektrode,
eine zweite Elektrode, und
eine organische Schicht, die zwischen der ersten Elektrode und der zweiten Elektrode angeordnet ist, wobei die organische Schicht eine Emissionsschicht umfasst, und
wobei die organische Schicht ferner mindestens eine organometallische Verbindung nach einem der Ansprüche 1-11 umfasst;
wobei vorzugsweise die erste Elektrode eine Anode ist, die zweite Elektrode eine Kathode ist, die organische Schicht ferner einen Lochtransportbereich, der zwischen der ersten Elektrode und der Emissionsschicht angeordnet ist, und einen Elektronentransportbereich, der zwischen der Emissionsschicht und der zweiten Elektrode angeordnet ist, umfasst, wobei der Lochtransportbereich eine Lochinjektionsschicht, eine Lochtransportschicht, eine Elektronensperrschicht, eine Pufferschicht oder eine Kombination davon umfasst, und
der Elektronentransportbereich eine Lochsperrschicht, eine Elektronentransportschicht, eine Elektroneninjektionsschicht oder eine Kombination davon umfasst.

13. Organische lichtemittierende Vorrichtung nach Anspruch 12, wobei die Emissionsschicht die mindestens eine organometallische Verbindung umfasst.

14. Organische lichtemittierende Vorrichtung nach Anspruch 13, wobei die Emissionsschicht ein grünes Licht emittiert, und/oder
wobei die Emissionsschicht ferner einen Wirt umfasst und die Menge des Wirts in der Emissionsschicht größer ist als die Menge der mindestens einen organometallischen Verbindung in der Emissionsschicht.

15. Elektronische Einrichtung, umfassend die organische lichtemittierende Vorrichtung nach einem der Ansprüche 12-14.

## Revendications

1. Composé organométallique représenté par la Formule 1 :
Formule 1 M(L₁)ₙ₁(L₂)ₙ₂
dans lequel, dans la Formule 1,
M est un iridium, un platine, un osmium ou un rhodium,
L₁ est un ligand représenté par la Formule 2-1,
L₂ est un ligand représenté par la Formule 2-2,
n1 et n2 valent chacun indépendamment 1 ou 2,
lorsque n1 est égal à 2, deux L₁ sont identiques ou différents l'un de l'autre, et lorsque n2 est égal à 2, deux L₂ sont identiques ou différents l'un de l'autre, et
L₁ et L₂ sont différents l'un de l'autre, 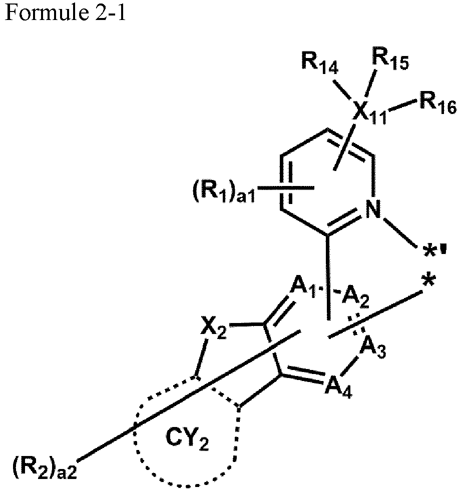 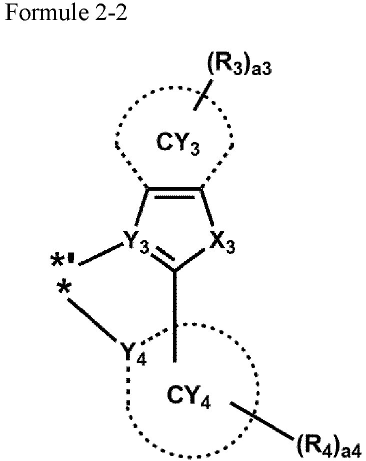
dans lequel, dans les Formules 2-1 et 2-2,
X₁₁ est Si ou Ge,
X₂ est O, S, Se, N(R₂₉), C(R₂₉ₐ)(R_{29b}) ou Si(R₂₉ₐ)(R_{29b}),
A₁ à A₄ sont chacun indépendamment C ou N, où l'un de A₁ à A₄ est C lié à un groupe pyridine voisin, et un autre de A₁ à A₄ est C lié à M dans la Formule 1,
Y₃ est N,
X₃ est O, S ou N-(T₃-Z₃),
T₃ est une liaison simple, un groupe alkylène en C₁-C₂₀ qui est non substitué ou substitué par au moins un R₁₀ₐ, un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
Y₄ est C ou N,
les cycles CY₂ à CY₄ sont chacun indépendamment un groupe carbocyclique en C₅-C₃₀ ou un groupe hétérocyclique en C₁-C₃₀, où le cycle CY₂ est un groupe hétérocyclique en C₃-C₃₀ comprenant au moins un N comme atome formant le cycle ; au moins l'un de A₁ à A₄ est N ; ou le cycle CY₂ est un groupe hétérocyclique en C₃-C₃₀ comprenant au moins un N comme atome formant le cycle, et au moins l'un de A₁ à A₄ est N,
R₁ à R₄, R₁₄ à R₁₆, R₂₉, R₂₉ₐ, R_{29b} et Z₃ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -Ge(Q₃)(Q₄)(Q₅), -B(Q₆)(Q₇), -P(=O)(Q₈)(Q₉) ou - P(Q₈)(Q₉),
a1 est un nombre entier de 0 à 3 ;
a2 est un nombre entier de 0 à 6 ;
a3 à a4 sont chacun indépendamment un nombre entier de 0 à 20,
deux ou plus d'une pluralité de R₁ sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux ou plus d'une pluralité de R₂ sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux ou plus d'une pluralité de R₃ sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux ou plus d'une pluralité de R₄ sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux ou plus de R₁ à R₄ sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
R₁₀ₐ est tel que décrit en relation avec R₂,
* et *' indiquent chacun un site de liaison à M dans la Formule 1,
au moins un substituant du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe alkylthio en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe alkylaryle en C₇-C₆₀ substitué, du groupe arylalkyle en C₇-C₆₀ substitué, du groupe aryloxy en C₆-C₆₀ substitué, du groupe arylthio en C₆-C₆₀ substitué, du groupe hétéroaryle en C₁-C₆₀ substitué, du groupe alkylhétéroaryle en C₂-C₆₀ substitué, du groupe hétéroarylalkyle en C₂-C₆₀ substitué, du groupe hétéroaryloxy en C₁-C₆₀ substitué, du groupe hétéroarylthio en C₁-C₆₀ substitué, du groupe polycyclique condensé non aromatique monovalent substitué et du groupe hétéropolycyclique condensé non aromatique monovalent substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀ ;
un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀, chacun étant substitué par au moins l'un parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉) ou une combinaison de ceux-ci ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent ou un groupe hétéropolycyclique condensé non aromatique monovalent, chacun étant non substitué ou substitué par au moins l'un parmi un deutérium, -F, -Cl, -Br, -I, -SF₅, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroarylalkyle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), P(Q₂₈)(Q₂₉) ou une combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) ou-P(Q₃₈)(Q₃₉) ; ou
une combinaison de ceux-ci, et
Q₁ à Q₉, Q₁₁ à Q₁₉, Q₂₁ à Q₂₉, et Q₃₁ à Q₃₉ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué ou un groupe hétéropolycyclique condensé non aromatique monovalent substitué ou non substitué.

2. Composé organométallique de la revendication 1, dans lequel X₂ est O ou S.

3. Composé organométallique de l'une des revendications 1 ou 2, dans lequel, dans la Formule 2-1,
A₁ est C lié à un groupe pyridine voisin, et A₂ est C lié à M dans la Formule 1 ; ou
A₃ est C lié à un groupe pyridine voisin, et A₂ est C lié à M dans la Formule 1.

4. Composé organométallique de l'une quelconque des revendications 1 à 3, dans lequel le cycle CY₂ est un groupe pyridine, un groupe pyrimidine, un groupe pyridazine, un groupe pyrazine, un groupe quinoléine, un groupe isoquinoléine, un groupe quinoxaline, un groupe quinazoline, un groupe phénanthridine, un groupe phénanthroline, un groupe benzoquinoléine, un groupe benzoisoquinoléine, un groupe azacarbazole, un groupe azafluorène, un groupe azadibenzosilole, un groupe azadibenzothiophène, un groupe azadibenzofurane, un groupe azadibenzosélénophène, un groupe azabenzocarbazole, un groupe azabenzofluorène, un groupe azanaphtobenzosilole, un groupe azanaphtobenzothiophène, un groupe azanaphtobenzofurane, un groupe azanaphtobenzosélénophène, un groupe azadibenzocarbazole, un groupe azadibenzofluorène, un groupe azadinaphtosilole, un groupe azadinaphtothiophène, un groupe azadinaphtofurane, un groupe azadinaphtosélénophène, un groupe azanaphtocarbazole, un groupe azanaphtofluorène, un groupe azaphénanthrobenzosilole, un groupe azaphénanthrobenzothiophène, un groupe azaphénanthrobenzofurane ou un groupe azaphénanthrobenzosélénophène ; et/ou
dans lequel le cycle CY₃ est un groupe benzène, un groupe naphtalène, un groupe anthracène, un groupe phénanthrène, un groupe pyridine, un groupe pyrimidine, un groupe pyridazine, un groupe pyrazine, un groupe quinoléine ou un groupe isoquinoléine ; et/ou
dans lequel le cycle CY₄ est un groupe benzène, un groupe naphtalène, un groupe anthracène, un groupe phénanthrène, un groupe 1,2,3,4-tétrahydronaphtalène, un groupe benzène condensé avec un groupe norbomane, un groupe carbazole, un groupe fluorène, un groupe dibenzosilole, un groupe dibenzothiophène, un groupe dibenzofurane, un groupe dibenzosélénophène, un groupe benzocarbazole, un groupe benzofluorène, un groupe naphtobenzosilole, un groupe naphtobenzothiophène, un groupe naphtobenzofurane, un groupe naphtobenzosélénophène, un groupe dibenzocarbazole, un groupe dibenzofluorène, un groupe dinaphtosilole, un groupe dinaphtothiophène, un groupe dinaphtofurane, un groupe dinaphtosélénophène, un groupe naphtocarbazole, un groupe naphtofluorène, un groupe phénanthrobenzosilole, un groupe phénanthrobenzothiophène, un groupe phénanthrobenzofurane, un groupe phénanthrobenzosélénophène, un groupe azacarbazole, un groupe azafluorène, un groupe azadibenzosilole, un groupe azadibenzothiophène, un groupe azadibenzofurane, un groupe azadibenzosélénophène, un groupe azabenzocarbazole, un groupe azabenzofluorène, un groupe azanaphtobenzosilole, un groupe azanaphtobenzothiophène, un groupe azanaphtobenzofurane, un groupe azanaphtobenzosélénophène, un groupe azadibenzocarbazole, un groupe azadibenzofluorène, un groupe azadinaphtosilole, un groupe azadinaphtothiophène, un groupe azadinaphtofurane, un groupe azadinaphtosélénophène, un groupe azanaphtocarbazole, un groupe azanaphtofluorène, un groupe azaphénanthrobenzosilole, un groupe azaphénanthrobenzothiophène, un groupe azaphénanthrobenzofurane ou un groupe azaphénanthrobenzosélénophène.

5. Composé organométallique de l'une quelconque des revendications 1 à 4, dans lequel R₁ à R₄, R₂₉, R₂₉ₐ, R_{29b} et Z₃ sont chacun indépendamment :
un hydrogène, un deutérium, -F ou un groupe cyano ; ou
un groupe alkyle en C₁-C₂₀, un groupe cycloalkyle en C₃-C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun étant non substitué ou substitué par au moins l'un parmi un deutérium, -F, un groupe cyano, un groupe alkyle en C₁-C₂₀, un groupe alkyle en C₁-C₂₀ deutéré, un groupe alkyle en C₁-C₂₀ fluoré, un groupe cycloalkyle en C₃-C₁₀, un groupe cycloalkyle en C₃-C₁₀ deutéré, un groupe cycloalkyle en C₃-C₁₀ fluoré, un groupe (alkyle en C₁-C₂₀)-cycloalkyle en C₃-C₁₀, un groupe phényle, un groupe phényle deutéré, un groupe phényle fluoré, un groupe (alkyle en C₁-C₂₀)-phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, -Si(Q₃₃)(Q₃₄)(Q₃₅), -Ge(Q₃₃)(Q₃₄)(Q₃₅) ou une combinaison de ceux-ci, et
R₁₄ à R₁₆ sont chacun indépendamment un groupe alkyle en C₁-C₂₀, un groupe cycloalkyle en C₃-C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun étant non substitué ou substitué par au moins l'un parmi un deutérium, -F, un groupe cyano, un groupe alkyle en C₁-C₂₀, un groupe alkyle en C₁-C₂₀ deutéré, un groupe alkyle en C₁-C₂₀ fluoré, un groupe cycloalkyle en C₃-C₁₀, un groupe cycloalkyle en C₃-C₁₀ deutéré, un groupe cycloalkyle en C₃-C₁₀ fluoré, un groupe (alkyle en C₁-C₂₀)-cycloalkyle en C₃-C₁₀, un groupe phényle, un groupe phényle deutéré, un groupe phényle fluoré, un groupe (alkyle en C₁-C₂₀)-phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle ou une combinaison de ceux-ci.

6. Composé organométallique de l'une quelconque des revendications 1 à 5, dans lequel a2 dans la Formule 2-1 n'est pas 0, et R₂ n'est pas un hydrogène ; et/ou
ledit composé organométallique comprenant un deutérium, un groupe fluoro ou une combinaison de ceux-ci.

7. Composé organométallique de l'une quelconque des revendications 1 à 6, dans lequel un groupe représenté par 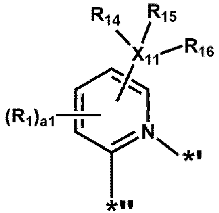 dans la Formule 2-1 est un groupe représenté par l'une des Formules CY1-1 à CY1-6 : 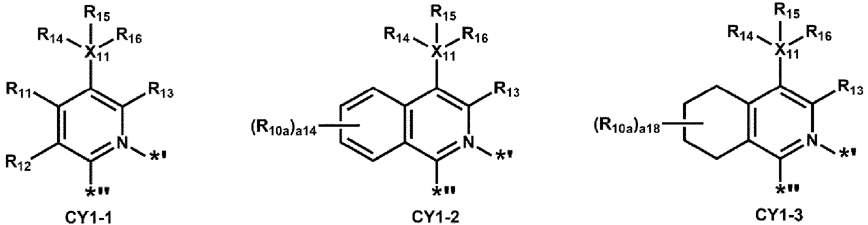 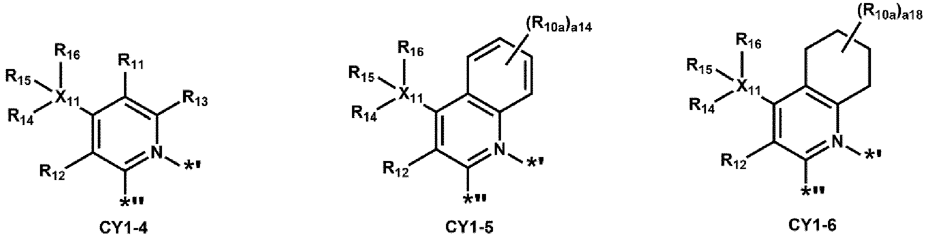 dans lequel, dans les Formules CY1-1 à CY1-6,
X₁₁, R₁₄ à R₁₆ et R₁₀ₐ sont chacun tels que décrits dans la revendication 1,
R₁₁ à R₁₃ sont chacun indépendamment tels que décrits en relation avec R₁ dans la revendication 1,
a14 est un nombre entier de 0 à 4 ;
a18 est un nombre entier de 0 à 8 ;
*' indique un site de liaison à M dans la Formule 1, et
*" indique un site de liaison à l'un de A₁ à A₄ dans la Formule 2-1.

8. Composé organométallique de l'une quelconque des revendications 1 à 7, dans lequel un groupe représenté par 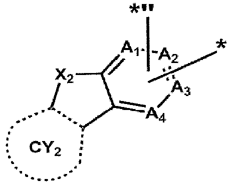 dans la Formule 2-1 est un groupe représenté par l'une des Formules CY2-1 à CY2-20 : 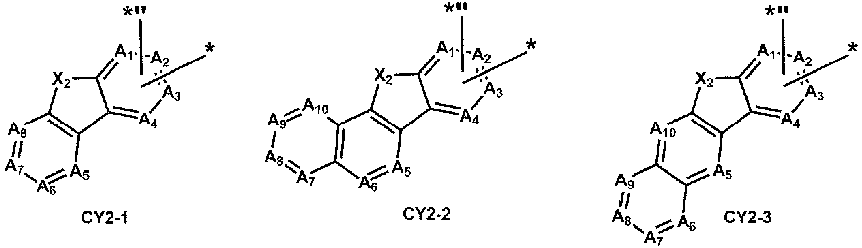 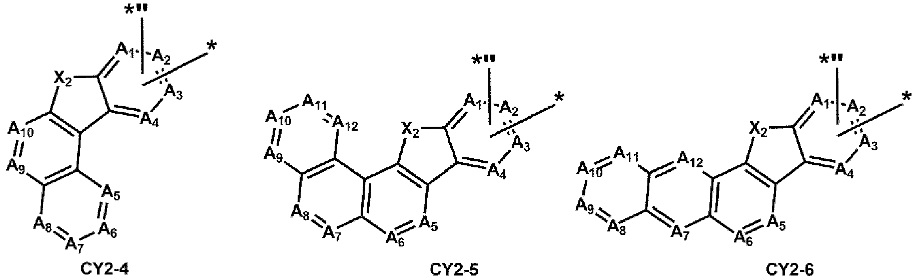 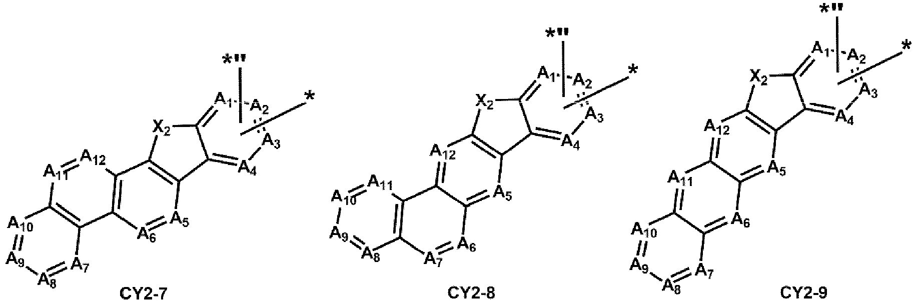 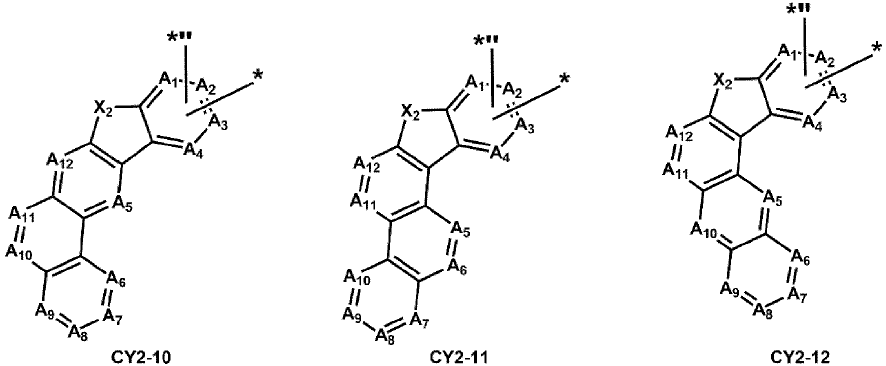 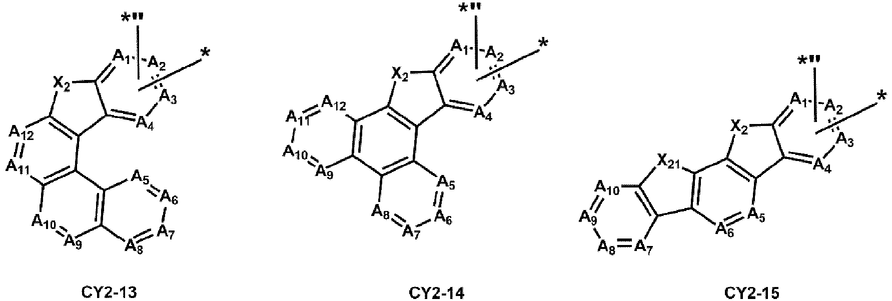 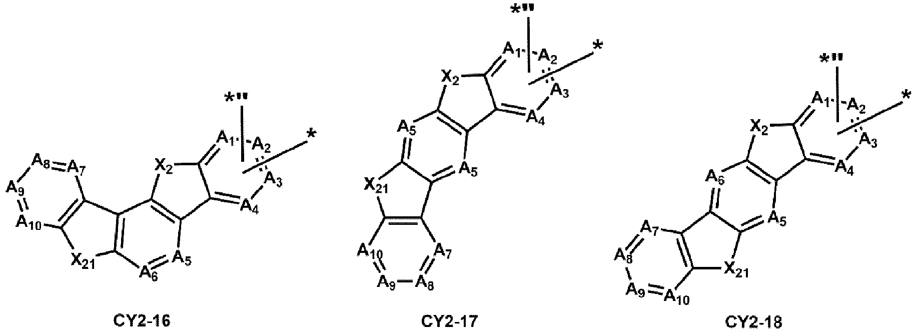 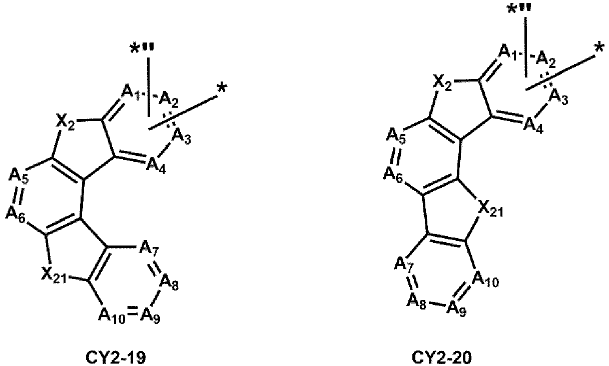 dans lequel, dans les Formules CY2-1 à CY2-20,
X₂ est tel que décrit dans la revendication 1,
X₂₁ est tel que décrit en relation avec X₂ dans la revendication 1,
A₁ à A₁₂ sont chacun indépendamment C ou N, où au moins l'un de A₁ à A₈ dans la Formule CY2-1 est N, au moins l'un de A₁ à A₁₀ dans les Formules CY2-2 à CY2-4 et CY2-15 à CY2-20 est N, et au moins l'un de A₁ à A₁₂ dans les Formules CY2-5 à CY2-14 est N,
*" indique un site de liaison à un groupe pyridine voisin dans la Formule 2-1, et
* indique un site de liaison à M dans la Formule 1.

9. Composé organométallique de la revendication 8, dans lequel
au moins l'un de A₄ à A₈ dans la Formule CY2-1 est N,
au moins l'un de A₄ à A₁₀ dans les Formules CY2-2 à CY2-4 et CY2-15 à CY2-20 est N, et
au moins l'un de A₄ à A₁₂ dans les Formules CY2-5 à CY2-14 est N.

10. Composé organométallique de l'une quelconque des revendications 1 à 9, dans lequel un groupe représenté par 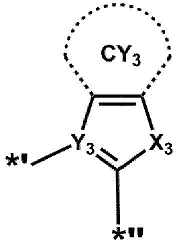 dans la Formule 2-2 est un groupe représenté par l'une des Formules CY3-1 à CY3-20 : 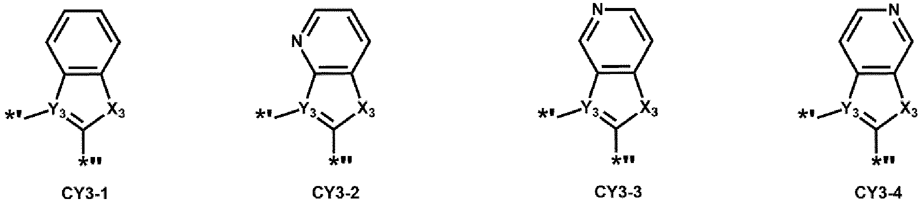 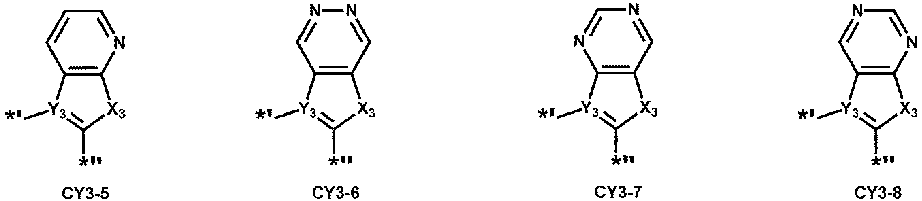 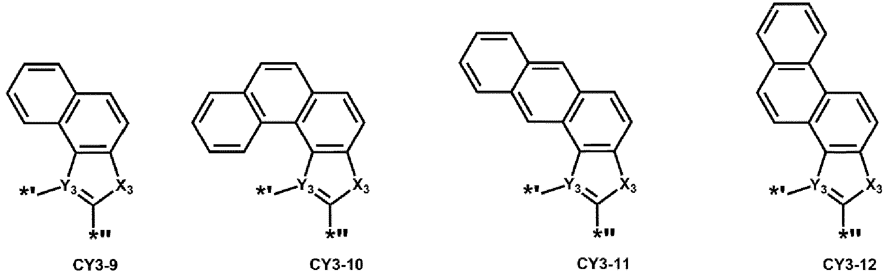 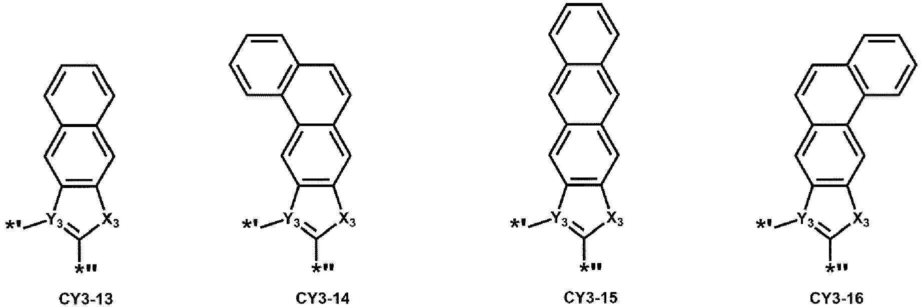 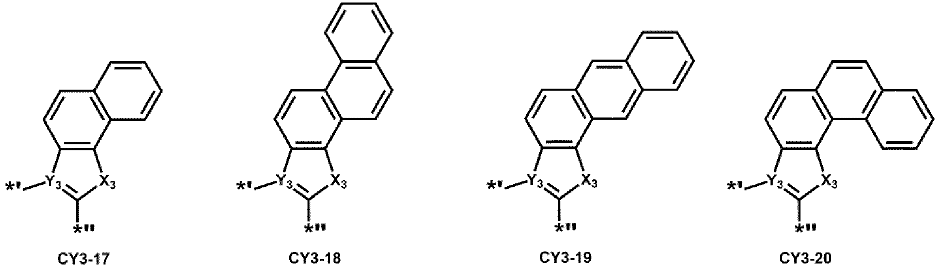 dans lequel, dans les Formules CY3-1 à CY3-20,
Y₃ et X₃ sont chacun tels que décrits dans la revendication 1,
*' indique un site de liaison à M dans la Formule 1, et
*" indique un site de liaison à un atome voisin dans la Formule 2-2.

11. Composé organométallique de l'une quelconque des revendications 1 à 10, dans lequel un groupe représenté par 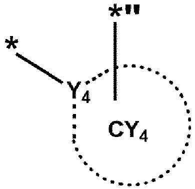 dans les Formules 2-2 est un groupe représenté par l'une des Formules CY4-1 à CY4-21 : 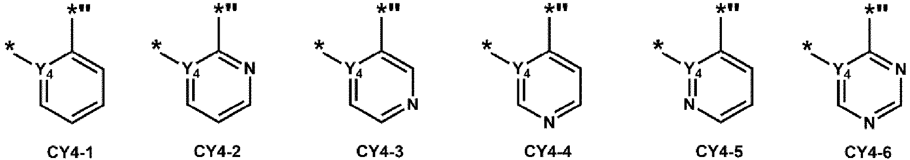 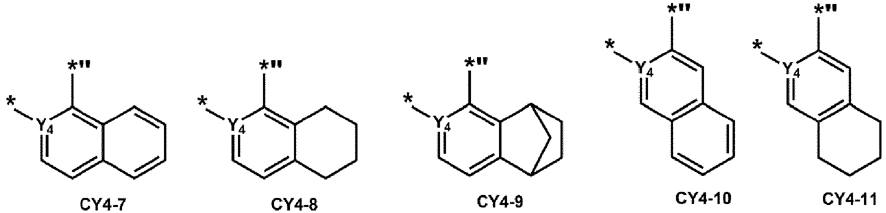 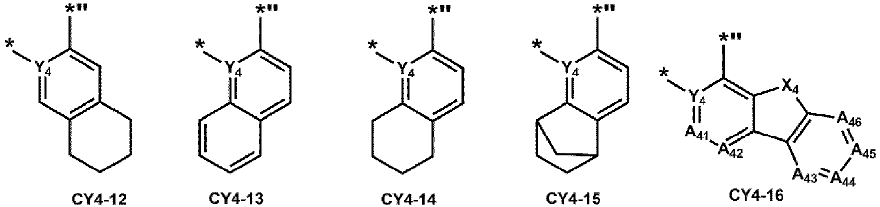 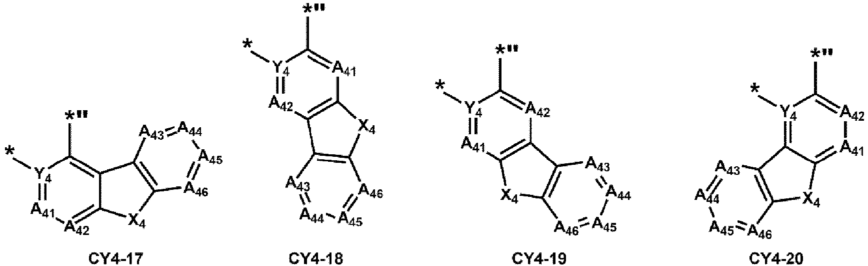 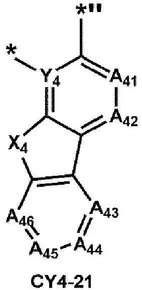 dans lequel, dans les Formules CY4-1 à CY4-21,
Y₄ est C,
A₄₁ à A₄₆ sont chacun indépendamment C ou N,
X₄ est O, S, Se, N(R₄₉), C(R₄₉ₐ)(R_{49b}) ou Si(R₄₉ₐ)(R_{49b}),
R₄₉, R₄₉ₐ et R_{49b} sont chacun indépendamment tels que décrits en relation avec R₄ dans la revendication 1,
* indique un site de liaison à M dans la Formule 1, et
*" indique un site de liaison à un atome voisin dans la Formule 2-2.

12. Dispositif électroluminescent organique, comprenant :
une première électrode ;
une seconde électrode ; et
une couche organique agencée entre la première électrode et la seconde électrode,
dans lequel la couche organique comprend une couche d'émission, et
dans lequel la couche organique comprend en outre au moins un composé organométallique de l'une quelconque des revendications 1 à 11 ;
de préférence, dans lequel
la première électrode est une anode,
la seconde électrode est une cathode,
la couche organique comprend en outre une région de transport de trous agencée entre la première électrode et la couche d'émission et une région de transport d'électrons agencée entre la couche d'émission et la seconde électrode,
la région de transport de trous comprend une couche d'injection de trous, une couche de transport de trous, une couche de blocage d'électrons, une couche tampon ou une combinaison de celles-ci, et
la région de transport d'électrons comprend une couche de blocage de trous, une couche de transport d'électrons, une couche d'injection d'électrons ou une combinaison de celles-ci.

13. Dispositif électroluminescent organique de la revendication 12, dans lequel la couche d'émission comprend l'au moins un composé organométallique.

14. Dispositif électroluminescent organique de la revendication 13, dans lequel la couche d'émission émet une lumière verte ; et/ou
dans lequel la couche d'émission comprend en outre un hôte, et une quantité de l'hôte dans la couche d'émission est supérieure à une quantité de l'au moins un composé organométallique dans la couche d'émission.

15. Appareil électronique, comprenant le dispositif électroluminescent organique de l'une quelconque des revendications 12 à 14.
